# EUROPÄISCHE PATENTSCHRIFT

(11) **EP 4 640 022 B1**
(45) Veröffentlichungstag und Bekanntmachung des Hinweises auf die Patenterteilung: **09.09.2026**
(21) Anmeldenummer: 23833729.9
(22) Anmeldetag: 18.12.2023
(51) Int. Cl.: H10K 85/60, H10K 85/40, H10K 85/30, H10K 101/00, H10K 101/10, H10K 50/11

(54) **MATERIALIEN FÜR ELEKTRONISCHE VORRICHTUNGEN**
MATERIALS FOR ELECTRONIC DEVICES
MATÉRIAUX POUR DISPOSITIFS ÉLECTRONIQUES

(30) Priorität: 19.12.2022 EP 22214459; 30.08.2023 EP 23194394
(43) Veröffentlichungstag der Anmeldung: 29.10.2025
(73) Patentinhaber: Merck Patent GmbH, 64293 Darmstadt (DE)
(72) Erfinder: STOESSEL, Philipp, 64293 Darmstadt (DE); STENGEL, Ilona, 64293 Darmstadt (DE); AUCH, Armin, 64293 Darmstadt (DE); SCHUETZ, Philipp, 64293 Darmstadt (DE); STUEHLER, Rudolf Raul Albert, 64293 Darmstadt (DE)
(74) Vertreter: Merck Patent Association
(86) Internationale Anmeldenummer: PCT/EP2023/086235
(87) Internationale Veröffentlichungsnummer: WO 2024/132993

(56) Entgegenhaltungen:
- WO-A1-2015/104045
- WO-A2-2014/023377
- DE-A1- 102008 056 688

## Beschreibung

Die vorliegende Erfindung betrifft Materialien für die Verwendung in elektronischen Vorrichtungen, insbesondere in organischen Elektrolumineszenzvorrichtungen, sowie elektronische Vorrichtungen, insbesondere organische Elektrolumineszenzvorrichtungen enthaltend diese Materialien. Elektronische Vorrichtungen, welche organische und/oder metallorganische Halbleiter enthalten, werden in vielen kommerziellen Produkten eingesetzt werden, beispielsweise in organischen Leuchtdioden (OLEDs). Hierbei gibt es einen großen Bedarf, die Leistungsdaten, insbesondere Lebensdauer, Effizienz und Betriebsspannung zu verbessern. Dies gilt insbesondere für blau phosphoreszente OLEDs bzw. für hyperphosphoreszente OLEDs.

Aufgabe der vorliegenden Erfindung ist die Bereitstellung von Verbindungen, welche sich für den Einsatz in einer elektronischen Vorrichtung, insbesondere einer OLED, eignen, insbesondere Elektronenblockiermaterialien und/oder als Hostmaterialien, und dort zu guten Eigenschaften führen. Aus WO 2010/054729 sind Diaza- und Tetraazasilan-Derivate bekannt, welche als Elektronenblockiermaterial und/oder als Matrixmaterial für grün oder blau ohosohoreszierende Verbindungen einaesetzt werden.

Weitere Tetraazasilan-Derivate sind aus DE 10 2008 056688 A1, WO 2014/023377 A2 und WO 2015/104045 A1 bekannt.

Auch wenn mit diesen Verbindungen bereits gute Ergebnisse erzielt werden, sind hier weitere Verbesserungen, insbesondere in Bezug auf die Effizienz, die Spannung und/oder die Lebensdauer wünschenswert.

Überraschend wurde gefunden, dass bestimmte, unten näher beschriebene Tetraazasilan-Derivate, welche teilweise oder vollständig deuteriert sind, diese Aufgabe lösen und sich gut für die Verwendung in elektronischen Vorrichtungen, insbesondere OLEDs eignen. Dabei weisen die OLEDs insbesondere eine verbesserte Lebensdauer, eine höhere Effizienz und/oder eine geringere Betriebsspannung auf gegenüber OLEDs, die undeuterierte Tetraazasilan-Derivate enthalten. Diese Verbindungen sowie elektronische Vorrichtungen, insbesondere organische Elektrolumineszenzvorrichtungen, welche diese Verbindungen enthalten, sind daher der Gegenstand der vorliegenden Erfindung.

Gegenstand der vorliegenden Erfindung ist eine Verbindung gemäß Formel (1), 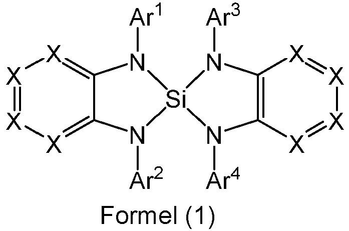 wobei für die verwendeten Symbole gilt:
- X: ist bei jedem Auftreten gleich oder verschieden CR oder N, mit der Maßgabe, dass nicht mehr als zwei X pro Cyclus für N stehen;
- Ar¹, Ar², Ar³, Ar⁴: ist bei jedem Auftreten gleich oder verschieden ein aromatisches oder heteroaromatisches Ringsystem mit 5 bis 40 aromatischen Ringatomen, das durch einen oder mehrere Reste R substituiert sein kann;
- R: ist bei jedem Auftreten gleich oder verschieden H, D, F, Cl, Br, I, OR¹, SR¹, B(OR¹)₂, CHO, C(=O)R', CR¹=C(R¹)₂, CN, C(=O)OR¹, C(=O)NR¹, Si(R¹)₃, Ge(R¹)₃, NO₂, P(=O)(R¹)₂, OSO₂R¹, OR¹, N(R¹)₂, S(=O)R¹, S(=O)₂R¹, SR¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch -R¹C=CR¹-, -C≡C-, Si(R¹)₂, CONR¹, C=O, C=S, -C(=O)O-, P(=O)(R¹), -O-, -S-, SO oder SO₂ ersetzt sein können, oder ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann; dabei können zwei oder mehrere Reste R miteinander ein Ringsystem bilden;
- R¹: ist bei jedem Auftreten gleich oder verschieden H, D, F, Cl, Br, I, B(OR²)₂, CHO, C(=O)R², CR²=C(R²)₂, CN, C(=O)OR², Si(R²)₃, Ge(R²)₃, NO₂, P(=O)(R²)₂, OSO₂R², SR², S(=O)R², S(=O)₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere CH₂-Gruppen in den oben genannten Gruppen durch -R²C=CR²-, -C=C-, Si(R²)₂, C=O, C=S, -C(=O)O-, CONR², P(=O)(R²), -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R² substituiert sein kann, wobei zwei oder mehr Reste R¹ miteinander ein Ringsystem bilden können;
- R²: ist bei jedem Auftreten gleich oder verschieden H, D, F, CN oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden;
dadurch gekennzeichnet, dass die Verbindung zu mindestens 20 % deuteriert ist.

Eine Arylgruppe im Sinne dieser Erfindung enthält 6 bis 40 C-Atome; eine Heteroarylgruppe im Sinne dieser Erfindung enthält 5 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 60 C-Atome, bevorzugt 6 bis 40 C-Atome im Ringsystem. Ein heteroaromatisches Ringsystem im Sinne dieser Erfindung enthält 1 bis 60 C-Atome, bevorzugt 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder Carbonylgruppe, verbunden sein können. Ebenso sollen hierunter Systeme verstanden werden, in denen zwei oder mehr Aryl- bzw. Heteroarylgruppen direkt miteinander verknüpft sind, wie z. B. Biphenyl, Terphenyl, Bipyridin oder Phenylpyridin. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe verbunden sind. Bevorzugte aromatische bzw. heteroaromatische Ringsysteme sind einfache Aryl- bzw. Heteroarylgruppen sowie Gruppen, in denen zwei oder mehr Aryl- bzw. Heteroarylgruppen direkt miteinander verknüpft sind, beispielsweise Biphenyl, Terphenyl, Quaterphenyl oder Bipyridin, sowie Fluoren oder Spirobifluoren.

Eine elektronenreiche Heteroarylgruppe ist dadurch gekennzeichnet, dass es sich dabei um eine Heteroarylgruppe handelt, die keine elektronenarmen Heteroarylgruppen enthält. Eine elektronenarme Heteroarylgruppe ist eine Sechsring-Heteroarylgruppe mit mindestens einem Stickstoffatom oder eine Fünfring-Heteroarylgruppe mit mindestens zwei Heteroatomen, von denen eines ein Stickstoffatom und das andere Sauerstoff, Schwefel oder ein substituiertes Stickstoffatom ist, wobei an diese Gruppen jeweils noch weitere Aryl- oder Heteroarylgruppen ankondensiert sein können. Dagegen sind elektronenreiche Heteroarylgruppen Fünfring-Heteroarylgruppen mit genau einem Heteroatom, ausgewählt aus Sauerstoff, Schwefel oder substituiertem Stickstoff, an welche noch weitere Arylgruppen und/oder weitere elektronenreiche Fünfring-Heteroarylgruppen ankondensiert sein können. So sind Beispiele für elektronenreiche Heteroarylgruppen Pyrrol, Furan, Thiophen, Indol, Benzofuran, Benzothiophen, Carbazol, Dibenzofuran, Dibenzothiophen, Indolocarbazol und Indenocarbazol.

Im Rahmen der vorliegenden Erfindung wird der Begriff Alkylgruppe als Oberbegriff sowohl für lineare oder verzweigte Alkylgruppen wie auch für cyclische Alkylgruppen verwendet. Analog werden die Begriffe Alkenylgruppe bzw. Alkinylgruppe als Oberbegriffe sowohl für lineare oder verzweigte Alkenyl- bzw. Alkinylgruppen, wie auch für cyclische Alkenyl- bzw. Alkinylgruppen verwendet. Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, Cyclooctyl, 2-Ethylhexyl, 1-Bicyclo[2,2,2]octyl, 2-Bicyclo-[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl, 1,1-Dimethyl-n-hept-1-yl, 1,1-Dimethyl-n-oct-1-yl, 1,1-Dimethyl-n-dec-1-yl, 1,1-Dimethyl-n-dodec-1-yl, 1,1-Dimethyl-n-tetradec-1-yl, 1,1-Dimethyl-n-hexadec-1-yl, 1,1-Dimethyl-n-octadec-1-yl, 1,1-Diethyl-n-hex-1-yl, 1,1-Diethyl-n-hept-1-yl, 1,1-Diethyl-n-oct-1-yl, 1,1-Diethyl-n-dec-1-yl, 1,1-Diethyl-n-dodec-1-yl, 1,1-Diethyl-n-tetradec-1-yl, 1,1-Diethyl-n-hexadec-1-yl, 1,1-Diethyl-n-octadec-1-yl, 1-(n-Propyl)-cyclohex-1-yl, 1-(n-Butyl)-cyclohex-1-yl, 1-(n-Hexyl)-cyclohex-1-yl, 1-(n-Octyl)-cyclohex-1-yl und 1-(n-Decyl)-cyclohex-1-yl, Ethenyl, Propenyl, Butenyl, Pentenyl, Cyclopentenyl, Hexenyl, Cyclohexenyl, Heptenyl, Cycloheptenyl, Octenyl, Cyclooctenyl, Cyclooctadienyl, Ethinyl, Propinyl, Butinyl, Pentinyl, Hexinyl, Heptinyl oder Octinyl verstanden. Unter einer Alkoxygruppe OR¹ mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe SR¹ mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nichtbenachbarte CH₂-Gruppen durch die oben genannten Gruppen ersetzt sein können; weiterhin können auch ein oder mehrere H-Atome durch D, F, Cl, Br, I, CN oder NO₂, bevorzugt D, F, Cl oder CN, besonders bevorzugt D, F oder CN ersetzt sein.

Unter einem aromatischen oder heteroaromatischen Ringsystem mit 5 - 60 aromatischen Ringatomen, vorzugsweise 5 - 40 aromatischen Ringatomen, welches noch jeweils mit den oben genannten Resten oder einem Kohlenwasserstoffrest substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme. Diese Gruppen können auch deuteriert sein.

Unter der Formulierung, dass zwei oder mehr Reste miteinander ein Ringsystem bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht:

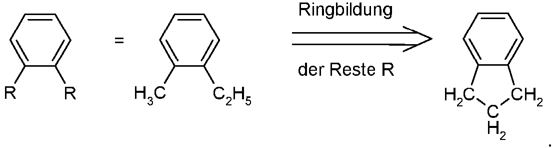

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

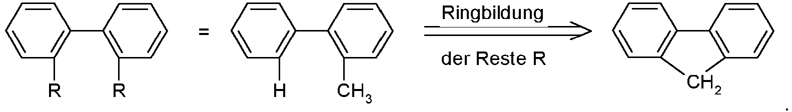

Wie vorstehend definiert, ist die erfindungsgemäße Verbindung dadurch gekennzeichnet, dass sie zu mindestens 20 % deuteriert ist. Dabei bedeutet der Begriff "deuteriert", dass in einer solchen Verbindungen der entsprechende Anteil der enthaltenen Wasserstoffatome der undeuterierten Verbindung gegen D (Deuterium) ausgetauscht wurde. Die undeuterierte Verbindung ist die entsprechende Verbindung, welche Wasserstoff in der natürlichen Isotopenverteilung enthält. Der Deuterierungsgrad ist in mol% angegeben und bezeichnet den durchschnittlichen Deuterierungsgrad der Verbindung, also den durchschnittlichen Anteil der H-Atome in der Verbindung, der durch D-Atome ersetzt ist. In einer vollständig deuterierten Verbindung sind alle H gegen D ausgetauscht, so dass hier der Deuterierungsgrad bei 100 % liegt. Ein Deuterierungsgrad von mindestens 20 % bedeutet, dass in der Verbindung durchschnittlich 20 % bis 100 % der H-Atome durch D-Atome ersetzt sind. In einer bevorzugten Ausführungsform liegt der Deuterierungsgrad bei 30 % bis 95 %, besonders bevorzugt bei 40 % bis 90 %, ganz besonders bevorzugt bei 50 % bis 80 %. Generell ist ein hoher Deuterierungsgrad wünschenswert. Dieser ist jedoch synthetisch nur mit hohem Aufwand oder gar nicht zu erreichen. Da sich die Angabe des Deuterierungsgrades auf den Durchschnitt einer Mischung verschieden deuterierter Verbindungen bezieht, weist diese Mischung Verbindungen derselben Grundstruktur auf, die sich, abhängig vom Deuterierungsverfahren, in der Position der Deuterierung und dem Deuterierungsgrad der einzelnen Verbindungen unterscheiden.

In einer bevorzugten Ausführungsform der Erfindung stehen alle Gruppen X für CR, oder zwei Gruppen X in jedem der beiden Cyclen stehen für N, so dass ein Pyrazin gebildet wird, oder zwei Gruppen X in einem der beiden Cyclen stehen für N, so dass ein Pyrazin gebildet wird, und alle X in dem anderen Cyclus stehen für CR. Bevorzugt sind daher die Verbindungen der folgenden Formel (2), (3) und (4), wobei die Verbindungen der Formel (2) besonders bevorzugt sind, 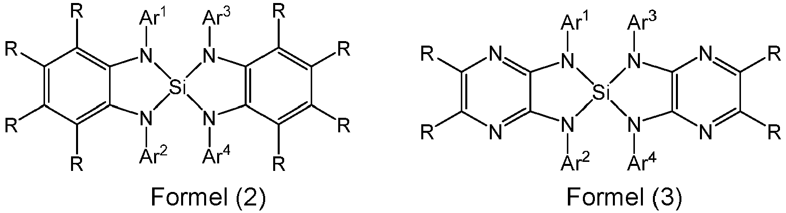 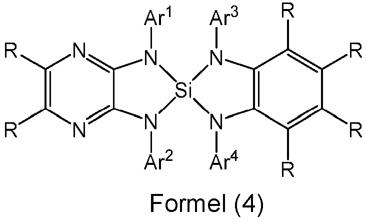 wobei die verwendeten Symbole die oben genannten Bedeutungen aufweisen.

Dabei kann es sich um symmetrische oder asymmetrische Strukturen handeln. Symmetrische Strukturen sind dadurch charakterisiert, dass alle vier Gruppen Ar¹, Ar², Ar³ und Ar⁴ identisch sind und dass die beiden Cyclen enthaltend die Gruppen X identisch sind. Asymmetrische Strukturen sind dadurch charakterisiert, dass nicht alle vier Gruppen Ar¹, Ar², Ar³ und Ar⁴ identisch sind und/oder dadurch, dass die beiden Cyclen enthaltend die Gruppen X unterschiedlich sind, wie dies beispielsweise in den Verbindungen der Formel (4) der Fall ist. Verbindungen, in denen die beiden Cyclen enthaltend die Gruppen X unterschiedlich sind, liegen auch dann vor, wenn beispielsweise wie in Formel (2) alle X für CR stehen, aber die Reste R an den beiden Cyclen unterschiedlich gewählt sind und/oder in unterschiedlichen Positionen gebunden sind.

Wenn an den beiden Phenylenringen in Strukturen der Formel (2) Substituenten gebunden sind, sind bevorzugte Strukturen die Verbindungen der folgenden Formeln (2a) bis (2f), 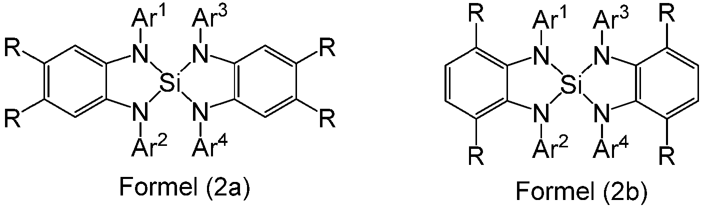 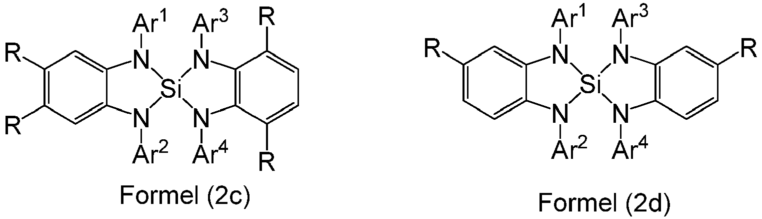 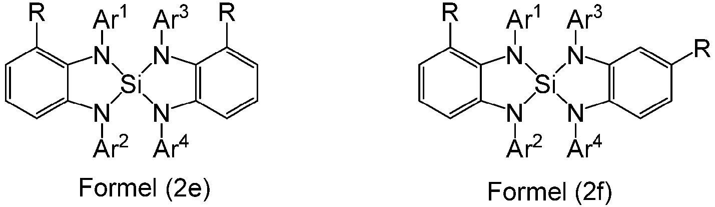 wobei die als unsubstituiert dargestellten Kohlenstoffatome auch teilweise oder vollständig deuteriert sein können, und Ar¹ bis Ar⁴ und R die oben genannten Bedeutungen aufweisen. Dabei sind die Strukturen der Formeln (2a), (2b) und (2d) bevorzugt.

Für die Gruppen Ar¹, Ar², Ar³ und Ar⁴ eignen sich verschiedene Kombinationen und Ausführungsformen:
(1) Ar¹ = Ar² = Ar³ = Ar⁴
(2) Ar¹ = Ar² und Ar³ = Ar⁴, aber Ar¹ ≠ Ar³
(3) Ar¹ = Ar³ und Ar² = Ar⁴, aber Ar¹ ≠ Ar²
(4) Ar¹ = Ar² = Ar³ und Ar⁴ ≠ Ar¹
(5) Ar¹ = Ar² und Ar³ ≠ Ar⁴ ≠ Ar¹
(6) Ar¹ = Ar³ und Ar² ≠ Ar⁴ ≠ Ar¹
(7) Ar¹ ≠ Ar² ≠ Ar³ ≠ Ar⁴.

Dabei sind die Ausführungsformen (1), (2), (3) und (7) besonders bevorzugt. Dabei können unterschiedliche Gruppen Ar¹ bis Ar⁴ unterschiedliche aromatische bzw. heteroaromatische Ringsysteme sein, und/oder es handelt sich um die gleichen aromatischen bzw. heteroaromatischen Ringsysteme, die aber unterschiedlich substituiert sind.

In einer Ausführungsform der Erfindung steht mindestens eine der Gruppen Ar¹, Ar², Ar³ und Ar⁴ für eine elektronenreiche Heteroarylgruppe oder für Benzimidazobenzimidazol, welche jeweils durch einen oder mehrere Reste R substituiert sein können, und/oder mindestens eine Gruppe X steht für CR und dieses R steht für eine elektronenreiche Heteroarylgruppe oder für Benzimidazobenzimidazol, welche jeweils durch einen oder mehrere Reste R¹ substituiert sein können, und/oder mindestens zwei benachbarte Gruppen X stehen für CR und die beiden Reste R bilden zusammen mit den Kohlenstoffatomen, an welche sie binden, eine elektronenreiche Heteroarylgruppe, welche durch einen oder mehrere Reste R¹ substituiert sein kann.

In einer weiteren Ausführungsform der Erfindung steht keine der Gruppen Ar¹, Ar², Ar³ und Ar⁴ für eine elektronenreiche Heteroarylgruppe oder für Benzimidazobenzimidazol, und kein Rest R für X = CR steht für eine elektronenreiche Heteroarylgruppe oder für Benzimidazobenzimidazol, und die Reste R, wenn zwei benachbarte Gruppen X für CR stehen, bilden zusammen mit den Kohlenstoffatomen, an welche sie binden, keine elektronenreiche Heteroarylgruppe.

In einer bevorzugten Ausführungsform der Erfindung enthält die Verbindung keine, eine, zwei, drei oder vier Gruppen Ar¹ bis Ar⁴ bzw. R, die für eine elektronenreiche Heteroarylgruppe bzw. für Benzimidazobenzimidazol stehen, besonders bevorzugt keine, eine, zwei oder drei Gruppen Ar¹ bis Ar⁴ bzw. R und ganz besonders bevorzugt keine, eine oder zwei Gruppen Ar¹ bis Ar⁴ bzw. R.

Wenn zwei benachbarte Gruppen X für CR stehen und die beiden Reste R zusammen mit den Kohlenstoffatomen, an welche sie binden, eine ankondensierte elektronenreiche Heteroarylgruppe bilden, so ist es bevorzugt, wenn eine solche ankondensierte elektronenreiche Heteroarylgruppe einmal oder zweimal vorliegt, besonders bevorzugt einmal. Bevorzugte Ausführungsformen sind hierfür die Verbindungen der folgenden Formeln (2g), (2h), (2i) und (2j), 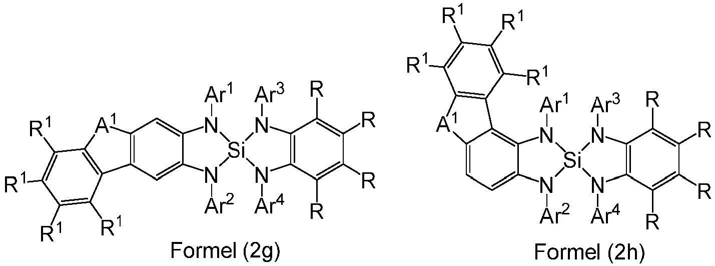 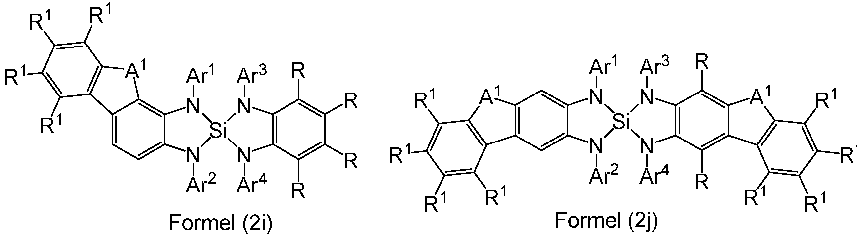 wobei die als unsubstituiert dargestellten Kohlenstoffatome auch teilweise oder vollständig deuteriert sein können, die verwendeten Symbole die oben genannten Bedeutungen aufweisen und A¹ für NR¹, O oder S steht, bevorzugt für NR¹ oder O.

Wenn eine oder mehrere der Gruppen Ar¹ bis Ar⁴ für eine elektronenreiche Heteroarylgruppe stehen, so ist diese Gruppe bevorzugt ausgewählt der Gruppe bestehend aus Dibenzofuran, welches über die 1-, 2-, 3- oder 4-Position verknüpft sein kann, Carbazol, welches über die 1-, 2-, 3- oder 4-Position verknüpft sein kann, Dibenzothiophen, welches über die 1-, 2-, 3- oder 4-Position verknüpft sein kann, Indenocarbazol, das über ein C-Atom verknüpft ist, oder Indolocarbazol, das über ein C-Atom verknüpft ist, wobei die vorgenannten Strukturen jeweils auch durch einen oder mehrere Reste R substituiert sein können.

Wenn eine oder mehrere der Gruppen R für eine elektronenreiche Heteroarylgruppe stehen, so ist diese Gruppe bevorzugt ausgewählt der Gruppe bestehend aus Dibenzofuran, welches über die 1-, 2-, 3- oder 4-Position verknüpft sein kann, Carbazol, welches über die 1-, 2-, 3- oder 4-Position oder über N verknüpft sein kann, Dibenzothiophen, welches über die 1-, 2-, 3- oder 4-Position verknüpft sein kann, Indenocarbazol, welches über ein C- oder ein N-Atom verknüpft sein kann, oder Indolocarbazol, welches über ein C- oder ein N-Atom verknüpft sein kann, wobei die vorgenannten Strukturen jeweils auch durch einen oder mehrere Reste R¹ substituiert sein können.

Nachfolgend werden bevorzugte Ausführungsformen für Ar¹ bis Ar⁴ beschrieben. In einer bevorzugten Ausführungsform der Erfindung ist Ar¹ bis Ar⁴ gleich oder verschieden bei jedem Auftreten ausgewählt aus einem aromatischen oder heteroaromatischen Ringsystem mit 6 bis 30 aromatischen Ringatomen, besonders bevorzugt mit 6 bis 24 aromatischen Ringatomen und ganz besonders bevorzugt mit 6 bis 18 aromatischen Ringatomen, welches jeweils durch einen oder mehrere Reste R substituiert sein kann.

In einer bevorzugten Ausführungsform der Erfindung enthält mindestens eine der Gruppen Ar¹ bis Ar⁴ mindestens 12 aromatische Ringatome. Besonders bevorzugt enthalten mindestens zwei der Gruppen Ar¹ bis Ar⁴ jeweils mindestens 12 aromatische Ringatome.

Wenn alle Gruppen Ar¹ bis Ar⁴ jeweils nur 6 aromatische Ringatome enthalten, ist es bevorzugt, wenn die Verbindung mindestens einen aromatischen oder heteroaromatischen Substituenten R aufweist, der mindestens 12 aromatische Ringatome enthält, und/oder wenn die Verbindung mindestens zwei aromatische oder heteroaromatische Substituenten R aufweist.

Geeignete aromatische bzw. heteroaromatische Ringsysteme Ar¹ bis Ar⁴ sind gleich oder verschieden bei jedem Auftreten ausgewählt aus Phenyl, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, welches über die 1-, 2-, 3- oder 4-Position verknüpft sein kann, Spirobifluoren, welches über die 1-, 2-, 3- oder 4-Position verknüpft sein kann, Naphthalin, welches über die 1- oder 2-Position verknüpft sein kann, Indol, Benzofuran, Benzothiophen, welches über die 1-, 2-, 3- oder 4-Position verknüpft sein kann, Dibenzofuran, welches über die 1-, 2-, 3- oder 4-Position verknüpft sein kann, Carbazol, welches über die 1-, 2-, 3- oder 4-Position verknüpft sein kann, Dibenzothiophen, welches über die 1-, 2-, 3- oder 4-Position verknüpft sein kann, Indenocarbazol, Indolocarbazol, Pyridin, Pyrimidin, Pyrazin, Pyridazin, Triazin, Chinolin, Chinazolin, Benzimidazol, Benzimidazobenzimidazol, Phenanthren, Triphenylen oder einer Kombination aus zwei oder drei dieser Gruppen, welche jeweils mit einem oder mehreren Resten R, bevorzugt nicht-aromatischen Resten R, substituiert sein können und wobei diese Strukturen auch teilweise oder vollständig deuteriert sein können. Wenn Ar¹ bis für eine Heteroarylgruppe, insbesondere für Triazin, Pyrimidin, Chinazolin oder Carbazol steht, können auch aromatische oder heteroaromatische Reste R an dieser Heteroarylgruppe bevorzugt sein.

Bevorzugte Gruppen Ar¹ bis Ar⁴ sind gleich oder verschieden bei jedem Auftreten ausgewählt aus den Gruppen der folgenden Formeln (Ar-1) bis (Ar-144), 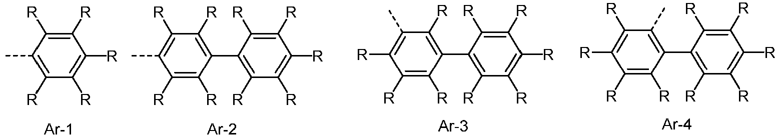 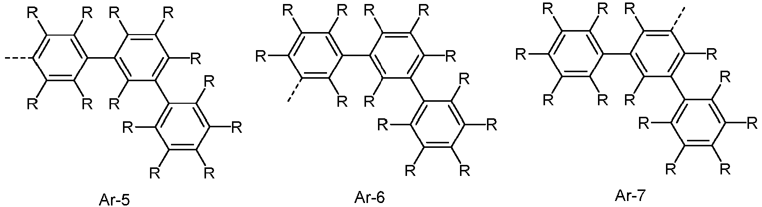 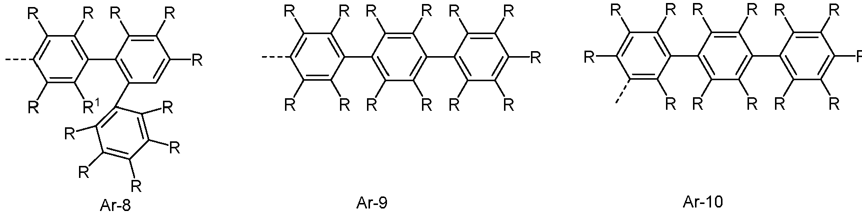 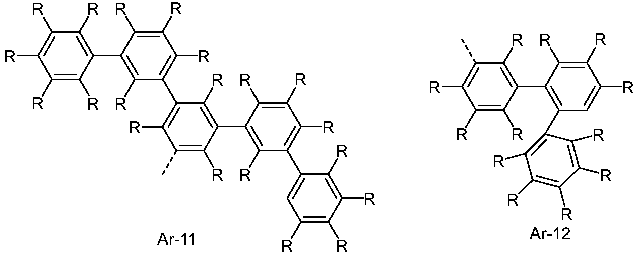 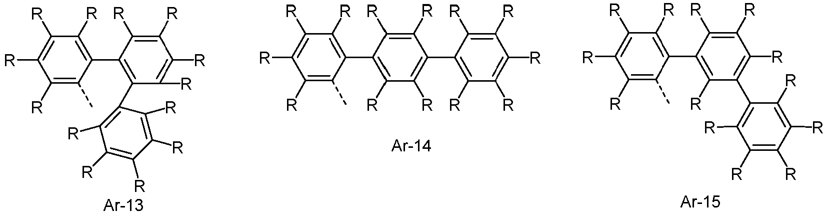 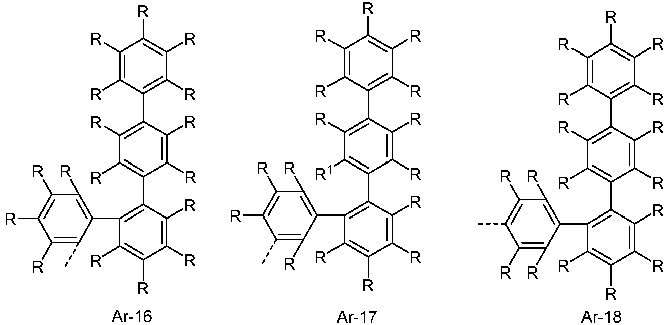 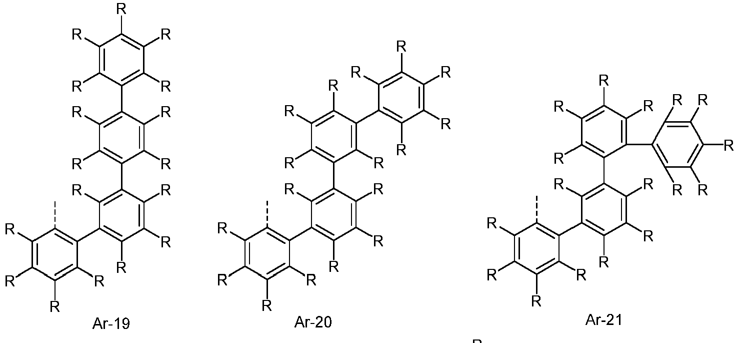 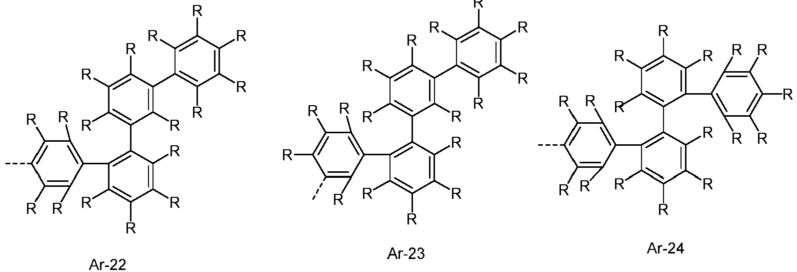 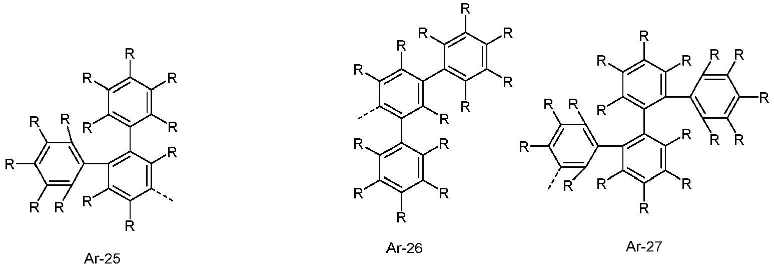 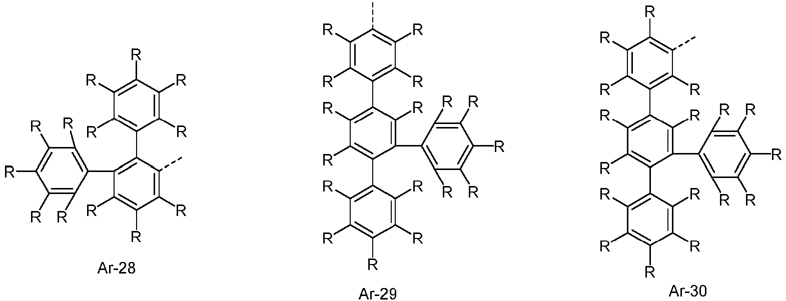 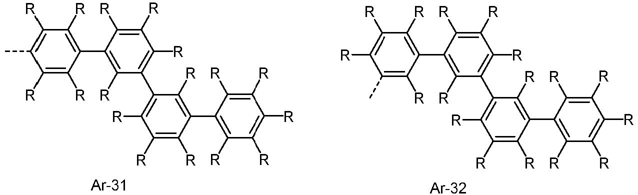 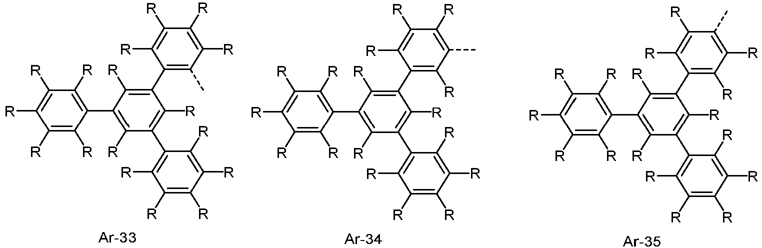 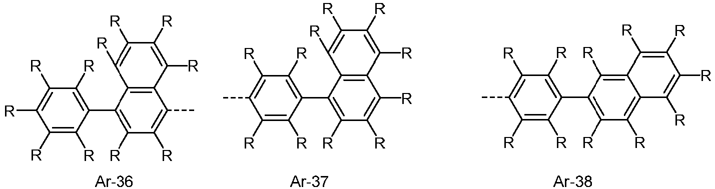 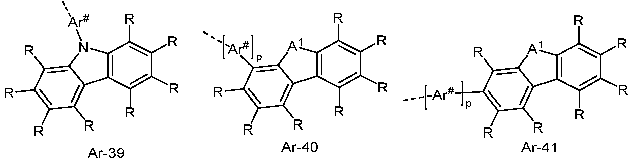 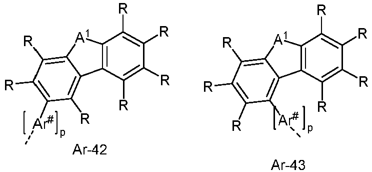 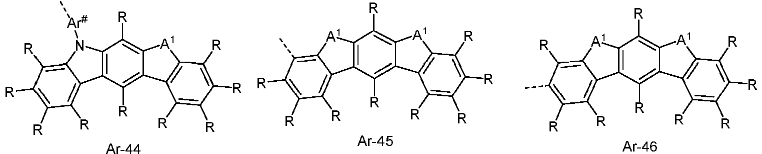 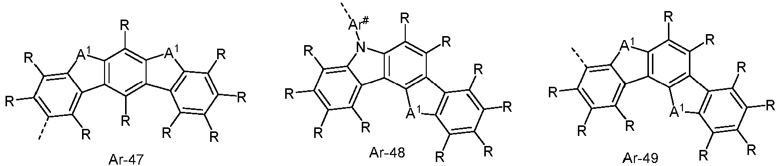 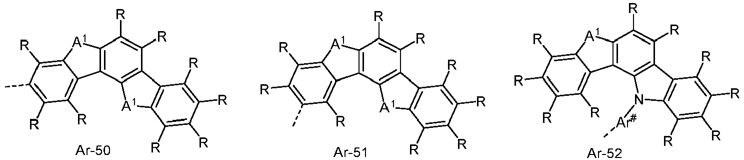 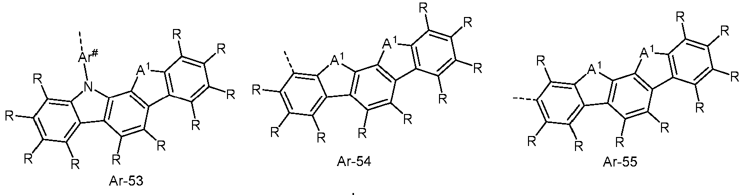 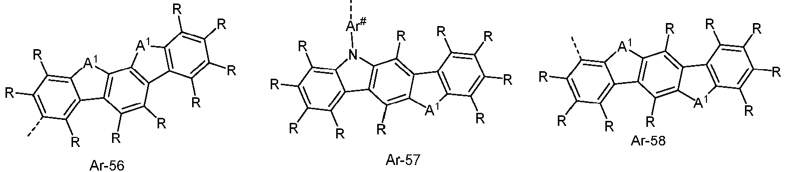 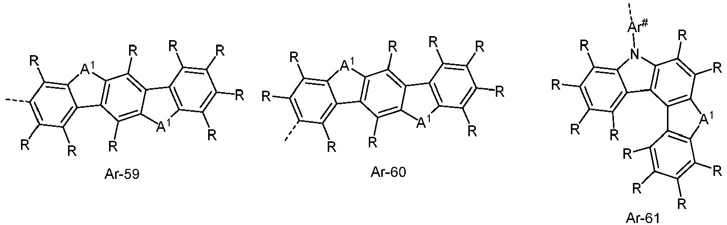 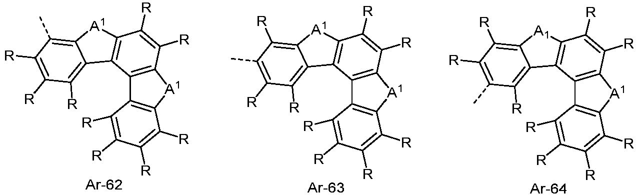 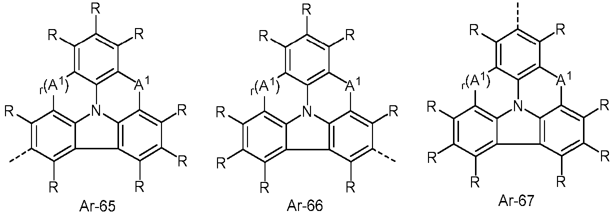 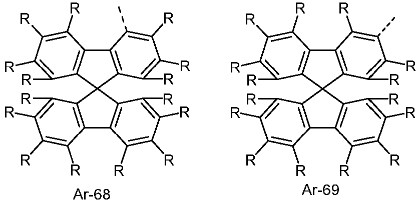 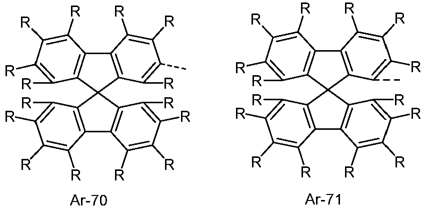 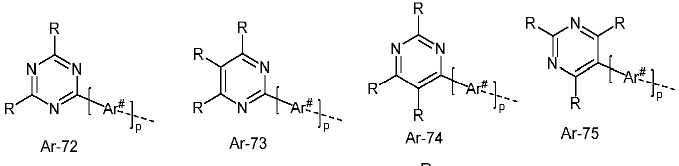 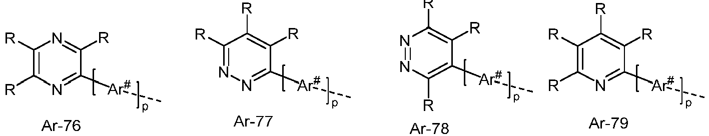 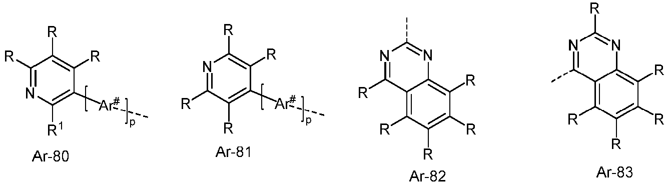 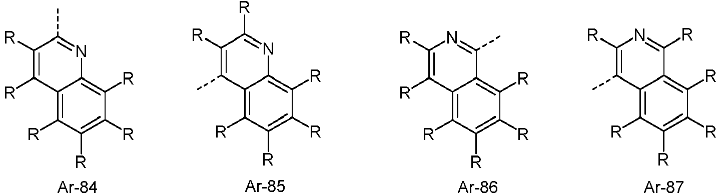 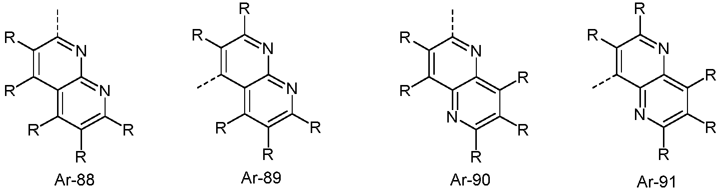 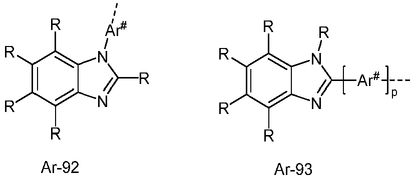 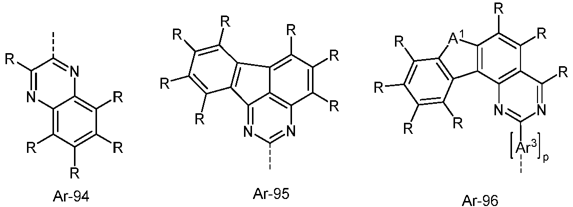 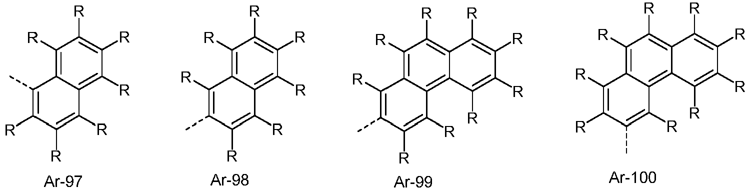 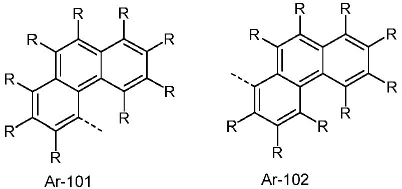 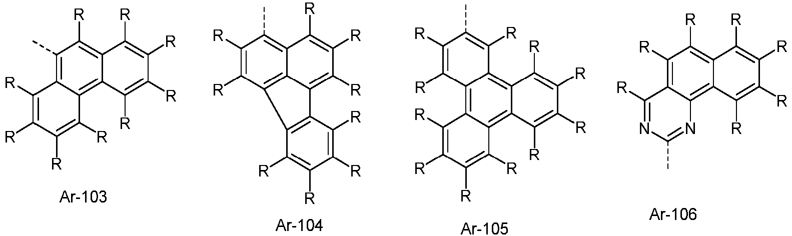 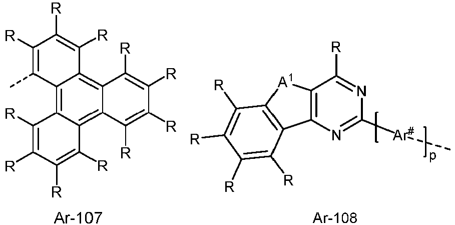 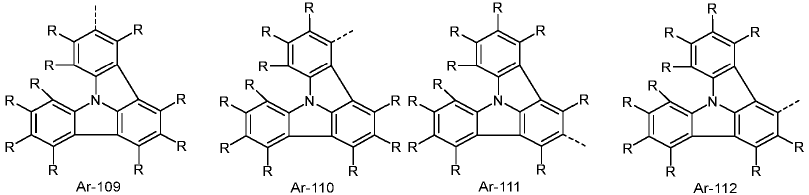 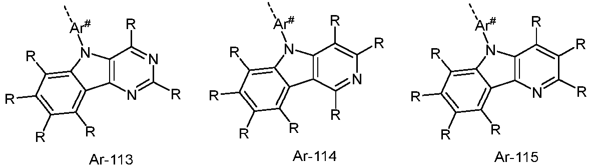 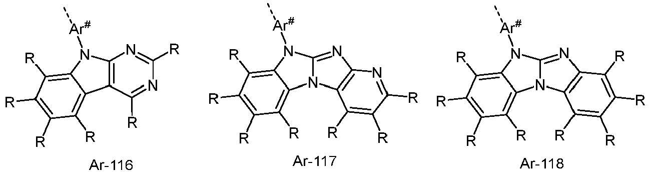 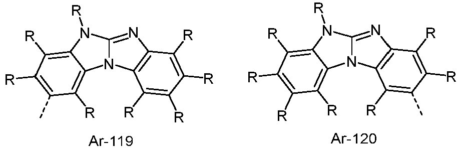 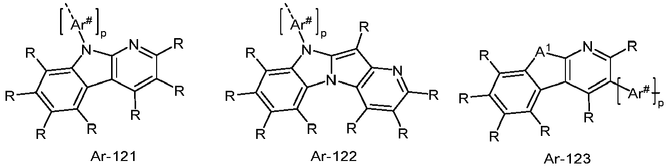 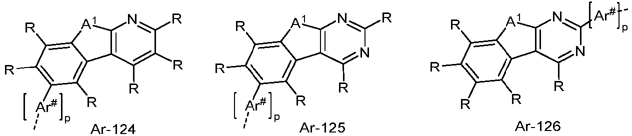 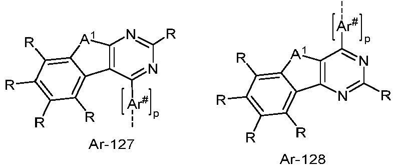 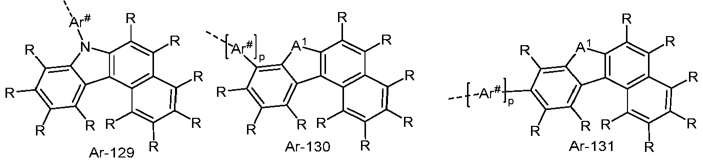 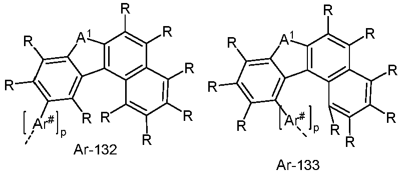 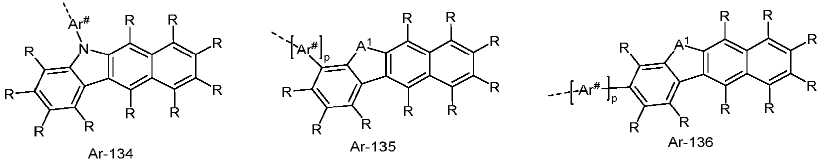 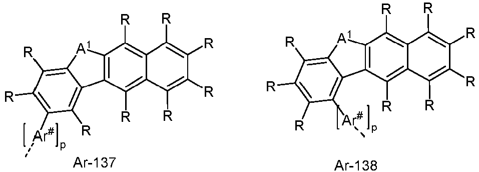 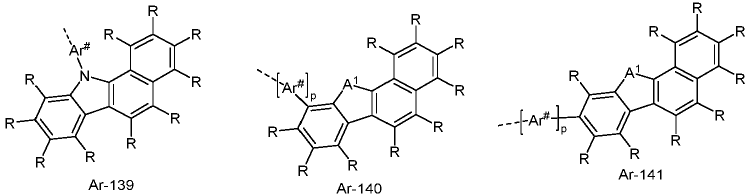 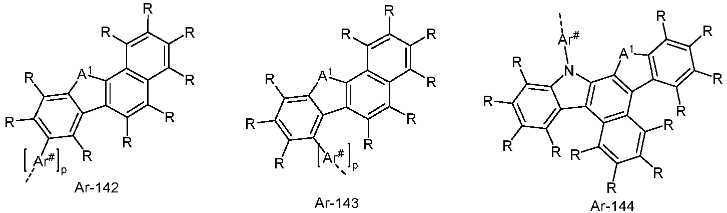 wobei R die oben genannten Bedeutungen aufweist, die gestrichelte Bindung die Bindung an ein Stickstoffatom in Formel (1) darstellt und weiterhin gilt:
- Ar^{#}: ist bei jedem Auftreten gleich oder verschieden ein bivalentes aromatisches oder heteroaromatisches Ringsystem mit 6 bis 18 aromatischen Ringatomen, welches jeweils mit einem oder mehreren Resten R substituiert sein kann;
- A¹: ist bei jedem Auftreten gleich oder verschieden BR, C(R)₂, C=O, NR, O oder S;
- p: ist 0 oder 1, wobei p = 0 bedeutet, dass die Gruppe Ar^{#} nicht vorhanden ist und dass die entsprechende aromatische bzw. heteroaromatische Gruppe direkt an das Stickstoffatom gebunden ist;
- r: ist 0 oder 1, wobei r = 0 bedeutet, dass an dieser Position keine Gruppe A¹ gebunden ist und an die entsprechenden Kohlenstoffatome stattdessen Reste R gebunden sind.

In einer bevorzugten Ausführungsform der Erfindung sind die oben aufgeführten Strukturen für Ar¹ bis Ar⁴ teilweise oder vollständig deuteriert.

In einer bevorzugten Ausführungsform enthalten Ar¹ bis Ar⁴ keine kondensierten Arylgruppen. Dagegen können kondensierte Heteroarylgruppen, in denen keine Sechsringe direkt aneinander ankondensiert sind, geeignet sein, beispielsweise Carbazol, Dibenzofuran oder Dibenzothiophen.

Besonders bevorzugte Gruppen Ar¹ bis Ar⁴ sind gleich oder verschieden bei jedem Auftreten gewählt aus der Gruppe bestehend aus den folgenden Strukturen Ar-a bis Ar-I, 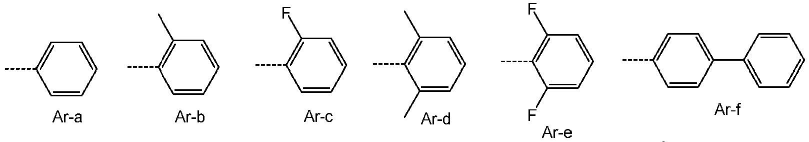 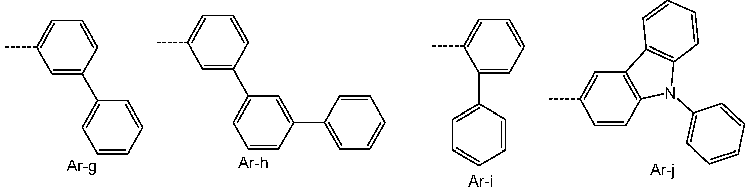 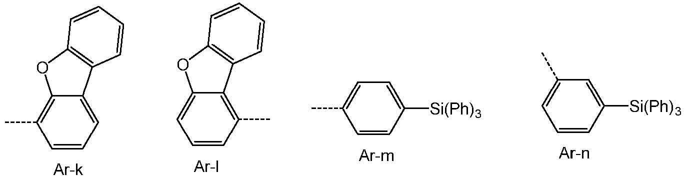 wobei die gestrichelte Bindung die Bindung an das Stickstoffatom darstellt und diese Strukturen bevorzugt teilweise oder vollständig deuteriert sind.

Beispiele für besonders bevorzugte Kombinationen von Ar¹, Ar², Ar³ und Ar⁴ sind die in der folgenden Tabelle aufgeführten Kombinationen:

| **Ar¹** | **Ar²** | **Ar³** | **Ar⁴** |
|---|---|---|---|
| Ar-a | Ar-a | Ar-g | Ar-g |
| Ar-a | Ar-g | Ar-a | Ar-g |
| Ar-a | Ar-a | Ar-j | Ar-a |
| Ar-a | Ar-a | Ar-k | Ar-a |
| Ar-a | Ar-a | Ar-n | Ar-a |
| Ar-a | Ar-a | Ar-j | Ar-a |
| Ar-a | Ar-a | Ar-k | Ar-a |
| Ar-a | Ar-a | Ar-n | Ar-a |
| Ar-a | Ar-a | Ar-j | Ar-g |
| Ar-a | Ar-a | Ar-k | Ar-g |
| Ar-a | Ar-a | Ar-n | Ar-g |
| Ar-a | Ar-a | Ar-j | Ar-j |
| Ar-a | Ar-a | Ar-k | Ar-k |
| Ar-a | Ar-j | Ar-j | Ar-a |
| Ar-a | Ar-k | Ar-k | Ar-a |
| Ar-a | Ar-g | Ar-j | Ar-a |
| Ar-a | Ar-g | Ar-k | Ar-a |
| Ar-a | Ar-g | Ar-n | Ar-a |
| Ar-g | Ar-g | Ar-j | Ar-a |
| Ar-g | Ar-g | Ar-k | Ar-a |
| Ar-g | Ar-g | Ar-n | Ar-a |

Im Folgenden werden bevorzugte Substituenten R, R¹ und R² beschrieben. In einer besonders bevorzugten Ausführungsform der Erfindung treten die nachfolgend genannten Bevorzugungen für R, R¹ und R² gleichzeitig auf und gelten für die Strukturen der Formel (1) sowie für alle bevorzugten Ausführungsformen.

Bevorzugte Substituenten R, die an Ar¹ bis Ar⁴ gebunden sind, sind bei jedem Auftreten gleich oder verschieden ausgewählt aus der Gruppe bestehend aus H, D, F, CN, Si(R¹)₃, Ge(R¹)₃, einer geradkettigen Alkylgruppe mit 1 bis 10 C-Atomen oder cyclischen Alkylgruppe mit 3 bis 10 C-Atomen, wobei die Alkylgruppe jeweils optional deuteriert und/oder mit einem oder mehreren Resten R¹ substituiert sein kann und bevorzugt außer einer optionalen Deuterierung unsubstituiert ist, und wobei eine oder mehrere nicht benachbarte CH₂-Gruppen durch O ersetzt sein können; dabei können zwei benachbarte Reste R miteinander ein Ringsystem bilden. Besonders bevorzugt ist R, welches an Ar¹ bis Ar⁴ gebunden ist, bei jedem Auftreten gleich oder verschieden ausgewählt aus der Gruppe bestehend aus H, D, F, CN, Si(R¹)₃, einer geradkettigen Alkylgruppe mit 1 bis 6 C-Atomen, insbesondere mit 1, 2, 3 oder 4 C-Atomen, oder einer verzweigten oder cyclischen Alkylgruppe mit 3 bis 6 C-Atomen, wobei die Alkylgruppe jeweils optional deuteriert und/oder mit einem oder mehreren Resten R¹ substituiert sein kann und bevorzugt außer einer optionalen Deutierung unsubstituiert ist; dabei können zwei benachbarte R miteinander ein Ringsystem bilden. Ganz besonders bevorzugt ist R, welches an Ar¹ bis Ar⁴ gebunden ist, bei jedem Auftreten gleich oder verschieden ausgewählt aus der Gruppe bestehend aus H, D, F, CN, Si(C₆H₅)₃, wobei die Phenylgruppe auch deuteriert sein kann und/oder mit einer oder mehreren optional deuterierten Methylgruppen substituiert sein kann, oder optional deuteriertes Methyl.

Bevorzugte Substituenten R, die für X = CR an das Kohlenstoffatom binden, sind bei jedem Auftreten gleich oder verschieden ausgewählt aus der Gruppe bestehend aus H, D, F, CN, OR¹, N(R¹)₂, Si(R¹)₃, Ge(R¹)₃, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils optional deuteriert und/oder mit einem oder mehreren Resten R¹ substituiert sein kann und bevorzugt außer einer optionalen Deuterierung unsubstituiert ist, oder einem aromatischen oder heteroaromatischen Ringsystem mit 6 bis 30 aromatischen Ringatomen, das jeweils optional deuteriert und/oder durch einen oder mehrere Reste R¹ substituiert sein kann. Besonders bevorzugt ist R, welches für X = CR an das Kohlenstoffatom bindet, bei jedem Auftreten gleich oder verschieden ausgewählt aus der Gruppe bestehend aus H, D, F, CN, Si(R¹)₃, einer geradkettigen Alkylgruppe mit 1 bis 6 C-Atomen, insbesondere mit 1, 2, 3 oder 4 C-Atomen, oder einer verzweigten oder cyclischen Alkylgruppe mit 3 bis 6 C-Atomen, wobei die Alkylgruppe jeweils optional deuteriert und/oder mit einem oder mehreren Resten R¹ substituiert sein kann und bevorzugt außer einer optionalen Deuterierung unsubstituiert ist, oder einem aromatischen oder heteroaromatischen Ringsystem mit 6 bis 24 aromatischen Ringatomen, das jeweils optional deuteriert und/oder durch einen oder mehrere Reste R¹, bevorzugt nicht-aromatische Reste R¹, substituiert sein kann. Ganz besonders bevorzugt ist R, welches für X = CR an das Kohlenstoffatom bindet, bei jedem Auftreten gleich oder verschieden ausgewählt aus der Gruppe bestehend aus H, D, F, CN, Si(C₆H₅)₃, wobei die Phenylgruppe optional deuteriert und/oder mit einer oder mehreren optional deuterierten Methylgruppen substituiert sein kann, oder einem aromatischen oder heteroaromatischen Ringsystem mit 6 bis 24 aromatischen Ringatomen, besonders bevorzugt mit 6 bis 18 aromatischen Ringatomen, das jeweils optional deuteriert und/oder durch einen oder mehrere Reste R¹, bevorzugt nicht-aromatische Reste R¹, substituiert sein kann.

Geeignete aromatische bzw. heteroaromatische Ringsysteme R sind ausgewählt aus Phenyl, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, welches über die 1-, 2-, 3- oder 4-Position verknüpft sein kann, Spirobifluoren, welches über die 1-, 2-, 3- oder 4-Position verknüpft sein kann, Naphthalin, welches über die 1- oder 2-Position verknüpft sein kann, Indol, Benzofuran, Benzothiophen, welches über die 1-, 2-, 3- oder 4-Position verknüpft sein kann, Dibenzofuran, Carbazol, welches über die 1-, 2-, 3- oder 4-Position verknüpft sein kann, Dibenzothiophen, welches über die 1-, 2-, 3- oder 4-Position verknüpft sein kann, Indenocarbazol, Indolocarbazol, Pyridin, Pyrimidin, Pyrazin, Pyridazin, Triazin, Chinolin, Chinazolin, Benzimidazol, Phenanthren, Triphenylen oder einer Kombination aus zwei oder drei dieser Gruppen, welche jeweils teilweise oder vollständig deuteriert und/oder mit einem oder mehreren Resten R¹ substituiert sein können. Wenn R für eine Heteroarylgruppe, insbesondere für Triazin, Pyrimidin, Chinazolin oder Carbazol steht, können auch aromatische oder heteroaromatische Reste R¹ an dieser Heteroarylgruppe bevorzugt sein.

Dabei sind die Gruppen R, wenn sie für ein aromatisches bzw. heteroaromatisches Ringsystem stehen, bevorzugt gewählt aus den Gruppen der folgenden Formeln R-1 bis R-144, 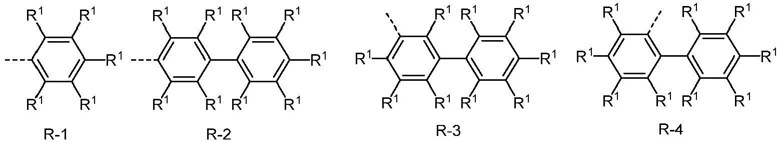 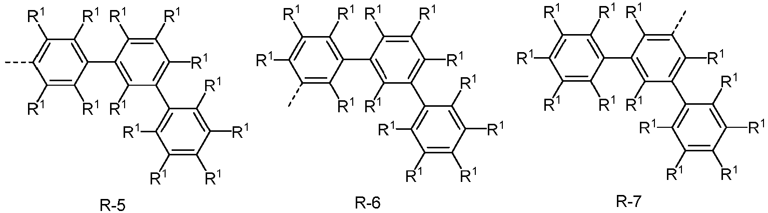 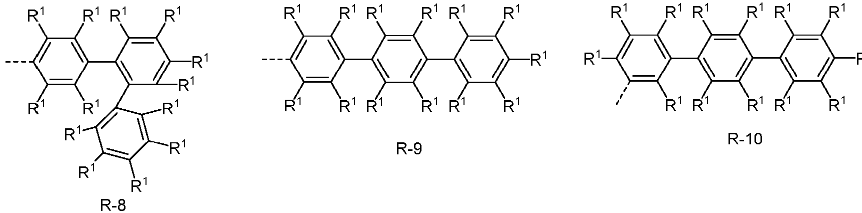 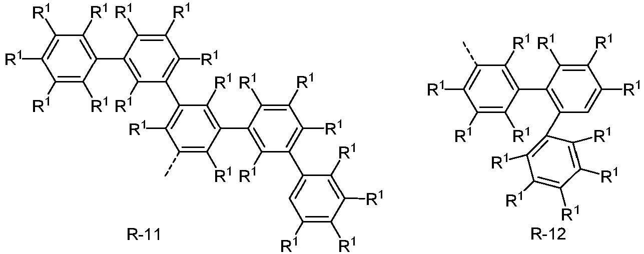 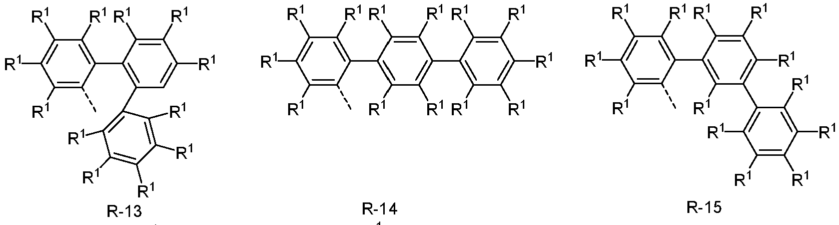 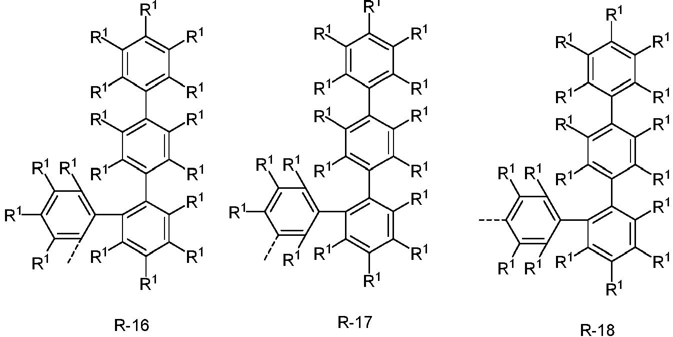 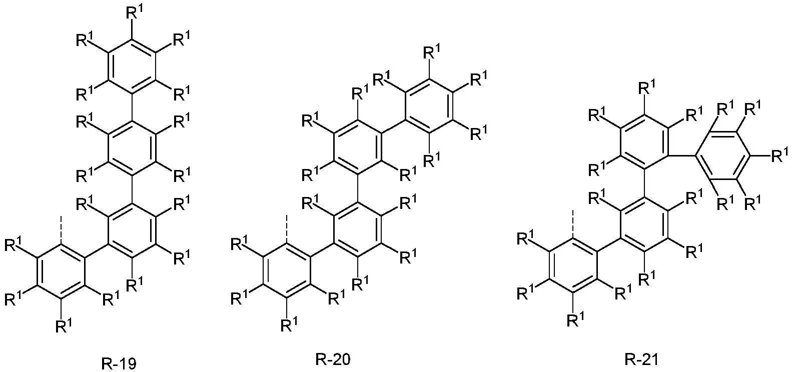 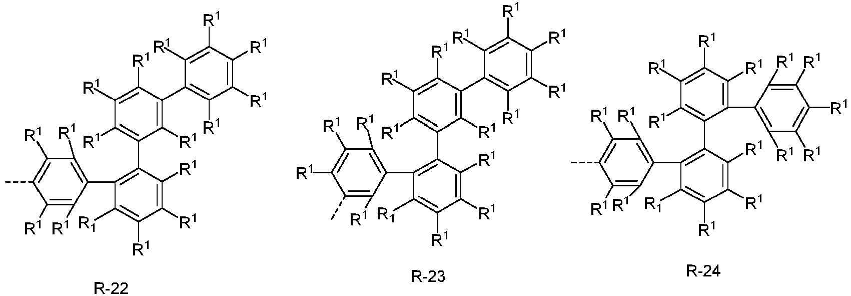 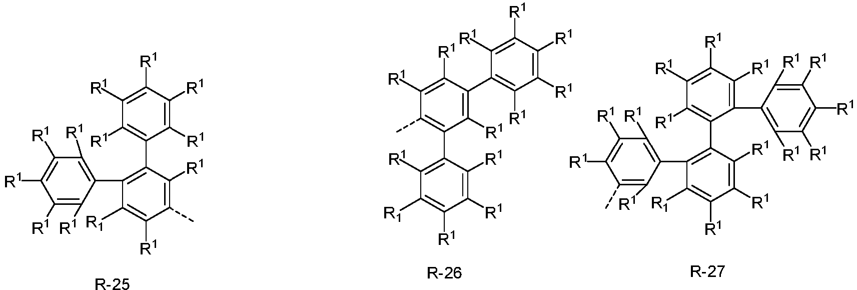 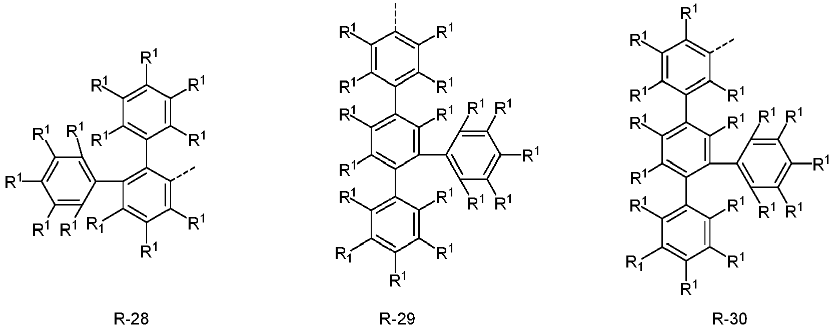 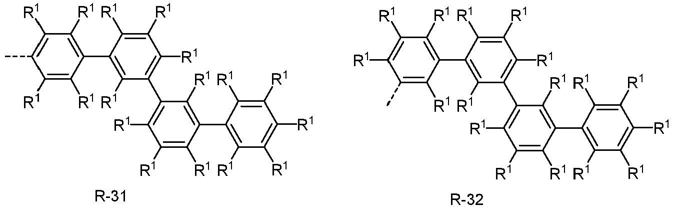 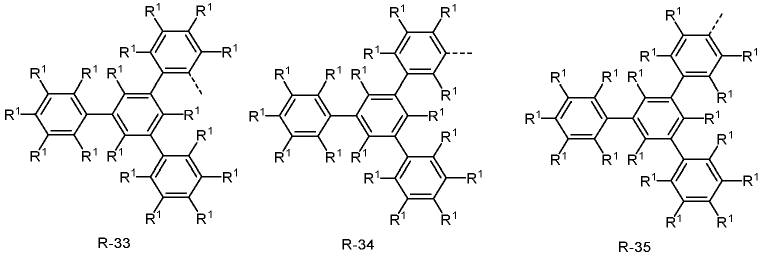 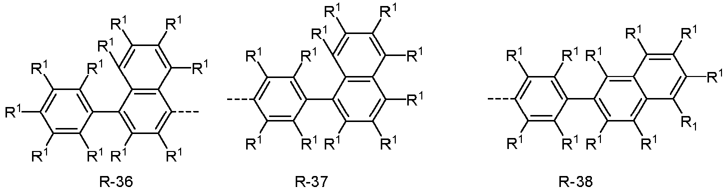 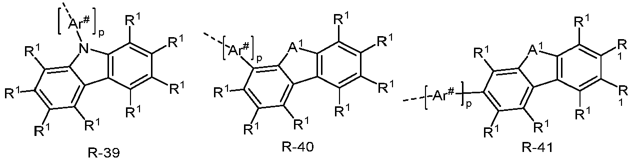 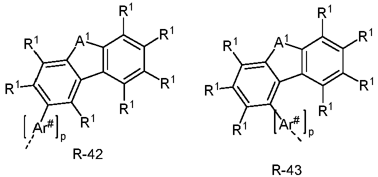 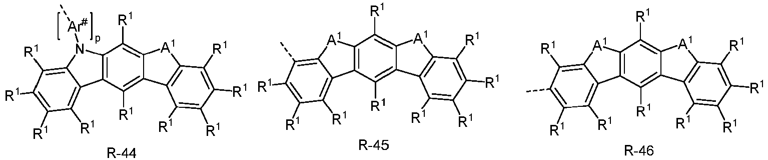 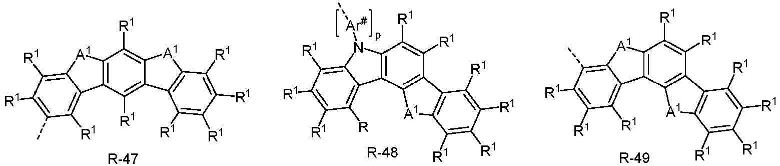 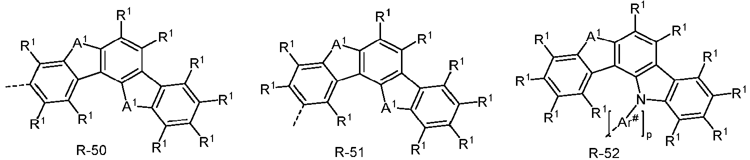 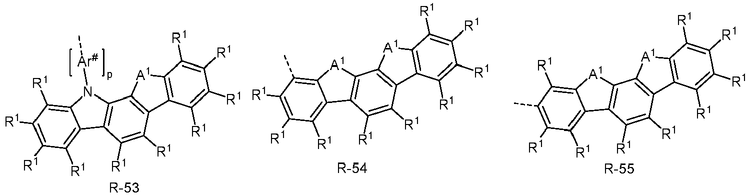 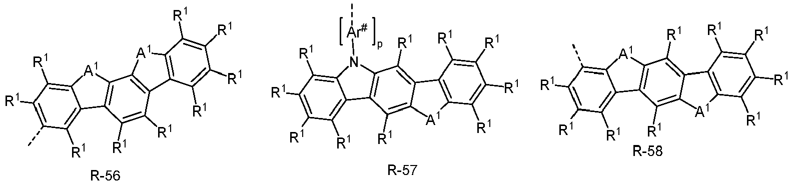 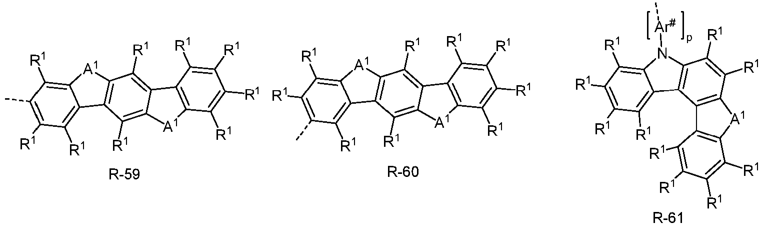 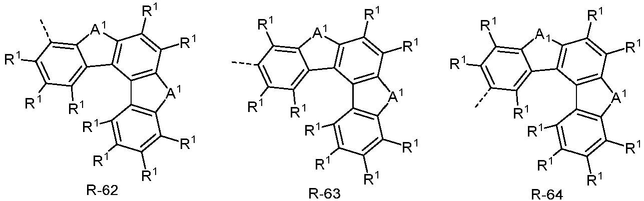 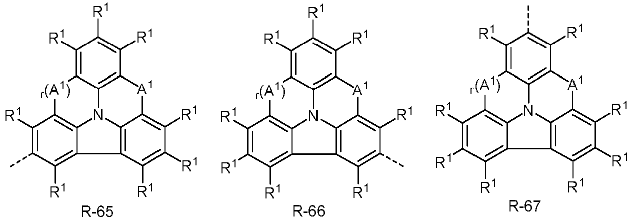 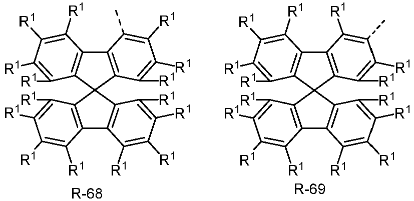 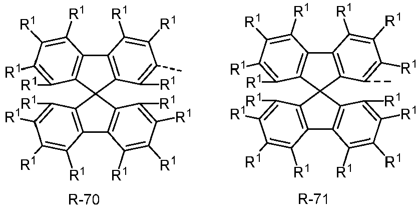 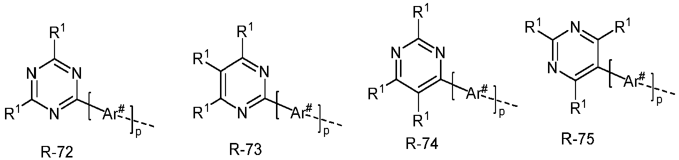 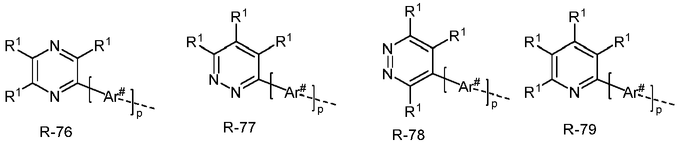 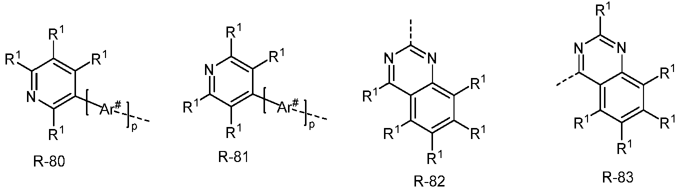 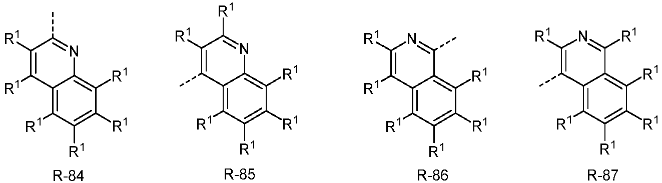 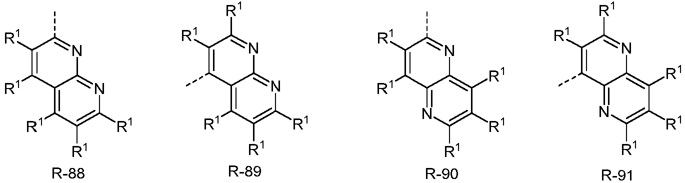 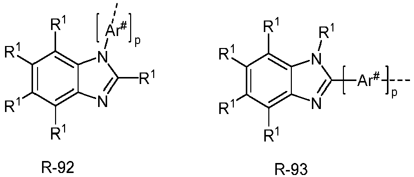 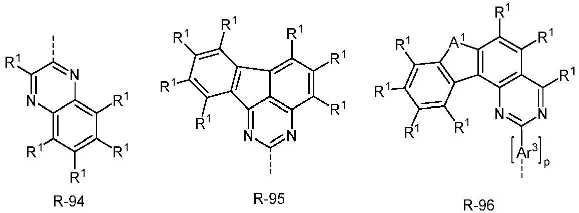 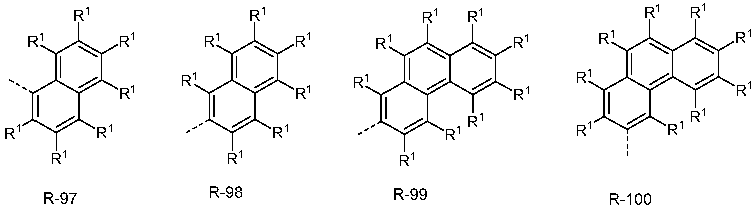 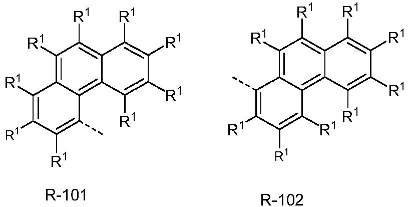 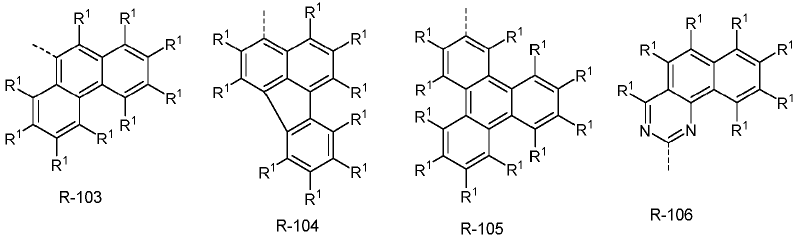 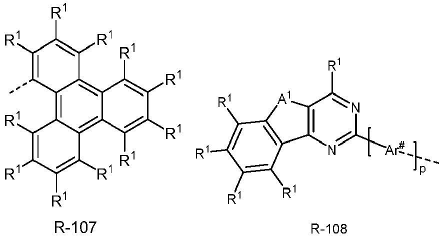 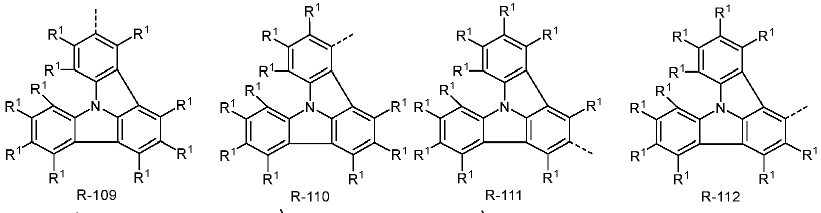 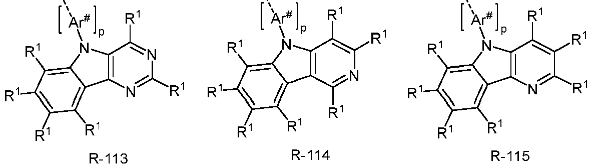 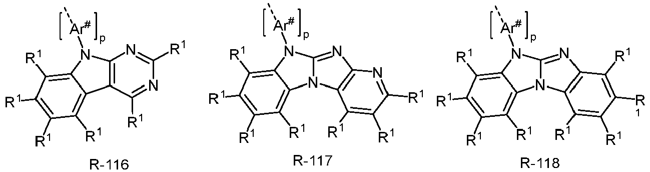 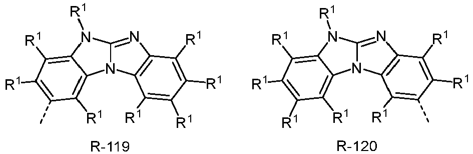 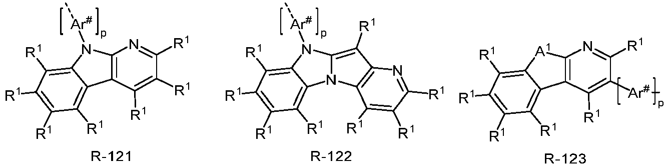 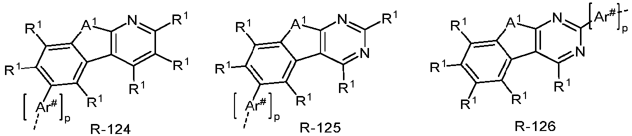 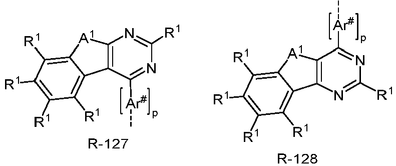 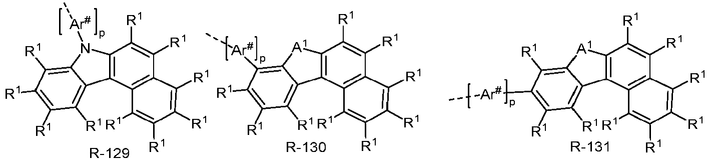 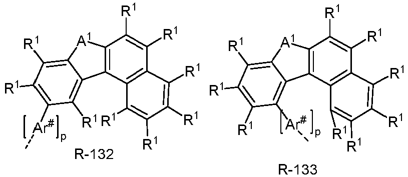 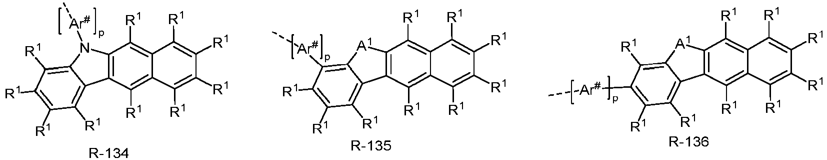 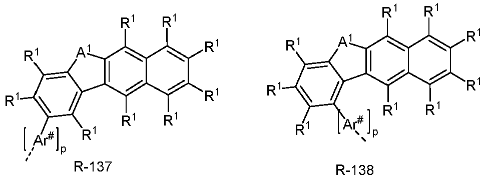 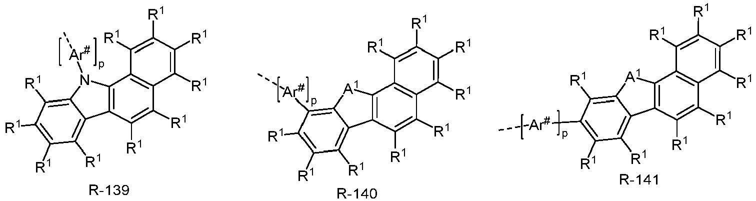 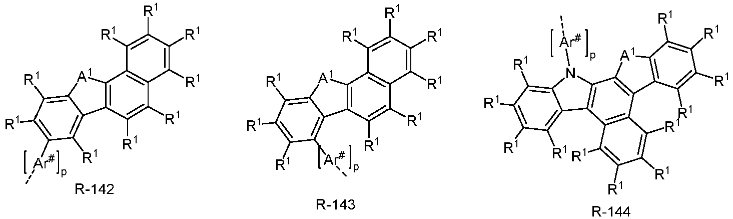 wobei R¹ die oben genannten Bedeutungen aufweist, die gestrichelte Bindung die Bindung der Gruppe darstellt und weiterhin gilt:
- Ar^{#}: ist bei jedem Auftreten gleich oder verschieden ein bivalentes aromatisches oder heteroaromatisches Ringsystem mit 6 bis 18 aromatischen Ringatomen, welches jeweils mit einem oder mehreren Resten R¹ substituiert sein kann;
- A¹: ist bei jedem Auftreten gleich oder verschieden BR¹, C(R¹)₂, C=O, NR¹, O oder S;
- p: ist 0 oder 1, wobei p = 0 bedeutet, dass die Gruppe Ar^{#} nicht vorhanden ist und dass die entsprechende aromatische bzw. heteroaromatische Gruppe direkt an das zugehörige Kohlenstoffatom;
- r: ist 0 oder 1, wobei r = 0 bedeutet, dass an dieser Position keine Gruppe A¹ gebunden ist und an die entsprechenden Kohlenstoffatome stattdessen Reste R¹ gebunden sind.

Dabei sind diese Strukturen bevorzugt teilweise oder vollständig deuteriert, so dass bevorzugt ein oder mehrere der Substituenten R¹ für D stehen.

Wenn die oben genannten Gruppen Ar-1 bis Ar-144 für Ar bzw. R-1 bis R-144 für R mehrere Gruppen A¹ aufweisen, so kommen hierfür alle Kombinationen aus der Definition von A¹ in Frage. Bevorzugte Ausführungsformen sind dann solche, in denen eine Gruppe A¹ für C(R)₂, NR, O oder S und die andere Gruppe A¹ für C(R)₂, NR, O oder S steht, wenn die sich um eine Gruppe Ar handelt, bzw. in denen eine Gruppe A¹ für C(R¹)₂, NR¹, O oder S und die andere Gruppe A¹ für C(R¹)₂, NR¹, O oder S steht, wenn es sich um eine Gruppe R handelt.

Wenn A¹ für NR bzw. NR¹ steht, steht der Substituent R bzw. R¹, der an das Stickstoffatom gebunden ist, bevorzugt für ein aromatisches oder heteroaromatisches Ringsystem mit 5 bis 24 aromatischen Ringatomen, welches auch durch einen oder mehrere Reste R¹ bzw. R² substituiert sein kann. In einer besonders bevorzugten Ausführungsform steht dieser Substituent R bzw. R¹ gleich oder verschieden bei jedem Auftreten für ein aromatisches oder heteroaromatisches Ringsystem mit 6 bis 24 aromatischen Ringatomen, bevorzugt mit 6 bis 12 aromatischen Ringatomen, und welches jeweils auch durch einen oder mehrere Reste R¹ bzw. R² substituiert sein kann. Besonders bevorzugt sind Phenyl, Biphenyl, Terphenyl und Quaterphenyl mit Verknüpfungsmustern, wie vorne für Ar-1 bis Ar-35 bzw. R-1 bis R-35 aufgeführt, wobei diese Strukturen auch teilweise oder vollständig deuteriert und/oder durch einen oder mehrere Reste R bzw. R¹ substituiert sein können und bevorzugt außer der optionalen Deuterierung unsubstituiert sind.

Wenn A¹ für C(R)₂ bzw. C(R¹)₂ steht, stehen die Substituenten R bzw. R¹, die an dieses Kohlenstoffatom gebunden sind, bevorzugt gleich oder verschieden bei jedem Auftreten für eine optional deuterierte lineare Alkylgruppe mit 1 bis 10 C-Atomen oder für eine optional deuterierte verzweigte oder cyclische Alkylgruppe mit 3 bis 10 C-Atomen oder für ein optional deuteriertes aromatisches oder heteroaromatisches Ringsystem mit 5 bis 24 aromatischen Ringatomen, welches auch durch einen oder mehrere Reste R¹ bzw. R² substituiert sein kann. Ganz besonders bevorzugt steht R bzw. R¹ für eine optional deuterierte Methylgruppe oder für eine optional deuterierte Phenylgruppe. Dabei können die Reste R bzw. R¹ auch miteinander ein Ringsystem bilden, was zu einem Spirosystem führt.

In einer weiteren bevorzugten Ausführungsform der Erfindung ist R¹ gleich oder verschieden bei jedem Auftreten ausgewählt aus der Gruppe bestehend aus H, D, F, CN, Si(R²)₃, Ge(R²)₃, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl- bzw. Alkenylgruppe jeweils teilweise oder vollständig deuteriert und/oder mit einem oder mehreren Resten R² substituiert sein kann, oder einem aromatischen oder heteroaromatischen Ringsystem mit 6 bis 30 aromatischen Ringatomen, das jeweils teilweise oder vollständig deuteriert und/oder durch einen oder mehrere Reste R² substituiert sein kann; dabei können zwei oder mehrere Reste R¹ miteinander ein aliphatisches Ringsystem bilden. In einer besonders bevorzugten Ausführungsform der Erfindung ist R¹ gleich oder verschieden bei jedem Auftreten ausgewählt aus der Gruppe bestehend aus H, D, Si(C₆H₅)₃, wobei die Phenylgruppe auch optional deuteriert und/oder jeweils mit einer oder mehreren optional deuterierten Methylgruppen substituiert sein kann, einer optional deuterierten geradkettigen Alkylgruppe mit 1 bis 6 C-Atomen, insbesondere mit 1, 2, 3 oder 4 C-Atomen, oder einer optional deuterierten verzweigten oder cyclischen Alkylgruppe mit 3 bis 6 C-Atomen, wobei die Alkylgruppe mit einem oder mehreren Resten R² substituiert sein kann, bevorzugt aber außer der optionalen Deuterierung unsubstituiert ist, oder einem aromatischen oder heteroaromatischen Ringsystem mit 6 bis 24 aromatischen Ringatomen, das jeweils auch optional deuteriert und/oder durch einen oder mehrere Reste R² substituiert sein kann.

In einer weiteren bevorzugten Ausführungsform der Erfindung ist R² gleich oder verschieden bei jedem Auftreten H, D, CN, F, eine optional deuterierte Alkylgruppe mit 1 bis 4 C-Atomen oder eine optional deuterierte Arylgruppe mit 6 bis 10 C-Atomen, welche mit einer optional deuterierten Alkylgruppe mit 1 bis 4 C-Atomen substituiert sein kann.

In einer weiteren bevorzugten Ausführungsform der Erfindung sind alle Reste R¹, soweit sie für ein aromatisches oder heteroaromatisches Ringsystem stehen, ausgewählt aus den Gruppen R-1 bis R-144, welche allerdings dann jeweils entsprechend mit R² statt R¹ substituiert sind.

Dabei haben die Alkylgruppen in erfindungsgemäßen Verbindungen, die durch Vakuumverdampfung verarbeitet werden, bevorzugt nicht mehr als fünf C-Atome, besonders bevorzugt nicht mehr als 4 C-Atome, ganz besonders bevorzugt nicht mehr als 1 C-Atom.

Die erfindungsgemäßen Verbindungen können bei ihrer Verwendung als Racemat oder als reines Enantiomer vorliegen. Die Bildung von Enantiomeren ist beispielsweise möglich, wenn in den erfindungsgemäßen Verbindungen die Gruppen Ar¹, Ar², Ar³ und Ar⁴ alle unterschiedlich gewählt sind.

Die oben genannten bevorzugten Ausführungsformen können beliebig innerhalb der in Anspruch 1 definierten Einschränkungen miteinander kombiniert werden. In einer besonders bevorzugten Ausführungsform der Erfindung treten die oben genannten Bevorzugungen gleichzeitig auf.

Beispiele für bevorzugte Verbindungen gemäß den oben aufgeführten Ausführungsformen sind die in der folgenden Tabelle aufgeführten Verbindungen. Dabei sind die Verbindungen als vollständig deuterierte Verbindungen dargestellt. Wie vorstehend erläutert, handelt es sich jedoch um eine Mischung von Verbindungen derselben Grundstruktur, welche jeweils einen unterschiedlichen Deuterierungsgrad aufweisen, so dass die nachfolgende Darstellung als vereinfachte Darstellung für Verbindungen mit unterschiedlichem Deuterierungsgrad angesehen werden können.

| | |
|---|---|
| 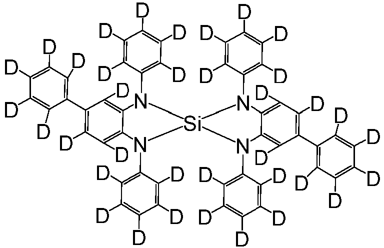 | 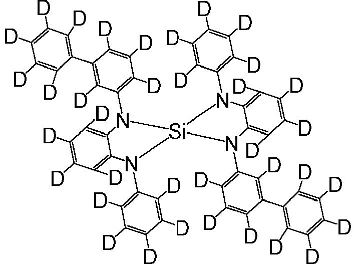 |
| 1 | 2 |
| 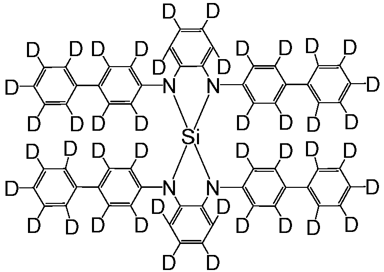 | 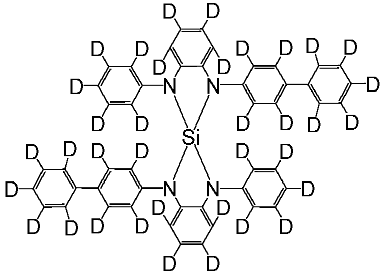 |
| 3 | 4 |
| 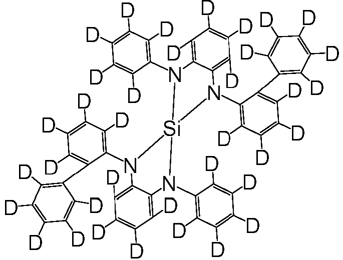 | 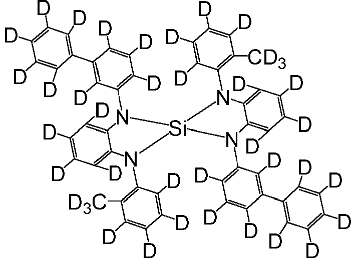 |
| 5 | 6 |
| 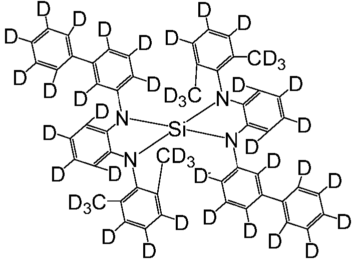 | 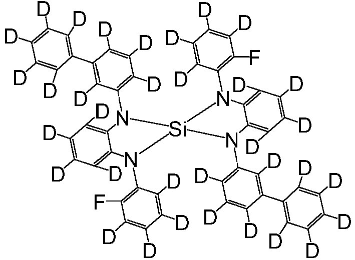 |
| 7 | 8 |
| 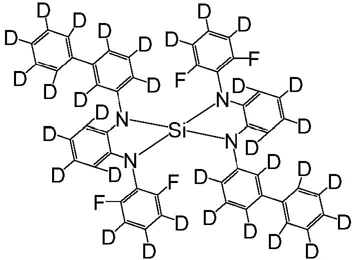 | 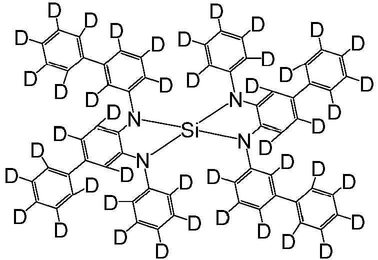 |
| 9 | 10 |
| 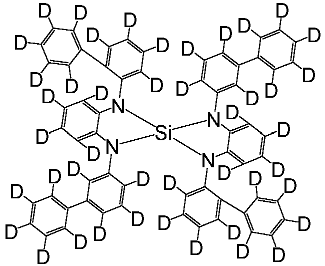 | 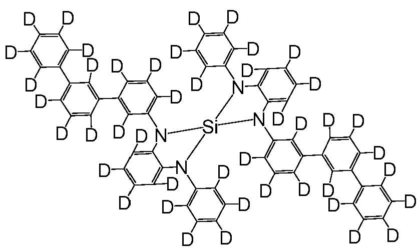 |
| 11 | 12 |
| 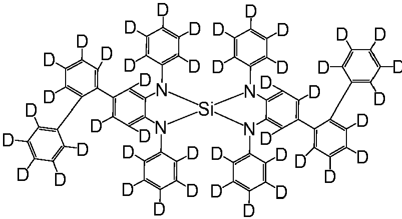 | 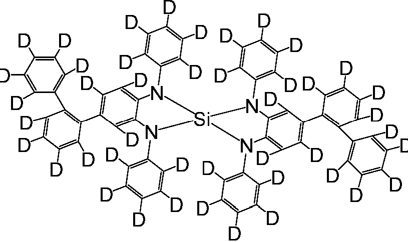 |
| 13 | 14 |
| 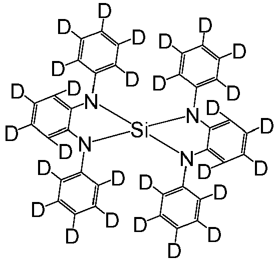 | 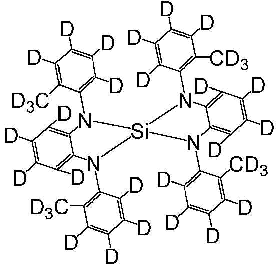 |
| 15 | 16 |
| 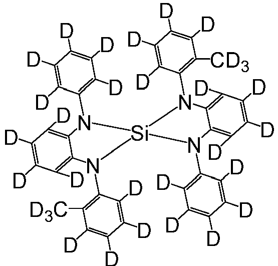 | 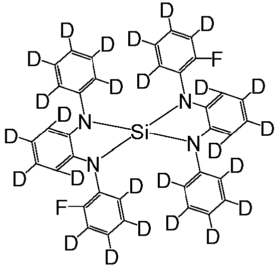 |
| 17 | 18 |
| 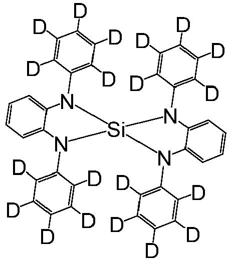 | 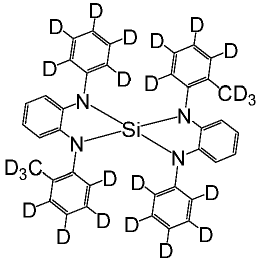 |
| 19 | 20 |
| 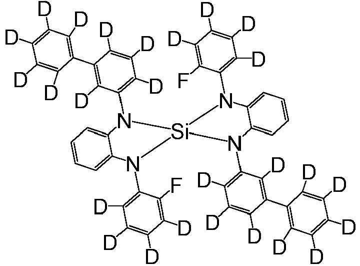 | 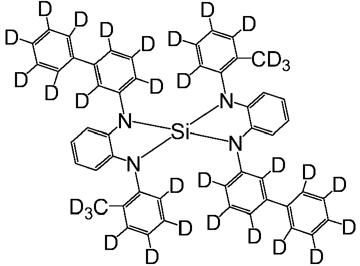 |
| 21 | 22 |
| 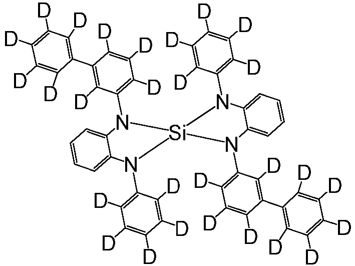 | 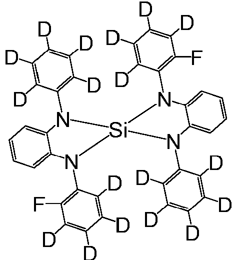 |
| 23 | 24 |
| 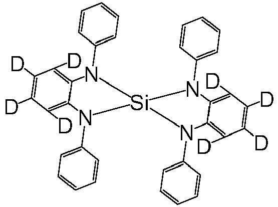 | 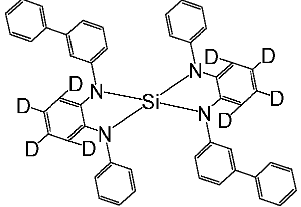 |
| 25 | 26 |
| 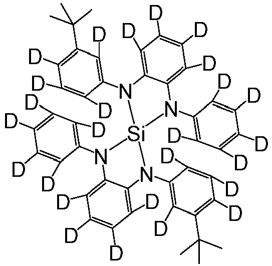 | 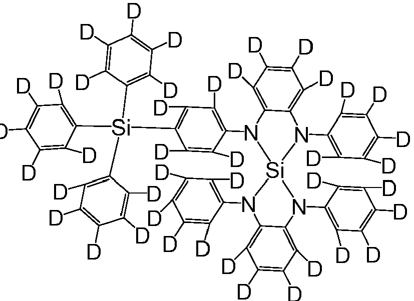 |
| 27 | 28 |
| 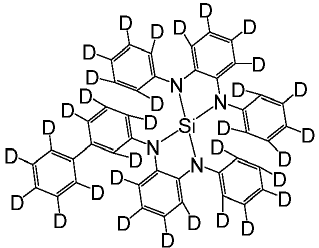 | 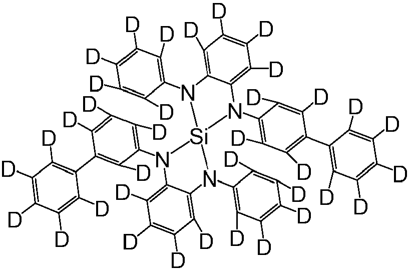 |
| 29 | 30 |
| 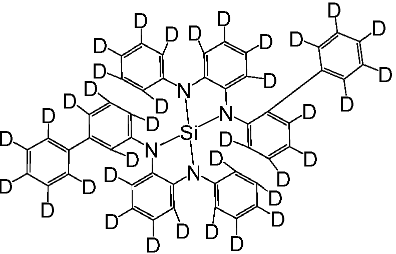 | 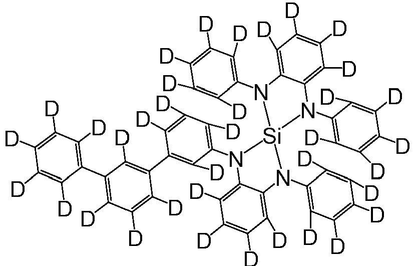 |
| 31 | 32 |
| 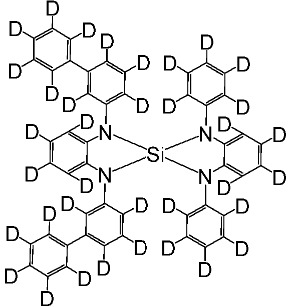 | 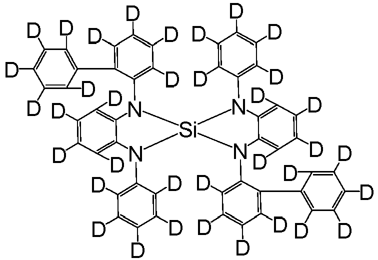 |
| 33 | 34 |
| 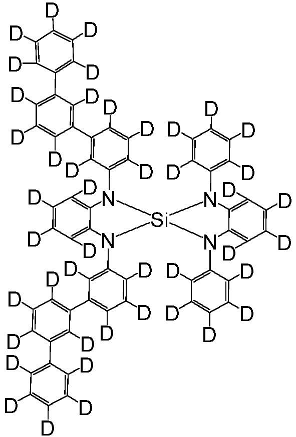 | 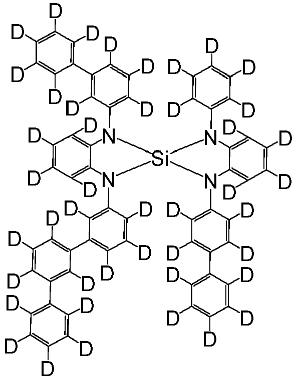 |
| 35 | 36 |
| 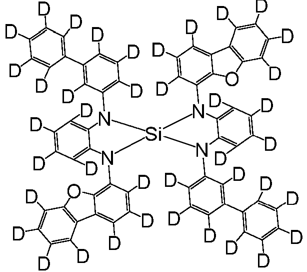 | 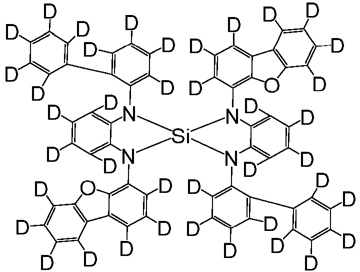 |
| 37 | 38 |
| 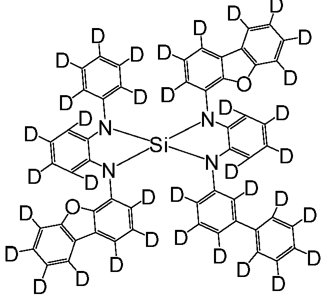 | 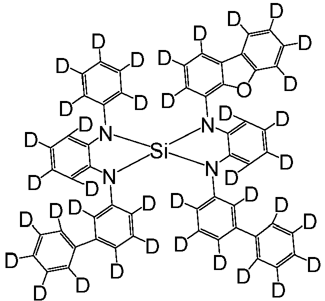 |
| 39 | 40 |
| 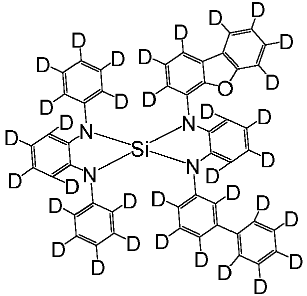 | 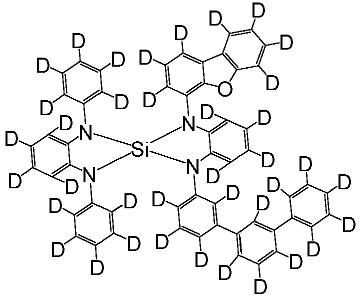 |
| 41 | 42 |
| 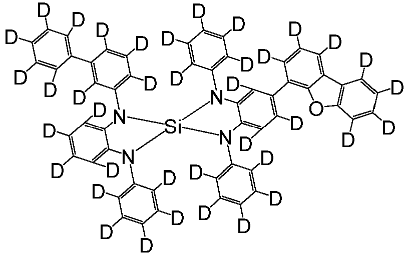 | 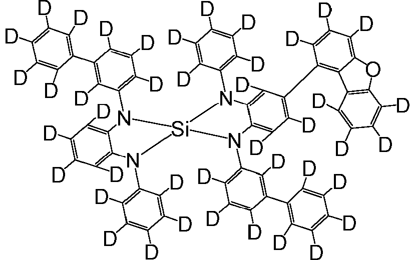 |
| 43 | 44 |
| 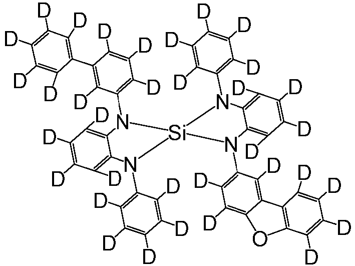 | 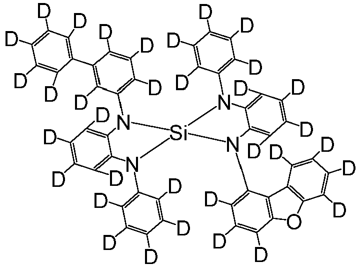 |
| 45 | 46 |
| 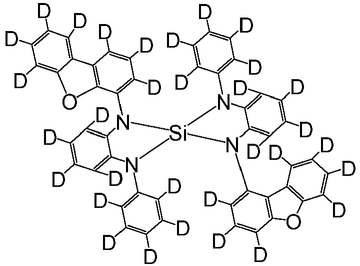 | 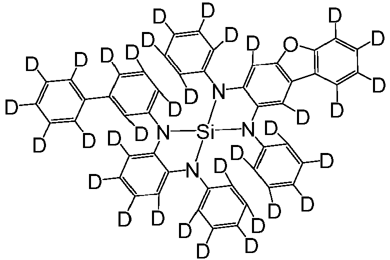 |
| 47 | 48 |
| 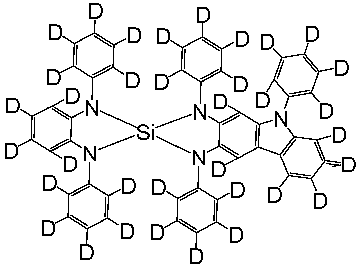 | 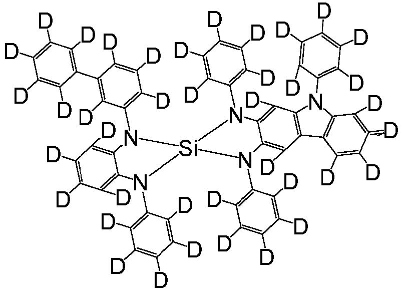 |
| 49 | 50 |
| 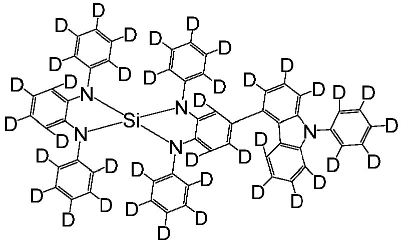 | 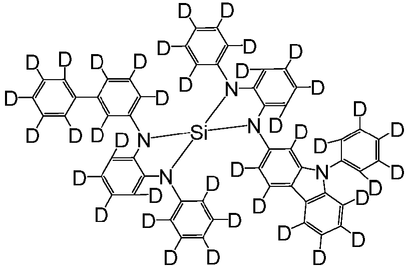 |
| 51 | 52 |
| 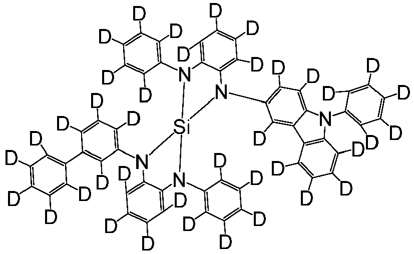 | 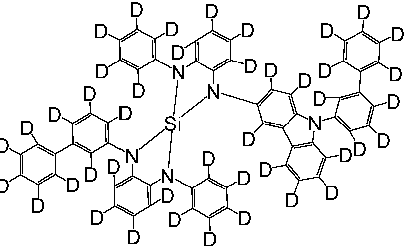 |
| 53 | 54 |
| 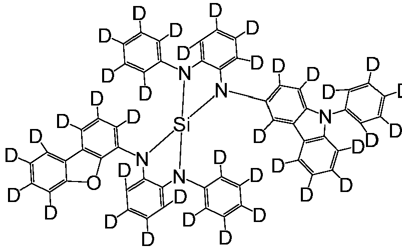 | 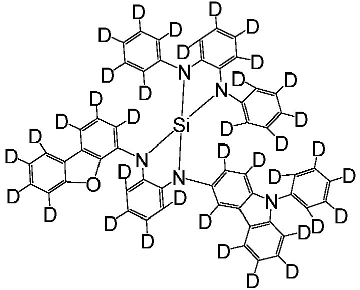 |
| 55 | 56 |
| 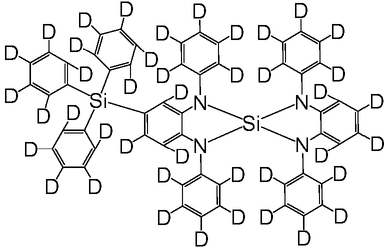 | 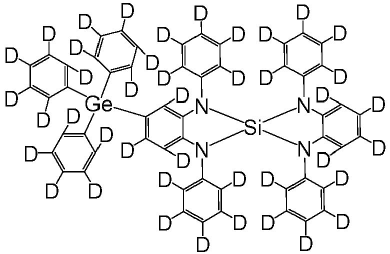 |
| 57 | 58 |
| 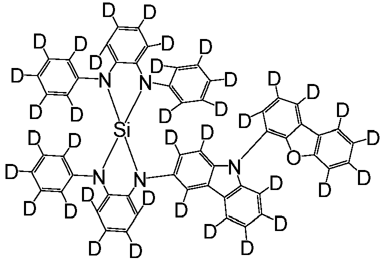 | 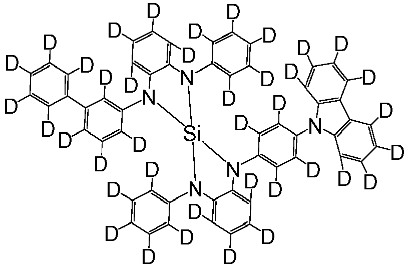 |
| 59 | 60 |
| 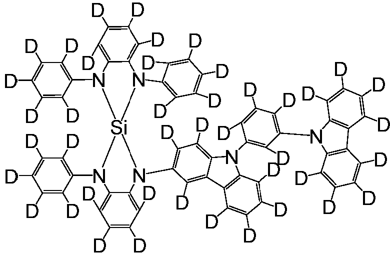 | 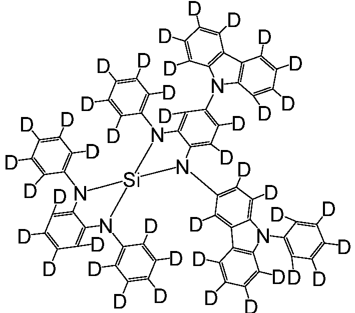 |
| 61 | 62 |
| 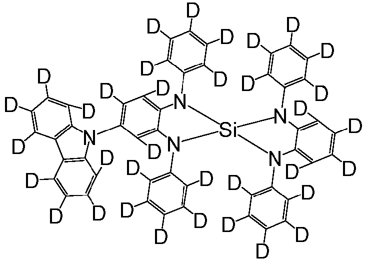 | 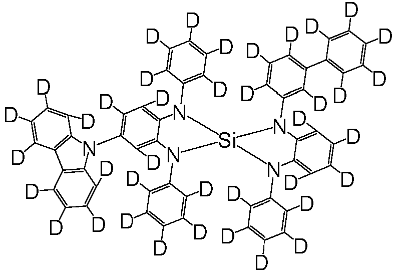 |
| 63 | 64 |
| 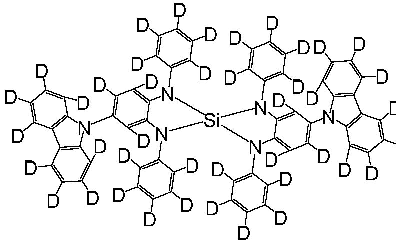 | 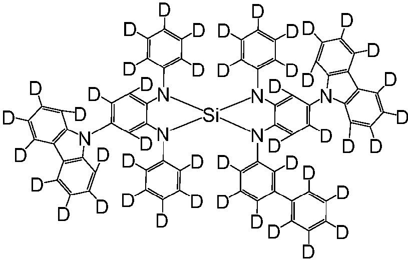 |
| 65 | 66 |
| 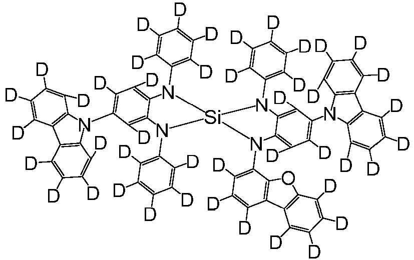 | 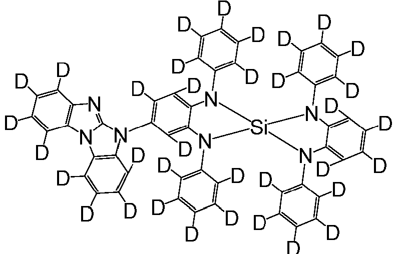 |
| 67 | 68 |
| 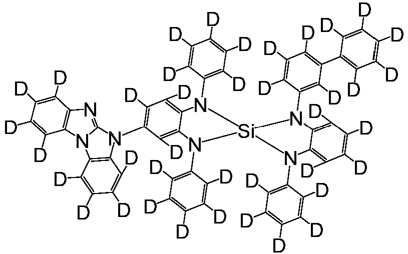 | 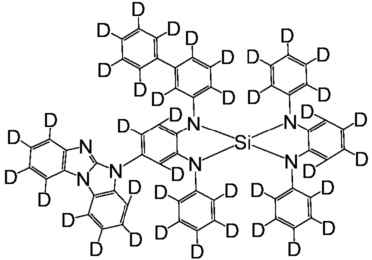 |
| 69 | 70 |
| 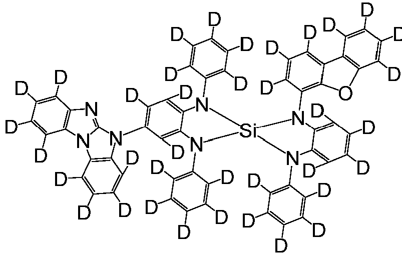 | I 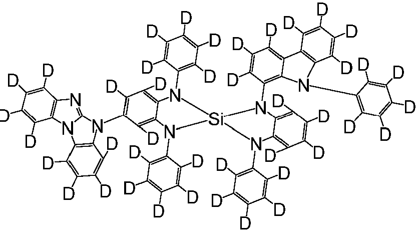 |
| 71 | 72 |
| 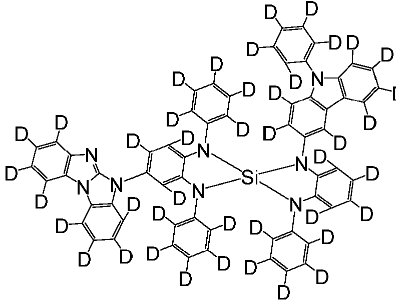 | 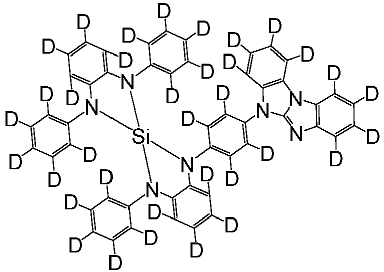 |
| 73 | 74 |
| 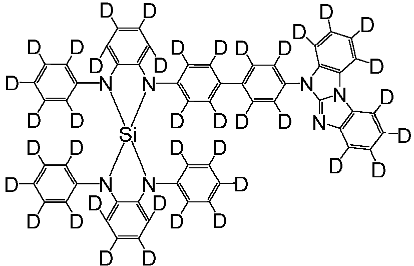 | 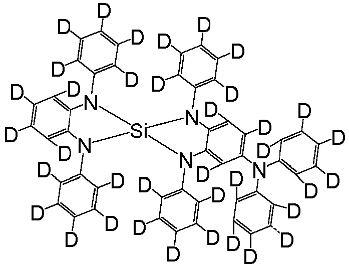 |
| 75 | 76 |
| 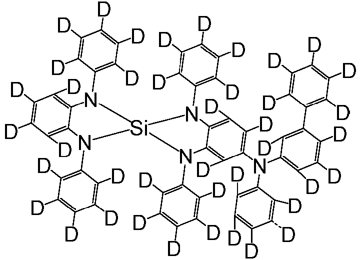 | 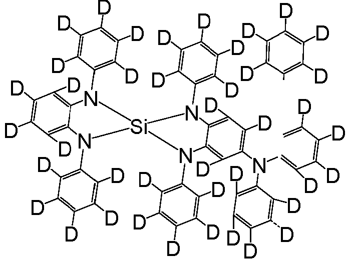 |
| 77 | 78 |
| 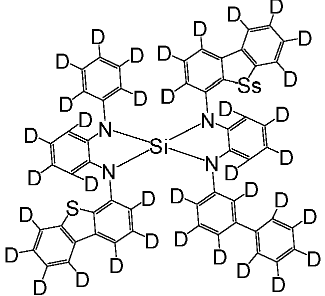 | 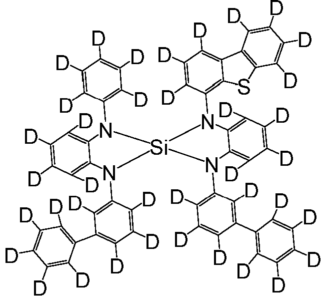 |
| 79 | 80 |
| 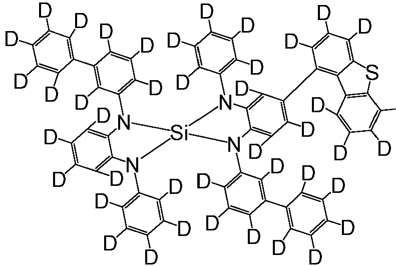 | 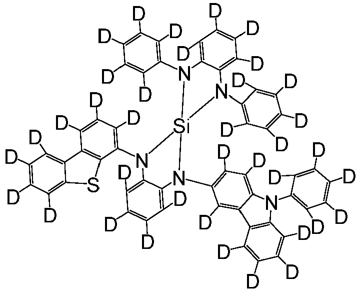 |
| 81 | 82 |
| 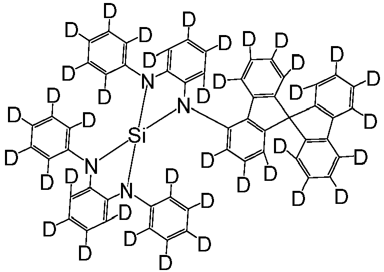 | 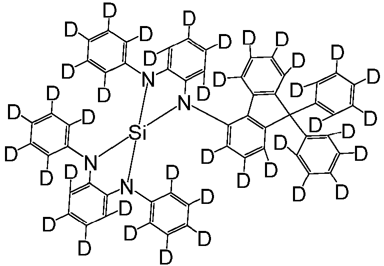 |
| 83 | 84 |
| 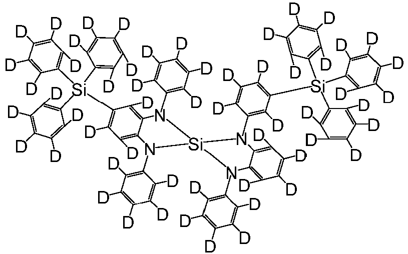 | 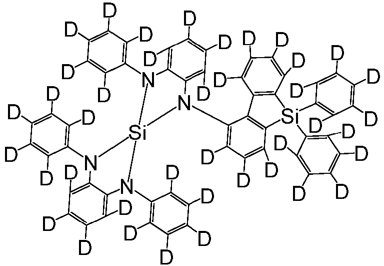 |
| 84 | 86 |
| 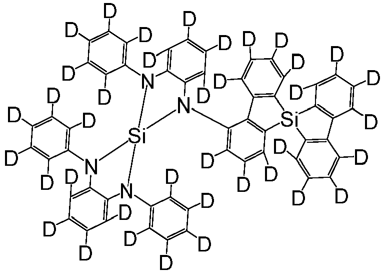 | 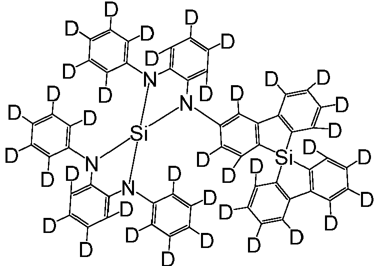 |
| 87 | 88 |
| 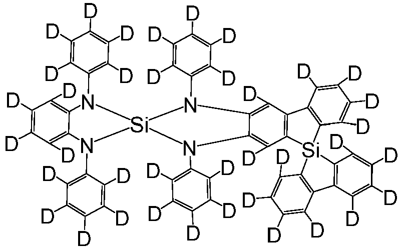 | 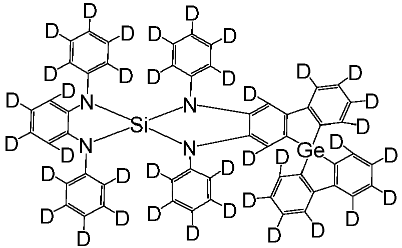 |
| 89 | 90 |
| 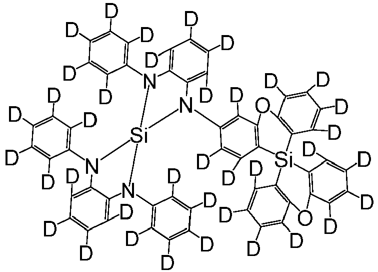 | 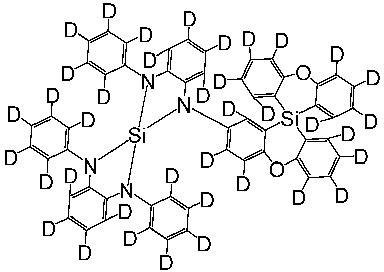 |
| 91 | 92 |
| 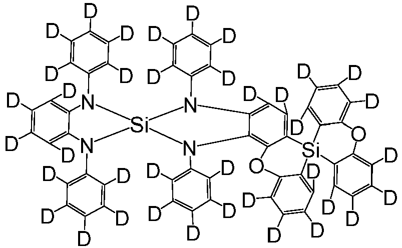 | 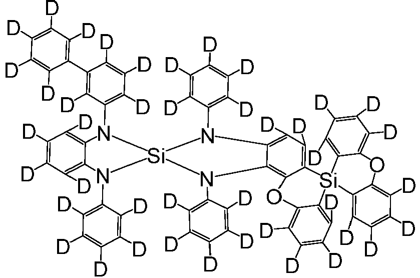 |
| 93 | 94 |

Die Synthese der erfindungsgemäßen Verbindungen (5) kann unter anderem gemäß Schema 1 erfolgen. Ausgehend von teil- oder volldeuterierten 1,2-Diamino-Aromaten bzw. -Heteroaromaten (1) führen zwei konsekutive mono-N-Arylierungen mit den teil- oder volldeuterierten Aromaten/Heteroaromaten Ar¹-Hal bzw. Ar²-Hal zu den teil- oder volldeuterierten 1,2-Bis(aryl-/heteroarylamino)-Aromaten bzw. -Heteroaromaten (2). Die Kupplungen können nach dem Fachmann bekannten Methoden, z. B. der Buchwald-Hartwig oder Ullmann-Kupplung ausgehend von Ar-Hal mit Hal = Cl, Br, I in Gegenwart einer Base (z. B. Alkyllithium, wie n-BuLi oder n-HexLi, einem Alkalimetallalkoxidm wie NaO-t-Bu oder KO-t-Bu, einer anorganischen Base wie Alkaliphosphaten oder -carbonaten), einer Palladiumquelle (z. B. Pd₂dba₃, Pd(OAc)₂ etc.) in Kombination mit einem bevorzugt elektronenreichen Phosphin (z. B. DPPF, BiNap, P(t-Bu)₃, S-Phos, X-Phos, AmPhos, etc.) oder einer Kupferquelle (z. B. Cu, CuCl, Cul, CuOTf, etc.) in Kombination mit einem Amin (z. B. Pyridin, Bipyridin, Phenanthrolin, Glycin, DACH, etc.) in wasserfreien Lösungsmitteln (z. B. Toluol, Xylol, THF, Dioxan, DMF, DMAc, NMP, DMSO, etc.) erfolgen. Daneben kann die die Kupplung via einer SN₂Ar Reaktion mit Ar-Hal mit Hal = F, Cl in Gegenwart einer Base (z. B. Alkyllithium, wie n-BuLi oder n-HexLi, einem Alkalimetallalkoxid, wie NaO-t-Bu oder KO-t-Bu, einer anorganischen Base, wie Alkaliphosphaten oder -carbonaten) in einem dipolar-aprotischen Lösungsmittel (DMF, DMAc, NMP, DMSO, Sulfolan, etc.) erfolgen. Sind die einzuführenden Reste Ar¹ und Ar² identisch, kann die Kupplung nach den o. g. Methoden in einem Schritt erfolgen. Die teil-oder volldeuterierten Synthone sind kommerziell erhältlich oder können aus den nicht-deuterierten Vorstufen durch H-D-Austauschreaktion nach dem Fachmann bekannten Verfahren, beispielsweise wie in WO 2023/117837 beschrieben, dargestellt werden. Alternativ kann das Diamin (2) auch zunächst aus nicht-deuterierten Bausteinen aufgebaut und dann durch H-D-Austauschreaktion, beispielsweise wie in WO 2023/117837 beschrieben, deuteriert werden. In einem zweiten Schritt wird das teil- oder volldeuterierte sekundäre Diamin (2) mittels einer Base (Alkyllithium- oder Aryllithium-Verbindungen, wie n-BuLi, t-BuLi, PhLi, etc. oder Lithiumamiden, wie Lithium-di-iso-propylamid (LDA), Lithium-2,2',6,6'-tetramethylpiperidid (LiHMP), Lithium-hexamethyldisilazid (LiHMDS), etc.) in einem Lösungsmittel (z. B. Diethylether, Di-n-butylether, Methyl-t-butylether, Tetrahydrofuran (THF), Dioxan, Toluol, etc.) bis-lithiiert und dann mit einem Siliciumhalogenid, bevorzugt Siliciumtetrachlorid (SiCl₄), zum Intermediat (3) umgesetzt. Die Reaktion verläuft bei einer Eduktstöchiometrie von (2) zu SiCl₄ von 1:1 selektiv zum Intermediat (3), da dieses eine gegenüber einer weiteren Umsetzung zu (5) stark erniedrigte Reaktivität aufweist. In einem dritten Schritt wird das Intermediat (3) mit dem bis-lithiierten Diamin (4) zum erfindungsgemäßen Produkt (5) umgesetzt. Sind die einzuführenden Diamine (2) identisch, d. h. Ar¹ = Ar³ und Ar² = Ar⁴, kann die Kupplung bei einer Eduktstöchiometrie von (2) zu SiCl₄ von 2:1 nach der o. g. Methode in einem Schritt erfolgen.

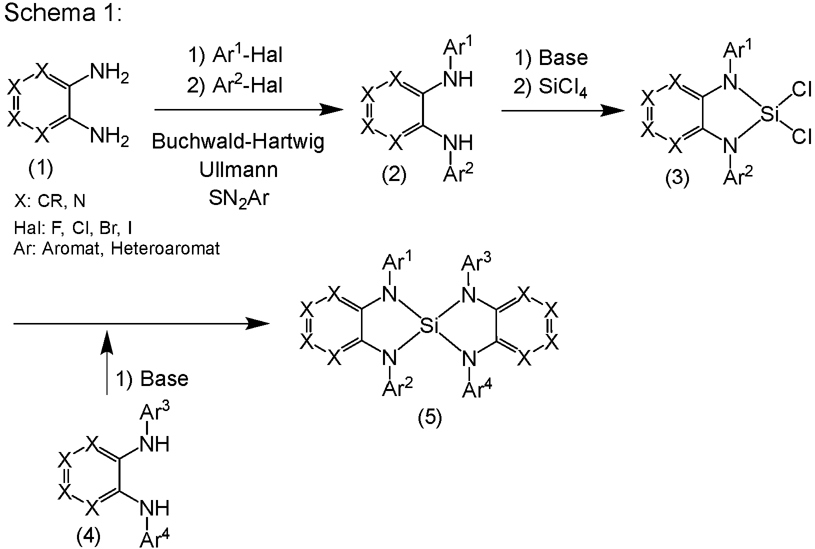

Entsprechende Deuterierungsmethoden sind dem Fachmann bekannt und sind beispielsweise in KR 2016041014, WO 2017/122988, KR 2020052820, KR 101978651 B1, WO 2018/110887, Bulletin of the Chemical Society of Japan, 2021, 94(2), 600-605 oder in Asian Journal of Organic Chemistry, 2017, 6(8), 1063-1071 beschrieben.

Ein geeignetes Verfahren zur Deuterierung einer Verbindung durch Austausch eines oder mehrerer H-Atome gegen D-Atome ist eine Behandlung der zu deuterierenden Verbindung in Gegenwart eines Platinkatalysators oder Palladiumkatalysators und einer Deuteriumquelle. Der Begriff "Deuteriumquelle" bedeutet jede Verbindung, die ein oder mehrere D-Atome enthält und diese unter geeigneten Bedingungen freisetzen kann.

Der Palladium- bzw. Platinkatalysator ist vorzugsweise trockenes Palladium bzw. Platin auf Kohle, vorzugsweise 5% trockenes Palladium bzw. Platin auf Kohle. Geeignete Deuteriumquellen sind D₂O, Benzol-d6, Chloroform-d, Acetonitril-d3, Aceton-d6, Essigsäure-d4, Methanol-d4 oder Toluol-d8. Eine bevorzugte Deuteriumquelle ist D₂O. Eine besonders bevorzugte Deuteriumquelle ist D₂O in Kombination mit einem Lösemittel wie Cyclohexan oder Decalin. Weitere bevorzugte Deuteriumquellen sind Benzol-d6 und Toluol-d8 in Kombination mit einer starken Säure, beispielsweise Trifluormethansulfonsäure. Die Reaktion wird vorzugsweise unter Erhitzen durchgeführt, besonders bevorzugt unter Erhitzen auf Temperaturen zwischen 100 °C und 200 °C. Weiterhin kann die Reaktion unter Normaldruck oder unter erhöhtem Druck durchgeführt werden. Wenn die Reaktion in Decalin als Lösemittel durchgeführt wird, wird sie bevorzugt unter Normaldruck durchgeführt, während sie in Cyclohexan als Lösemittel bevorzugt unter erhöhtem Druck durchgeführt wird.

Ein weiterer Gegenstand der vorliegenden Erfindung ist ein Verfahren zur Herstellung der erfindungsgemäßen Verbindungen, gekennzeichnet durch die folgenden Schritte:
(A) Bereitstellung eines teilweise oder vollständig deuterierten Benzolderivats oder entsprechenden heteroaromatischen Derivats, welches in ortho-Position zueinander mit einer Gruppe -NHAr¹ und einer Gruppe -NHAr² substituiert ist und gegebenenfalls Bereitstellung eines teilweise oder vollständig deuterierten Benzolderivats oder entsprechenden heteroaromatischen Derivats, welches in ortho-Position zueinander mit einer Gruppe -NHAr³ und einer Gruppe -NHAr⁴ substituiert ist; und
(B) Umsetzung von SiHal₄, insbesondere SiCl₄, mit dem teilweise oder vollständig deuterierten Benzolderivat oder entsprechenden heteroaromatischen Derivat, welches in ortho-Position zueinander mit einer Gruppe -NHAr¹ und einer Gruppe -NHAr² substituiert ist, gegebenenfalls gefolgt von Umsetzung mit dem teilweise oder vollständig deuterierten Benzolderivat oder entsprechenden heteroaromatischen Derivat, welches in ortho-Position zueinander mit einer Gruppe -NHAr³ und einer Gruppe -NHAr⁴ substituiert ist.

Ein weiterer Gegenstand der vorliegenden Erfindung ist ein Oligomer, Polymer oder Dendrimer umfassend eine oder mehrere Verbindungen gemäß Formel (1), wobei dann statt einem oder mehreren Resten R ein Bindung zur Polymerkette vorliegt.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete Lösemittel sind dem Fachmann bekannt. Die Herstellung solcher Lösungen ist dem Fachmann bekannt und ist beispielsweise beschrieben in WO 2002/072714, WO 2003/019694 und der darin zitierten Literatur.

Ein weiterer Gegenstand der vorliegenden Erfindung ist daher eine Formulierung, insbesondere eine Lösung, Dispersion oder Emulsion, umfassend mindestens eine erfindungsgemäße Verbindung und mindestens eine weitere Verbindung. Die weitere Verbindung kann beispielsweise ein Lösemittel sein und/oder eine weitere organische oder anorganische Verbindung, die ebenfalls in der elektronischen Vorrichtung eingesetzt wird, beispielsweise eine emittierende Verbindung und/oder ein Matrixmaterial.

Die erfindungsgemäßen Verbindungen eignen sich für die Verwendung in einer elektronischen Vorrichtung, insbesondere in einer organischen Elektrolumineszenzvorrichtung (OLED). Abhängig von der Substitution können die Verbindungen in unterschiedlichen Funktionen und Schichten verwendet werden. Ein weiterer Gegenstand der vorliegenden Erfindung ist daher die Verwendung einer erfindungsgemäßen Verbindung in einer elektronischen Vorrichtung.

Ein nochmals weiterer Gegenstand der vorliegenden Erfindung ist eine elektronische Vorrichtung enthaltend mindestens eine erfindungsgemäße Verbindung.

Eine elektronische Vorrichtung im Sinne der vorliegenden Erfindung ist eine Vorrichtung, welche mindestens eine Schicht enthält, die mindestens eine organische Verbindung enthält. Das Bauteil kann dabei auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), farbstoffsensibilisierten organischen Solarzellen (DSSCs), organischen optischen Detektoren, organischen Photorezeptoren, organische Photodioden (OPD), organischen Feld-Quench-Devices (O-FQDs), lichtemittierenden elektrochemischen Zellen (LECs), organischen Laserdioden (O-Laser) und "organic plasmon emitting devices".

Die Vorrichtung ist besonders bevorzugt eine organische Elektrolumineszenzvorrichtung (OLED) umfassend Kathode, Anode und mindestens eine emittierende Schicht, wobei mindestens eine Schicht mindestens eine erfindungsgemäße Verbindung umfasst. Außer diesen Schichten kann die organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers) und/oder organische oder anorganische p/n Übergänge. Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende oder mehrere Schichten enthalten. Wenn mehrere Emissionsschichten vorhanden sind, weisen diese bevorzugt insgesamt mehrere Emissionsmaxima zwischen 380 nm und 750 nm auf, sodass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen. Es kann sich bei der erfindungsgemäßen organischen Elektrolumineszenzvorrichtung auch um eine Tandem-OLED handeln, insbesondere für weiß emittierende OLEDs.

Bevorzugt wird die Verbindung gemäß Formel (1) in einer organischen Elektrolumineszenzvorrichtung verwendet, welche einen oder mehrere phosphoreszierende Emitter umfasst, wobei die erfindungsgemäße Verbindung, je nach genauer Struktur, in unterschiedlichen Schichten eingesetzt werden kann.

In einer bevorzugten Ausführungsform der Erfindung werden die Verbindungen der Formel (1) als lochtransportierendes Material verwendet. In diesem Fall ist die erfindungsgemäße Verbindung vorzugsweise in einer Lochtransportschicht oder einer Excitonenblockierschicht oder einem lochleitenden Hostmaterial enthalten.

Eine Lochtransportschicht im Sinne der vorliegenden Anmeldung ist eine Schicht mit lochtransportierender Funktion zwischen der Anode und der emittierenden Schicht. Eine Exzitonenblockierschicht im Sinne der vorliegenden Anmeldung ist eine Schicht, die auf Anodenseite direkt an eine emittierende Schicht angrenzt. Es handelt sich dabei um eine bestimmte Ausführungsform einer Lochtransportschicht.

Wird die Verbindung der Formel (1) als Lochtransportmaterial in einer Lochtransportschicht oder einer Exzitonenblockierschicht verwendet, so kann die Verbindung als reines Material, d.h. in einem Anteil von 100 %, in der Schicht eingesetzt werden, oder sie kann in Kombination mit einer oder mehreren weiteren Verbindungen verwendet werden.

In einer weiteren bevorzugten Ausführungsform der Erfindung wird die erfindungsgemäße Verbindung als Matrixmaterial in einer emittierenden Schicht eingesetzt, wobei die Emissionsschicht phosphoreszent, hyperphosphoreszent oder fluoreszent sein kann.

Bei einer hyperphosphoreszenten Emssionsschicht handelt es sich um eine Schicht, welche üblicherweise ein oder mehrere Matrixmaterialien enthalten, außerdem einen oder mehrere phosphoreszenten Verbindungen, welche als Sensitizer eingesetzt werden und deren Lumineszenz nicht oder nicht in wesentlichem Maße beobachtet wird, und einen oder mehrere fluoreszente Emitter, welche für die Emission der OLED verantwortlich sind.

Der Ausdruck "phosphoreszierende Verbindung" bzw. "phosphoreszente Verbindung" (= Triplettemitter) bezeichnet typischerweise Verbindungen, bei denen die Aussendung von Licht durch einen spin-verbotenen Übergang erfolgt, z. B. einen Übergang von einem angeregten Triplett-Zustand oder einem Zustand mit einer höheren Spin-Quantenzahl, z. B. einem Quintett-Zustand. Bevorzugt werden als phosphoreszierende Verbindungen lumineszierende Komplexe mit Übergangsmetallen oder Lanthaniden angesehen, insbesondere wenn sie Kupfer, Molybdän, Wolfram, Rhenium, Ruthenium, Osmium, Rhodium, Iridium, Palladium, Platin, Silber, Gold oder Europium enthalten, insbesondere Verbindungen, die Iridium, Platin oder Kupfer enthalten. Im Rahmen der vorliegenden Erfindung werden alle lumineszierenden Iridium-, Platin- oder Kupferkomplexe als phosphoreszierende emittierende Verbindungen betrachtet. Besonders bevorzugt sind Iridium- oder Platinkomplexe.

Beispiele für phosphoreszierende Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/041769, WO 2019/020538, WO 2018/178001, WO 2019/115423 und WO 2019/158453 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden. Für den Fachmann ist es auch ohne erfinderische Tätigkeit möglich, weitere phosphoreszierende Komplexe in Kombination mit den Verbindungen der Formel (1) in organischen Elektrolumineszenzvorrichtungen zu verwenden. Da die erfindungsgemäßen Verbindungen je nach Substitution auch eine hohe Triplettenergie aufweisen können, ist es insbesondere auch möglich, diese als Matrixmaterial für blau phosphoreszierende Emitter zu verwenden.

Geeignete phosphoreszente Metallkomplexe, die in phosphorezenten OLEDs oder als Sensitizer in hyperphosphoreszenten OLEDs eingesetzt werden können, sind weiterhin unter anderem offenbart in Sungho Nam et al., Adv. Sci. 2021, 2100586, Eungdo Kin et al., Sci. Adv. 2022, 8, 1641. Weitere als Sensitizer geeignete Verbindungen sind offenbart in EP 3435438 A2, insbesondere die Verbindungen 2 und 3 auf Seite 21, in CN 109111487, insbesondere die Verbindungen auf Seite 76 und 77, in US 2020/0140471, insbesondere die Verbindungen auf den Seiten 166 bis 175; in KR 2020108705, insbesondere die Verbindungen auf den Seiten 8 bis 14, in US 2019/0119312, insbesondere die Verbindungen auf den Seiten 114 bis 121, und in US 2020/0411775, insbesondere die Verbindungen auf den Seiten 123 bis 128. Weitere geeignete phosphoreszente Metallkomplexe sind offenbart in in US 2022/0115607, US 2022/0298193, US 2016/0072082 und US 2022/0271236.

Der Anteil des Matrixmaterials in der emittierenden Schicht liegt in diesem Fall zwischen 50.0 und 99.9 Vol.-%, bevorzugt zwischen 80.0 und 99.5 Vol.-%, besonders bevorzugt zwischen 92.0 und 99.5 Vol-%. für fluoreszierende emittierende Schichten und zwischen 85.0 und 97.0 Vol.-% für phosphoreszierende emittierende Schichten.

Entsprechend liegt der Anteil der emittierenden Verbindung zwischen 0.1 und 50.0 Vol.-%, bevorzugt zwischen 0.5 und 20.0 Vol.-%, besonders bevorzugt zwischen 0.5 und 8.0 Vol.-% für fluoreszierende emittierende Schichten und zwischen 3.0 und 15.0 Vol.-% für phosphoreszierende emittierende Schichten.

Eine emittierende Schicht kann auch Systeme umfassen, die eine Vielzahl von Matrixmaterialien (Mischmatrixsysteme) und/oder eine Vielzahl emittierender Verbindungen enthalten. Auch in diesem Fall sind in der Regel die emittierenden Verbindungen diejenigen, die den kleineren Anteil im System haben und die Matrixmaterialien diejenigen, die den größeren Anteil im System haben. In Einzelfällen kann jedoch der Anteil eines einzelnen Matrixmaterials im System geringer sein als der Anteil einer einzelnen emittierenden Verbindung.

Vorzugsweise werden die Verbindungen der Formel (1) als Bestandteil von Mischmatrixsystemen eingesetzt. Die Mischmatrixsysteme bestehen vorzugsweise aus zwei oder drei verschiedenen Matrixmaterialien, besonders bevorzugt aus zwei verschiedenen Matrixmaterialien. Vorzugsweise ist eines der beiden Materialien ein Material mit löchertransportierenden Eigenschaften und das andere Material ist ein Material mit elektronentransportierenden Eigenschaften. Die Verbindung der Formel (1) ist vorzugsweise das Matrixmaterial mit lochtransportierenden Eigenschaften. Die weiteren gemischten Matrixkomponenten können auch andere Funktionen erfüllen. Die beiden unterschiedlichen Matrixmaterialien können in einem Verhältnis von 1:50 bis 1:1, bevorzugt 1:20 bis 1:1, noch bevorzugter 1:10 bis 1:1 und am meisten bevorzugt 1:4 bis 1:1 vorliegen. Bevorzugt werden Mischmatrixsysteme in phosphoreszenten bzw. hyperphosphoreszenten organischen Elektrolumineszenzvorrichtungen eingesetzt. Besonders geeignete Matrixmaterialien, die in Kombination mit den erfindungsgemäßen Verbindungen als Matrixbestandteile eines Mischmatrixsystems verwendet werden können, werden unten genauer ausgeführt.

Beispiele für phosphoreszierende Verbindungen sind nachfolgend aufgeführt.

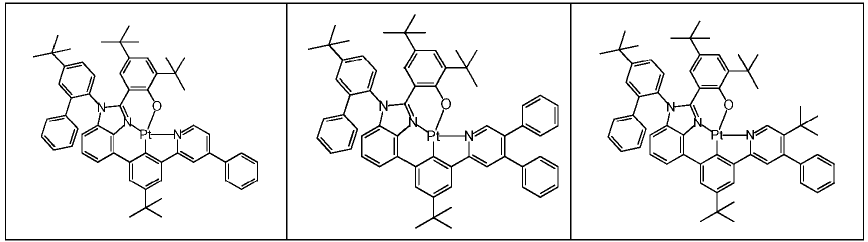

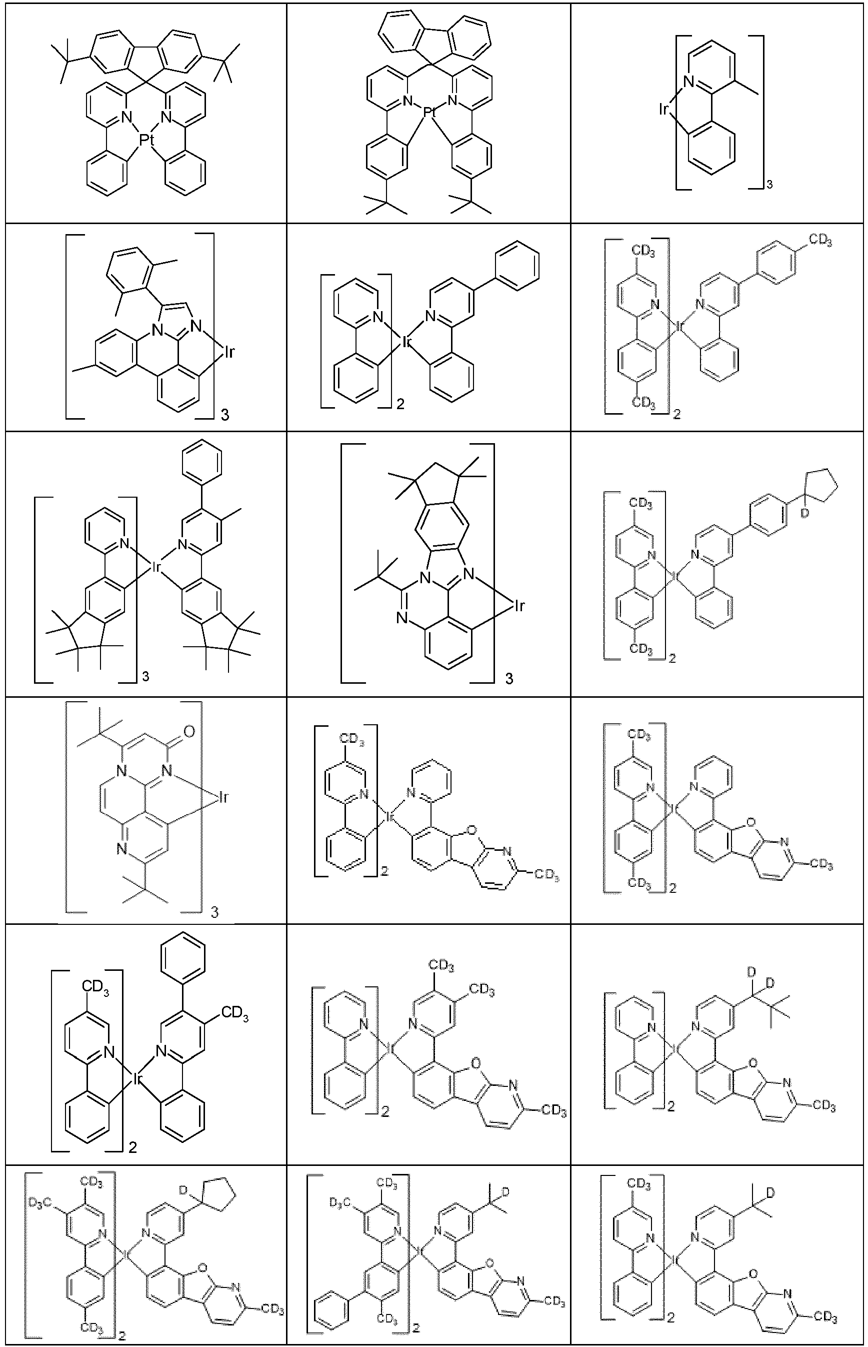

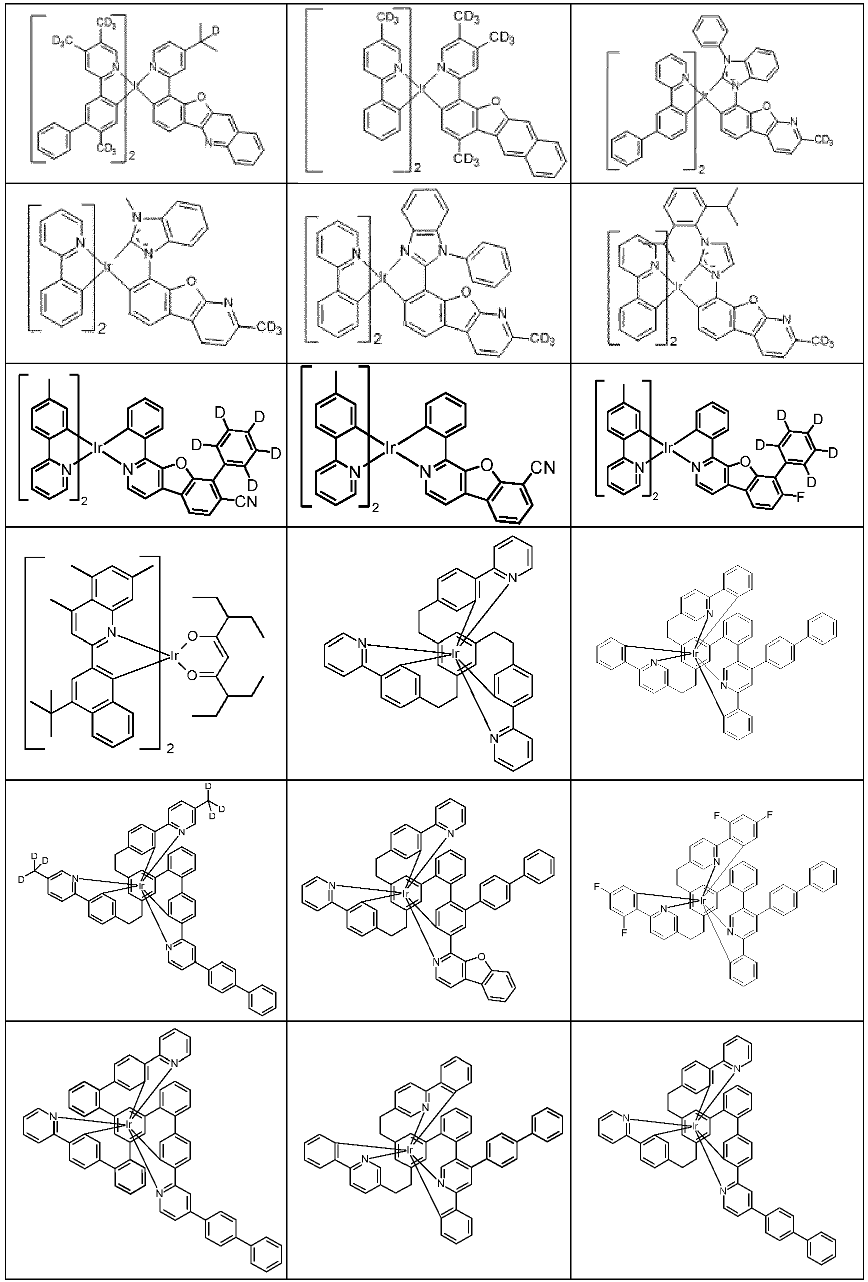

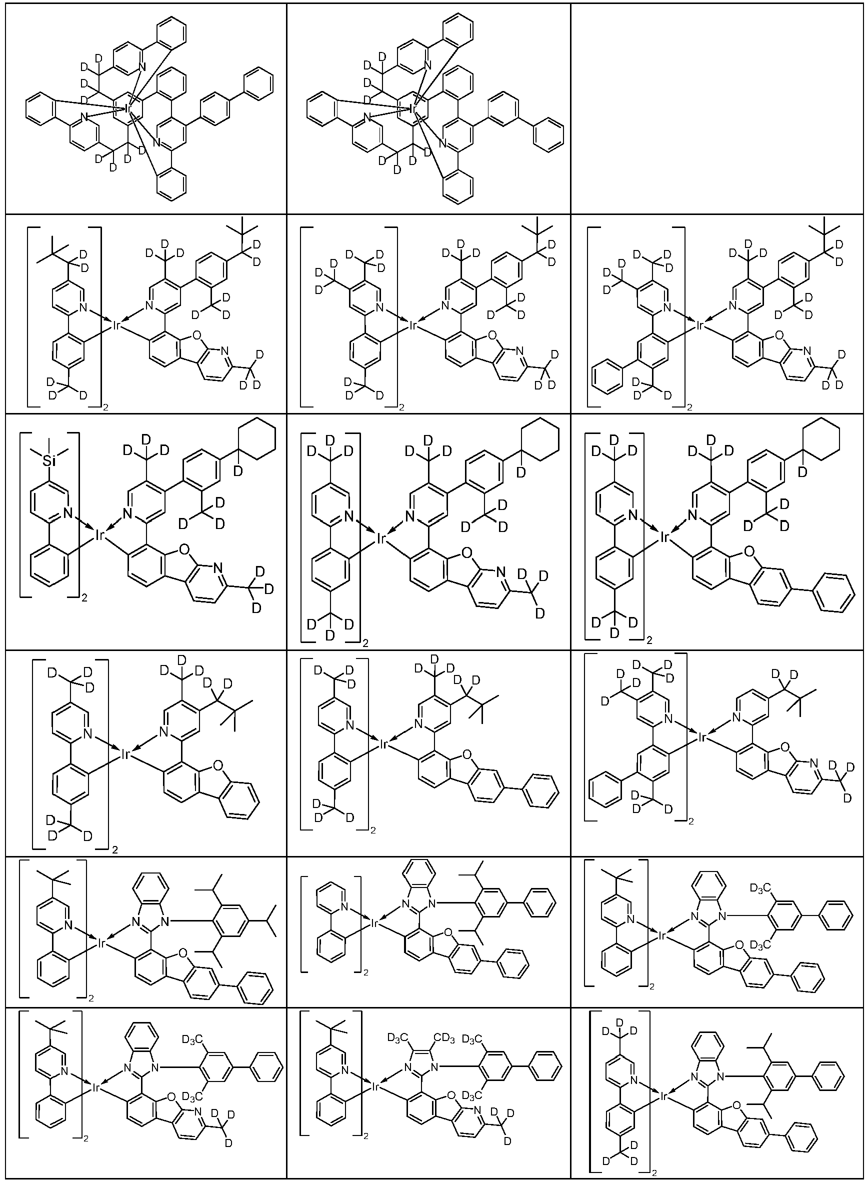

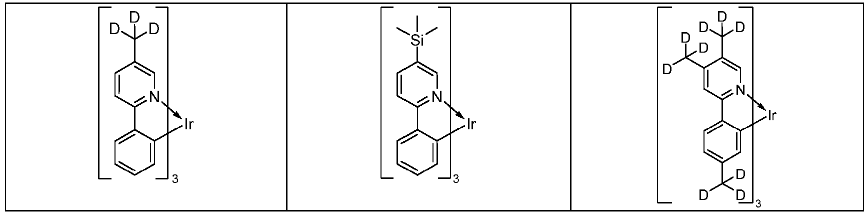

In einer bevorzugten Ausführungsform der Erfindung enthält die erfindungsgemäße organische Elektrolumineszenzvorrichtung mindestens einen blau phosphoreszierenden Metallkomplex, insbesondere mindestens einen blau phosphoreszierenden Platinkomplex. Vorzugsweise hat der mindestens eine blau phosphoreszierende Metallkomplex ein LUMO von -1.8 eV bis -2.2 eV, und ein HOMO von -5.0 eV bis -5.6 eV, wie durch quantenmechanische Berechnungen definiert. Vorzugsweise ist die Energie des niedrigsten Triplettzustands T₁ des mindestens einen blau phosphoreszierenden Metallkomplexes >2.55 eV, besonders bevorzugt >2.65 eV, ganz besonders bevorzugt >2.75 eV, wie durch quantenmechanische Berechnungen definiert.

Die Energieniveaus von Molekülorbitalen (höchstes besetztes Molekülorbital HOMO, niedrigstes unbesetztes Molekülorbital LUMO, niedrigster Triplettzustands T₁, niedrigster angeregter Singulettzustands S₁) werden über quantenmechanische Rechnungen bestimmt. In allen quantenchemischen Berechnungen wird das Programmpaket Gaussian16 (Rev. B.01) verwendet. Der neutrale Singulettgrundzustand wird auf dem B3LYP/6-31 G(d)-Niveau optimiert. HOMO- und LUMO-Werte werden auf dem B3LYP/6-31 G(d)-Niveau für die mit B3LYP/6-31 G(d) optimierte Grundzustandsenergie bestimmt. Daraufhin werden TD-DFT-Singulett- und Triplettanregungen (vertikale Anregungen) mit der gleichen Methode (B3LYP/6-31G(d)) und der optimierten Grundzustandsgeometrie berechnet. Die Standardeinstellungen für SCF- und Gradientenkonvergenz werden verwendet. Die aus der quantenchemischen Rechnung stammenden HOMO- und LUMO-Werte in eV werden zusätzlich mit folgenden Faktoren skaliert: $HOMO _ corr = 0.90603 * HOMO \left(in eV\right) - 0.84836$ $LUMO _ corr = 0.99687 * LUMO \left(in eV\right) - 0.72445$

Diese Werte sind im Sinne dieser Anmeldung als HOMO- bzw. LUMO-Energieniveaus der Materialien anzusehen.

Der niedrigste Triplettzustand T₁ ist definiert als die Energie des Triplettzustands mit der niedrigsten Energie, der sich aus der beschriebenen quantenchemischen Rechnung ergibt. Der niedrigste angeregte Singulettzustand S₁ ist definiert als die Energie des angeregten Singulettzustands mit der niedrigsten Energie, der sich aus der beschriebenen quantenchemischen Rechnung ergibt.

Geeignete Platinkomplexe, die sich als blau phosphoreszente Emitter oder als Sensitizer für hyperphosphoreszente OLEDs eignen, sind in US 2020/0140471, US 2020/0216481, US 2021/0284672, US 2022/0271236, US 2022/0399517, US 2023/0157041, US 2023/0147748 und US 2023/0065887 offenbart.

Als blau phosphoreszierende Metallkomplexe eignen sich die Verbindungen der Formel (Pt-1) gemäß nachstehender Definition sehr gut: 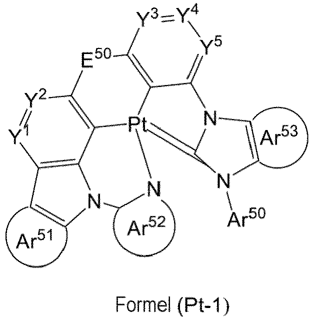 wobei:
- Y¹, Y², Y³, Y⁴, Y⁵: bei jedem Auftreten gleich oder verschieden für eine Gruppe CR^{Y} oder N stehen; oder Y¹-Y² und/oder Y³-Y⁴ oder Y⁴-Y⁵ einen kondensierten Aryl- oder Heteroarylring mit 5 bis 18 aromatischen Ringatomen bilden können, der jeweils auch durch einen oder mehrere Reste R substituiert sein kann;
- E⁵⁰: bei jedem Auftreten gleich oder verschieden für C(R^{C0})₂, NR^{N0}, O oder S steht;
- Ar⁵⁰: bei jedem Auftreten gleich oder verschieden ein aromatisches oder heteroaromatisches Ringsystem mit 5 bis 40 aromatischen Ringatomen, das jeweils auch durch einen oder mehrere Reste R substituiert sein kann, ist;
- Ar⁵¹, Ar⁵², Ar⁵³: gleich oder verschieden für einen kondensierten Aryl- oder Heteroarylring mit 5 bis 18 aromatischen Ringatomen, der jeweils auch durch einen oder mehrere Reste R substituiert sein kann, stehen;
- R^{Y}: bei jedem Auftreten gleich oder verschieden für einen Rest ausgewählt aus H, D, F, Cl, Br, I, CHO, CN, C(=O)R, P(=O)(R)₂, S(=O)R, S(=O)₂Ar, N(R)₂, NO₂, Si(R)₃, B(OR)₂, OSO₂R, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, die jeweils durch einen oder mehrere Reste R substituiert sein können, wobei jeweils eine oder mehrere nicht benachbarte CH₂-Gruppen durch RC=CR, C=C, Si(R)₂, Ge(R)₂, Sn(R)₂, C=O, C=S, C=Se, P(=O)(R), SO, SO₂, O, S oder CONR ersetzt sein können und wobei ein oder mehrere H-Atome durch D, F, Cl, Br, I, CN oder NO₂ ersetzt sein können, einem aromatischen oder heteroaromatischen Ringsystem mit 5 bis 40 aromatischen Ringatomen, das jeweils durch einen oder mehrere Reste R substituiert sein kann, und einer Aryloxygruppe mit 5 bis 40 aromatischen Ringatomen, die durch einen oder mehrere Reste R substituiert sein kann, steht, wobei zwei Reste R^{Y} zusammen ein aliphatisches, aromatisches oder heteroaromatisches Ringsystem, das durch einen oder mehrere Reste R' substituiert sein kann, bilden können;
- R^{C0}: bei jedem Auftreten gleich oder verschieden für einen Rest ausgewählt aus H, D, einer geradkettigen Alkylgruppe mit 1 bis 40 C-Atomen, die durch einen oder mehrere Reste R substituiert sein kann, einer Aryl- oder Heteroarylgruppe mit 6 bis 18 aromatischen Ringatomen, die jeweils durch einen oder mehrere Reste R substituiert sein kann, steht, wobei zwei Reste R^{C} zusammen ein aliphatisches, aromatisches oder heteroaromatisches Ringsystem, das durch einen oder mehrere Reste R substituiert ist, bilden können;
- R^{N0}: bei jedem Auftreten gleich oder verschieden für einen Rest ausgewählt aus H, D, F, einer geradkettigen Alkylgruppe mit 1 bis 40 C-Atomen oder einer verzweigten oder cyclischen Alkylgruppe mit 3 bis 40 C-Atomen, die jeweils durch einen oder mehrere Reste R substituiert ist und wobei ein oder mehrere H-Atome durch D, F oder CN ersetzt sein können, einem aromatischen oder heteroaromatischem Ringsystem mit 5 bis 40 aromatischen Ringatomen, das jeweils durch einen oder mehrere Reste R substituiert sein kann, steht;
und R die gleiche Bedeutung wie oben hat.

Vorzugsweise ist Ar⁵⁰ bei jedem Auftreten gleich oder verschieden ein aromatisches oder heteroaromatisches Ringsystem mit 5 bis 30, besonders bevorzugt 6 bis 24 und ganz besonders bevorzugt 6 bis 18 aromatischen Ringatomen, das jeweils auch durch einen oder mehrere Reste R substituiert sein kann.

Vorzugsweise stehen Ar⁵¹, Ar⁵², Ar⁵³ gleich oder verschieden für einen kondensierten Aryl- oder Heteroarylring mit 6 aromatischen Ringatomen, der jeweils auch durch einen oder mehrere Reste R substituiert sein kann.

Vorzugsweise steht R^{Y} bei jedem Auftreten gleich oder verschieden für H, D, F, eine geradkettige Alkyl-, Alkoxy- oder Thioalkylgruppe mit 1 bis 40, vorzugsweise 1 bis 20 und weiter bevorzugt 1 bis 10 C-Atomen oder eine verzweigte oder cyclische Alkyl-, Alkoxy- oder Thioalkylgruppe mit 3 bis 40, vorzugsweise 3 bis 20 und weiter bevorzugt 3 bis 10 C-Atomen, die jeweils durch einen oder mehrere Reste R substituiert sein kann, wobei jeweils eine oder mehrere nicht benachbarte CH₂-Gruppen durch RC=CR, C=C, O oder S ersetzt sein können und wobei ein oder mehrere H-Atome durch D oder F ersetzt sein können, ein aromatisches oder heteroaromatisches Ringsystem mit 5 bis 30, besonders bevorzugt 5 bis 18 aromatischen Ringatomen, das jeweils durch einen oder mehrere Reste R substituiert sein kann.

Vorzugsweise steht R^{C0} bei jedem Auftreten gleich oder verschieden für einen Rest ausgewählt aus H, D, einer geradkettigen Alkylgruppe mit 1 bis 10, vorzugsweise 1 bis 6 und weiter bevorzugt 1 bis 3 C-Atomen, die durch einen oder mehrere Reste R substituiert sein kann, einer Aryl- oder Heteroarylgruppe mit 6 bis 18 und vorzugsweise 6 bis 12 aromatischen Ringatomen, die jeweils durch einen oder mehrere Reste R substituiert sein kann, wobei zwei Reste R^{C0} zusammen ein aliphatisches, aromatisches oder heteroaromatisches Ringsystem, das durch einen oder mehrere Reste R substituiert ist, bilden können.

Vorzugsweise steht R^{N0} bei jedem Auftreten gleich oder verschieden für einen Rest ausgewählt aus einem aromatischen oder heteroaromatischen Ringsystem mit 5 bis 40, besonders bevorzugt 5 bis 30 und noch weiter bevorzugt 5 bis 18 aromatischen Ringatomen, das jeweils durch einen oder mehrere Reste R substituiert sein kann.

Beispiele für geeignete blau phosphoreszierende Platinkomplexe sind nachstehend abgebildet:

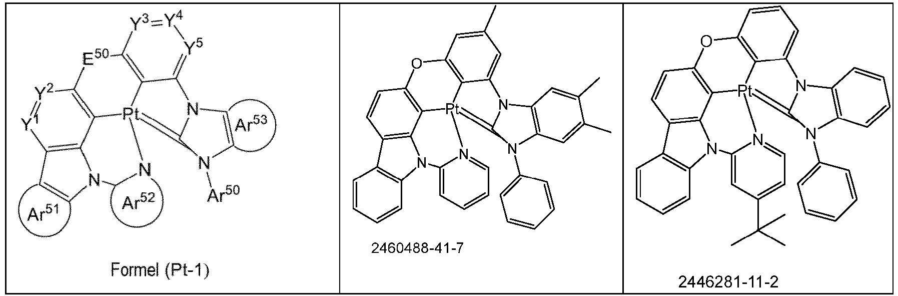

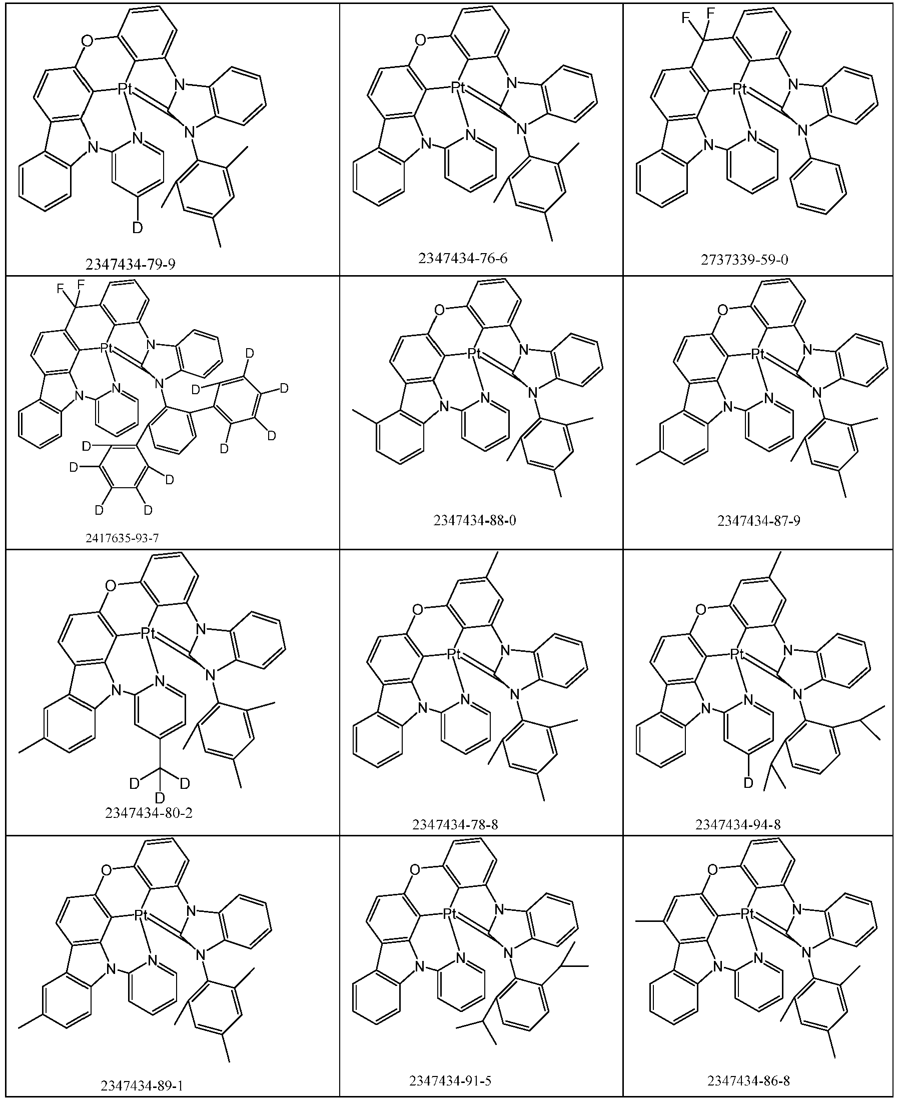

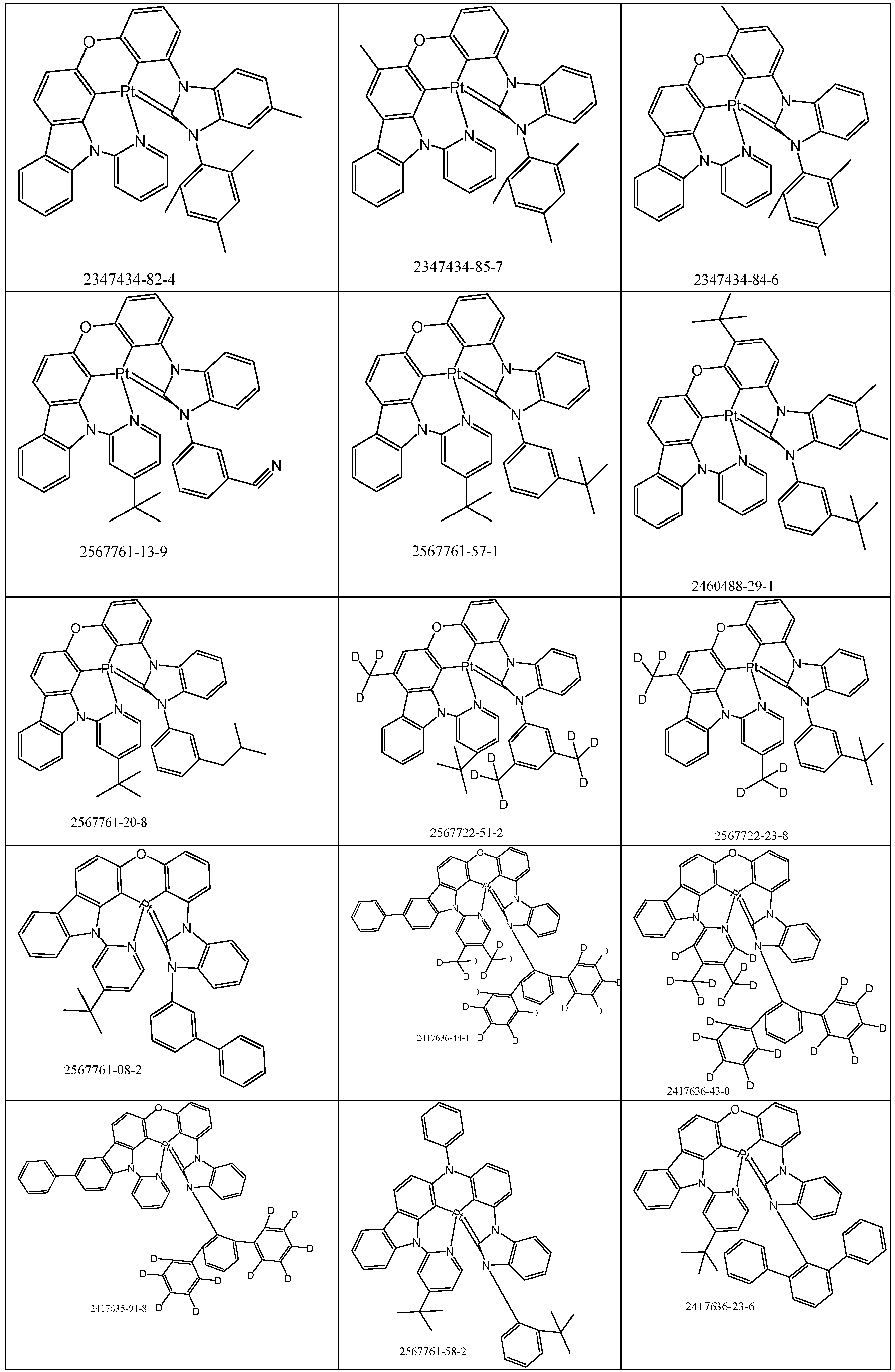

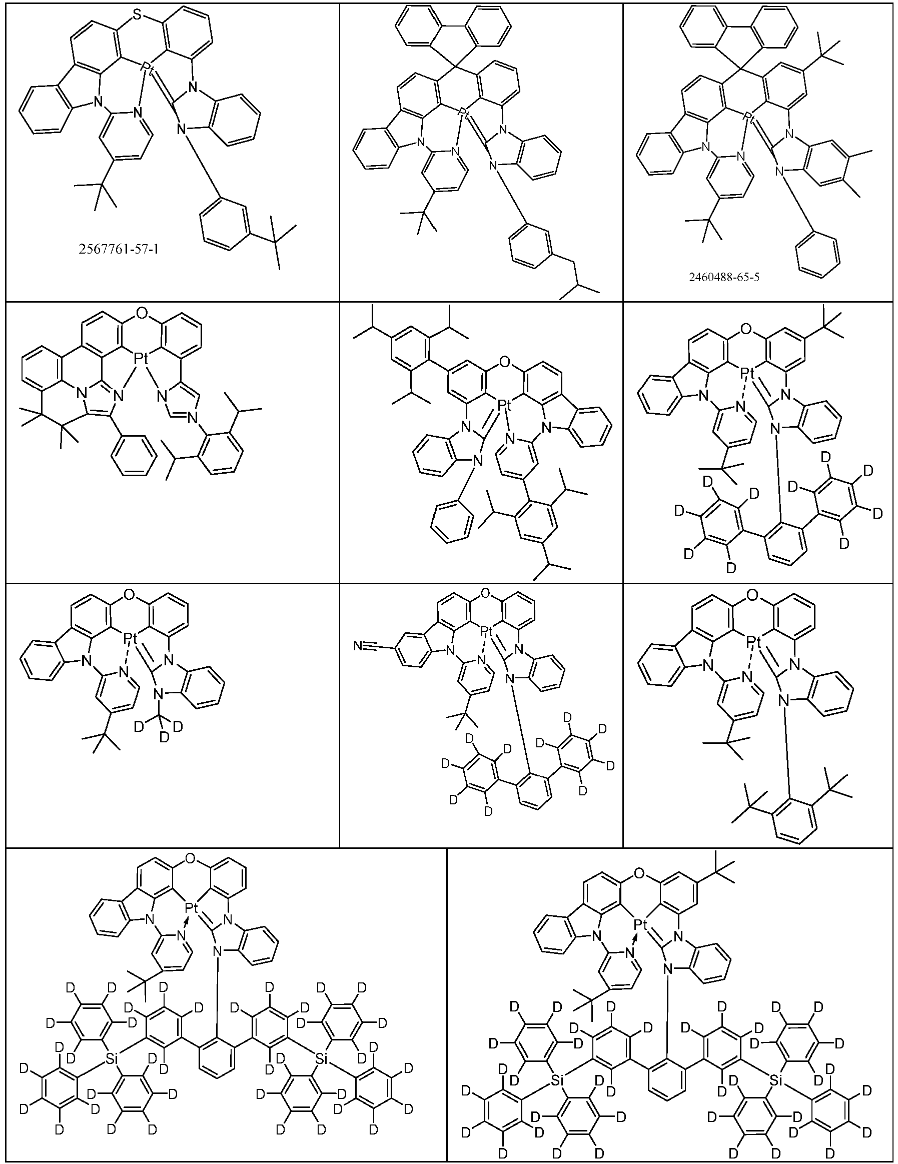

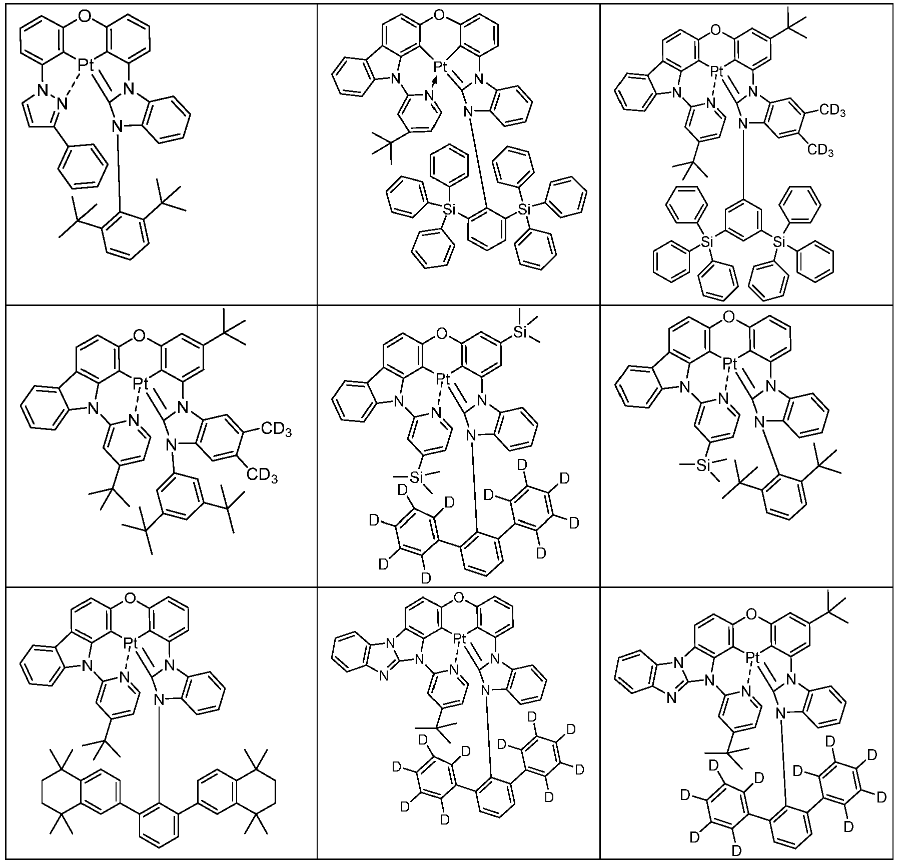

Weitere geeignete blau phosphoreszierende Verbindungen, die als Sensitizer eingesetzt werden können, sind die in der folgenden Tabelle aufgeführten Verbindungen:

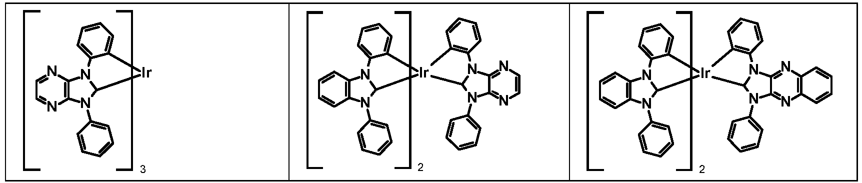

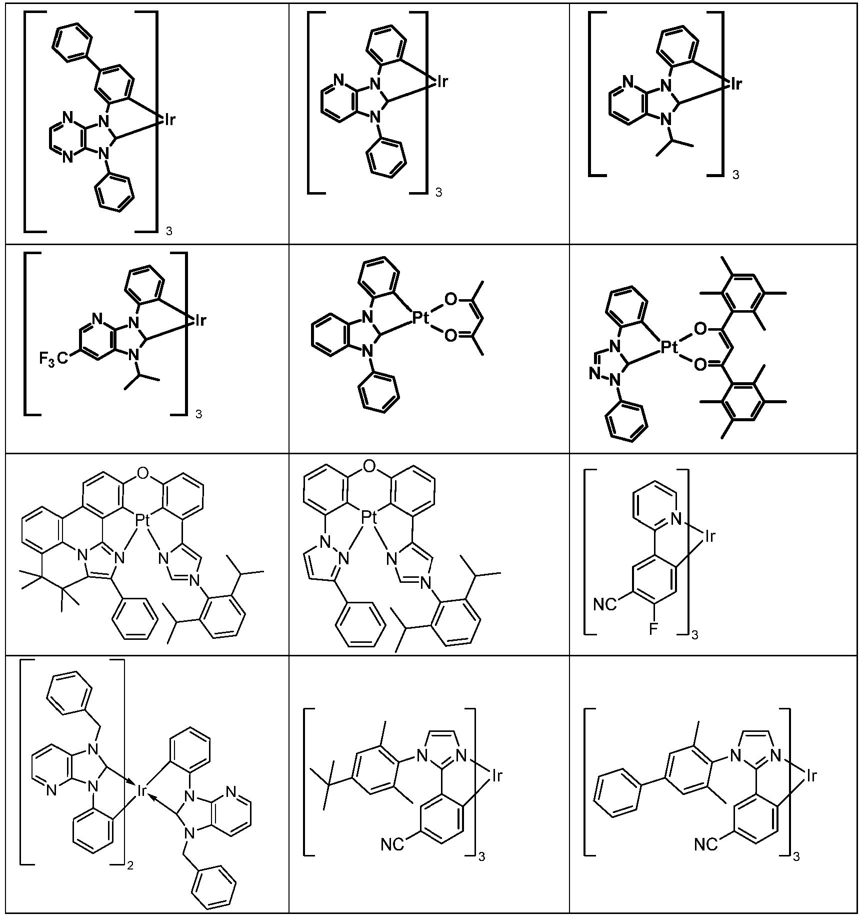

Bevorzugte Matrixmaterialien für phosphoreszierende Verbindungen sind, die auch in Kombination mit den erfindungsgemäßen Verbindungen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl) oder WO 2005/039246, US 2005/0069729, JP 2004/288381, EP 1205527, WO 2008/086851 oder WO 2013/041176, Indolocarbazolderivate, z. B. gemäß WO 2007/063754 oder WO 2008/056746, Indenocarbazolderivate, z. B. gemäß WO 2010/136109, WO 2011/000455, WO 2013/041176 oder WO 2013/056776, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2007/063754, WO 2008/056746, WO 2010/015306, WO 2011/057706, WO 2011/060859 oder WO 2011/060877, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, verbrückte Carbazol-Derivate, z. B. gemäß WO 2011/042107, WO 2011/060867, WO 2011/088877 und WO 2012/143080, Triphenylenderivate, z. B. gemäß WO 2012/048781, Lactame, z. B. gemäß WO 2011/116865 oder WO 2011/137951, oder Dibenzofuranderivate, z. B. gemäß WO 2015/169412, WO 2016/015810, WO 2016/023608, WO 2017/148564 oder WO 2017/148565. Ebenso kann ein weiterer phosphoreszierender Emitter, welcher kürzerwellig als der eigentliche Emitter emittiert, als Co-Host in der Mischung vorhanden sein oder eine Verbindung, die nicht oder nicht in wesentlichem Umfang am Ladungstransport teilnimmt, wie beispielsweise in WO 2010/108579 beschrieben.

Da die Verbindung der Formel (1) bzw. die bevorzugten Ausführungsformen lochtransportierende Eigenschaften aufweist, wird diese Verbindung bei Verwendung in einem Mischmatrixsystem bevorzugt mit einer Verbindung kombiniert, die elektronentransportierende Eigenschaften aufweist.

Daher ist es weiter bevorzugt, dass die Zusammensetzung der vorliegenden Erfindung zusätzlich zu dem lochtransportierenden Matrixmaterial der Formel (1) mindestens ein elektronentransportierendes Matrixmaterial enthält.

Besonders geeignete Matrixmaterialien, die vorteilhaft mit den erfindungsgemäßen Verbindungen in einem Mixed-Matrix-System kombiniert werden, können aus den Verbindungen der Formeln (eTMM1), (eTMM2), (eTMM3), (eTMM4) oder (eTMM5) ausgewählt werden, wie nachfolgend beschrieben.

Ein weiterer Gegenstand der Erfindung ist demzufolge eine Mischung enthaltend mindestens eine erfindungsgemäße Verbindung und mindestens eine Verbindung der Formel (eTMM1), (eTMM2), (eTMM3), (eTMM4) und/oder (eTMM5), 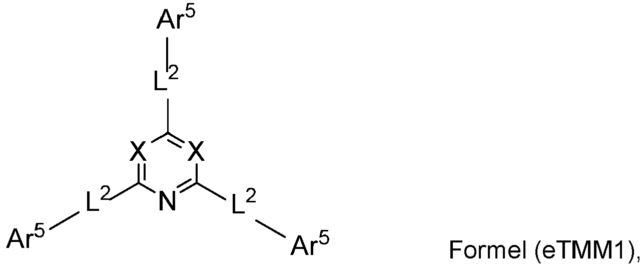 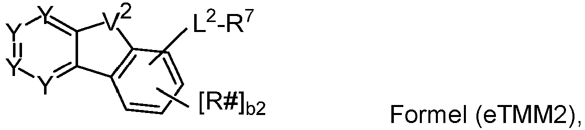 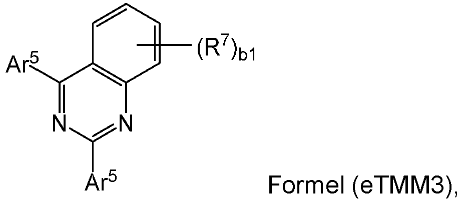 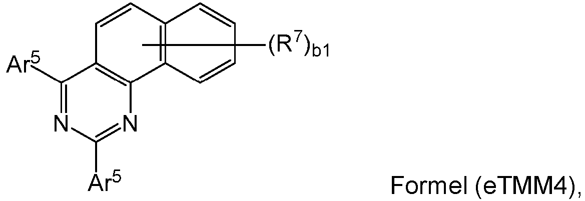 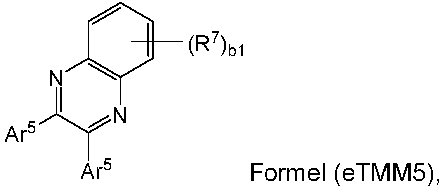 wobei für die verwendeten Symbole und Indizes gilt:
- L²: ist bei jedem Auftreten gleich oder verschieden eine Einfachbindung oder ein aromatisches oder heteroaromatisches Ringsystem mit 5 bis 24 Ringatomen, das jeweils mit einem oder mehreren Resten R⁷ substituiert sein kann;
- R#: ist bei jedem Auftreten gleich oder verschieden D, F, CN oder ein aromatisches Ringsystem mit 6 bis 24 Ringatomen, das mit einem oder mehreren Resten R⁶ substituiert sein kann;
- Y: ist bei jedem Auftreten gleich oder verschieden N oder CR⁷, wobei ausgeschlossen ist, dass zwei nebeneinanderliegende Y gleichzeitig N bedeuten;
- V²: ist O oder S;
- R: ist bei jedem Auftreten gleich oder verschieden H, D, F, CN, Si(R⁷)₃, Ge(R⁷)₃, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R⁷ substituiert sein kann und wobei eine oder mehrere nicht benachbarte CH₂-Gruppen durch Si(R⁷)₂, C=O, NR⁷, O, S oder CONR⁷ ersetzt sein können, oder ein aromatisches oder heteroaromatisches Ringsystem mit 5 bis 60 Ringatomen, das jeweils durch einen oder mehrere Reste R⁷ substituiert sein kann; dabei können zwei Reste R⁶ auch miteinander ein aromatisches, heteroaromatisches, aliphatisches oder heteroaliphatisches Ringsystem bilden;
- Ar⁵: steht bei jedem Auftreten gleich oder verschieden für ein aromatisches oder heteroaromatisches Ringsystem mit 5 bis 40 Ringatomen, welches mit einem oder mehreren Resten R⁷ substituiert sein kann;
- R: ⁷ ist bei jedem Auftreten gleich oder verschieden H, D, F, Cl, Br, I, N(R⁸)₂, CN, NO₂, OR⁸, SR⁸, Si(R⁸)₃, Ge(R⁸)₃, B(OR⁸)₂, C(=O)R⁸, P(=O)(R⁸)₂, S(=O)R⁸, S(=O)₂R⁸, OSO₂R⁸, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R⁸ substituiert sein kann, wobei eine oder mehrere nicht benachbarte CH₂-Gruppen durch Si(R⁸)₂, C=O, NR⁸, O, S oder CONR⁸ ersetzt sein können, oder ein aromatisches oder heteroaromatisches Ringsystem mit 5 bis 40 Ringatomen, das jeweils durch einen oder mehrere Reste R⁸ substituiert sein kann; dabei können zwei oder mehrere Reste R⁷ miteinander ein aromatisches, heteroaromatisches, aliphatisches oder heteroaliphatisches Ringsystem bilden;
- R⁸: ist bei jedem Auftreten gleich oder verschieden **H,** D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
- b1: ist 0, 1, 2, 3 oder 4;
- b2: ist 0, 1, 2 oder 3.

Ein weiterer Gegenstand der Erfindung ist eine organische elektronische Vorrichtung, insbesondere eine organische Elektrolumineszenzvorrichtung umfassend Anode, Kathode und mindestens eine organische Schicht, enthaltend mindestens eine lichtemittierende Schicht, wobei mindestens eine lichtemittierende Schicht die oben genannte Mischung aus mindestens einer erfindungsgemäßen Verbindung und und mindestens einer Verbindung der Formeln (eTMM1), (eTMM2), (eTMM3), (eTMM4) und/oder (eTMM5) enthält.

Bevorzugte Verbindungen der Formel (eTMM1) sind die Verbindungen der Formeln (eTMM1a), (eTMM1b), (eTMM1c), (eTMM1d) und (eTMM1e), 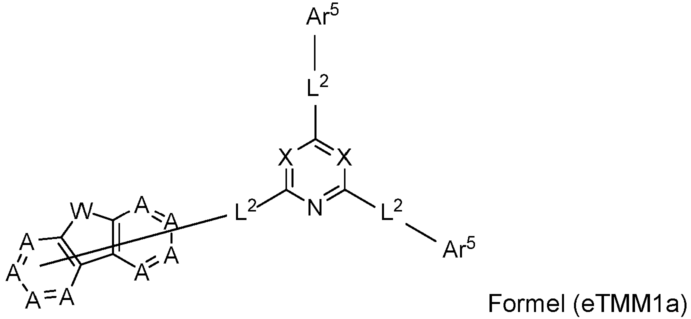 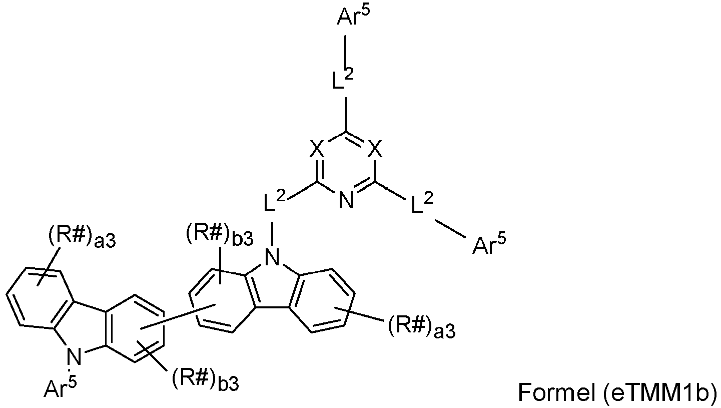 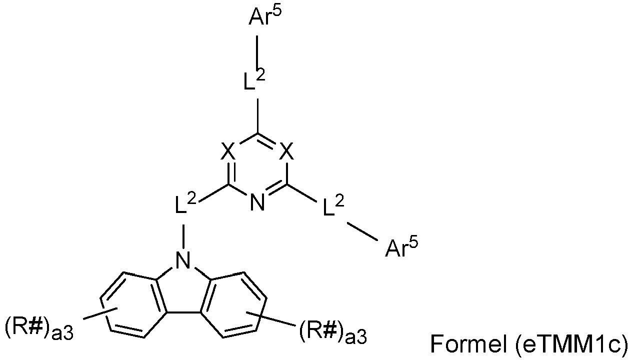 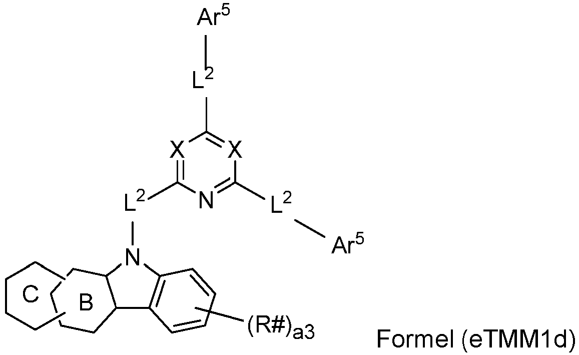 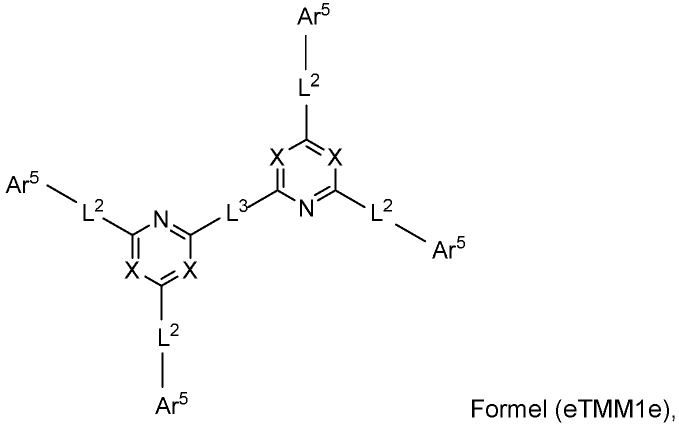 wobei die Symbole und Indizes für diese Formeln die folgende Bedeutung haben:
- W, W¹: bedeuten bei jedem Auftreten gleich oder verschieden O, S, C(R^{W})₂ oder N-Ar⁵;
- R^{W}: ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei ein oder mehrere H-Atome durch D, F, oder CN ersetzt sein können, oder ein aromatisches oder heteroaromatisches Ringsystem mit 5 bis 40 Ringatomen, das mit einem oder mehreren Substituenten ausgewählt aus D, F, CN, einer geradkettigen Alkylgruppe mit 1 bis 20 C-Atomen oder einer verzweigten oder cyclischen Alkylgruppe mit 3 bis 20 C-Atomen ersetzt sein können, wobei ein oder mehrere H-Atome der Alkylgruppe am aromatischen oder heteroaromatischen Ringsystem durch D, F, oder CN ersetzt sein können; dabei können die beiden Reste R^{W}, die an dasselbe Kohlenstoffatom binden, auch miteinander ein Ringsystem bilden;
- A: ist bei jedem Auftreten gleich oder verschieden CR⁷ oder N, wobei maximal zwei Gruppen A pro Cyclus für N stehen und wobei A für C steht, wenn an diese Position L² gebunden ist;
- a3: ist bei jedem Auftreten gleich oder verschieden 0, 1, 2, 3 oder 4;
- b3: ist bei jedem Auftreten gleich oder verschieden 0, 1, 2 oder 3;
- Ring B: 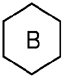 ist abgeleitet von einer Arylgruppe mit 6 bis 20 Ringatomen, die mit einem oder mehreren Substituenten R# substituiert sein kann;
- Ring C: 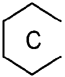 bedeutet 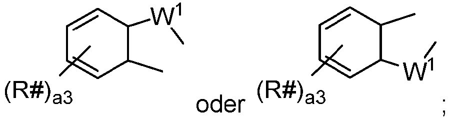
- L₃: ist ein aromatisches Ringsystem mit 6 bis 40 Ringatomen oder ein heteroaromatisches Ringsystem mit 5 bis 40 Ringatomen, die mit einem oder mehreren Resten R⁷ substituiert sein können;
- L², X, Ar₅, R⁷ und R#: haben die zuvor angegebenen Bedeutungen.

Besonders bevorzugte Matrixmaterialien für blau phosphoreszente OLEDs oder hyperphosphoreszente OLEDs sind die Verbindungen der folgenden Formel (eTMM1c*), 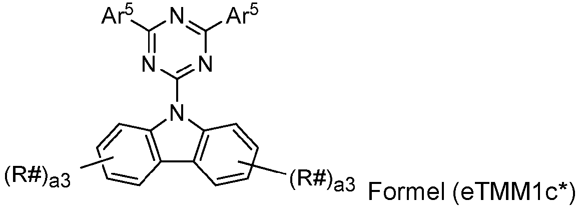 wobei die verwendeten Symbole und Indizes die oben genannten Bedeutungen aufweisen und die Verbindung auch teilweise oder vollständig deuteriert sein kann. Dabei sind besonders bevorzugte Gruppen Ar⁵ gleich oder verschieden bei jedem Auftreten ausgewählt aus Phenyl, meta-Biphenyl oder N-Carbazolyl, welches jeweils auch durch einen oder mehrere Reste R⁷ substituiert sein kann. Weiterhin bevorzugt ist mindestens einer und besonders bevorzugt genau einer der Substituenten, die an die N-Carbazolylgruppe oder an Ar⁵ gebunden sind, eine Triphenylsilylgruppe. Besonders bevorzugt weist die Verbindung der Formel (eTMM1c*) eine Gruppe Ar⁵ auf, welche für eine Phenylgruppe steht, die in meta-Position mit einer Triphenylsilylgruppe substituiert ist.

Bevorzugte Verbindungen der Formel (eTMM3) sind die Verbindungen der Formel (eTMM3a), 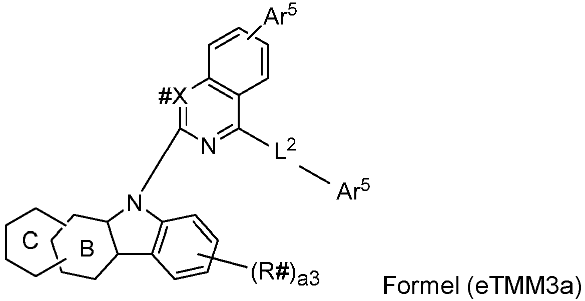 wobei die Symbole und Indizes für diese Formel (eTMM3a) die folgende Bedeutung haben:
- W¹: ist bei jedem Auftreten gleich oder verschieden O, S, C(R^{W})₂ oder N-Ar⁵;

- #X: ist CR oder NAr⁵, bevorzugt NAr⁵;
- R^{W}: ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei ein oder mehrere H-Atome durch D, F, oder CN ersetzt sein können, oder ein aromatisches oder heteroaromatisches Ringsystem mit 5 bis 40 Ringatomen, das mit einem oder mehreren Substituenten ausgewählt aus D, F, CN, einer geradkettigen Alkylgruppe mit 1 bis 20 C-Atomen oder einer verzweigten oder cyclischen Alkylgruppe mit 3 bis 20 C-Atomen ersetzt sein können, wobei ein oder mehrere H-Atome der Alkylgruppe am aromatischen oder heteroaromatischen Ringsystem durch D, F, oder CN ersetzt sein können;
- a3: ist bei jedem Auftreten gleich oder verschieden 0, 1, 2, 3 oder 4;
- Ring B: 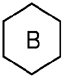 ist abgeleitet von einer Arylgruppe mit 6 bis 20 Ringatomen, die mit einem oder mehreren Substituenten R## substituiert sein kann;
- Ring C: 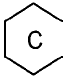 bedeutet 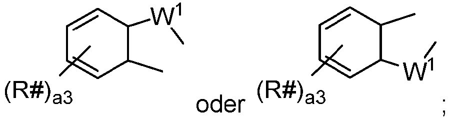
wobei L², Ar⁵ und R# die zuvor angegebenen Bedeutungen haben.

In Verbindungen der Formel (eTMM1a) ist W bevorzugt O oder N-Ar⁵.

In Verbindungen der Formel (eTMM1a) ist A bevorzugt bei jedem Auftreten gleich oder verschieden CR⁷, wobei A für C steht, wenn an diese Position L² gebunden ist.

In Verbindungen der Formeln (eTMM1d) oder (eTMM3a) ist W¹ bevorzugt O, C(R^{W})₂ oder N-Ar⁵, besonders bevorzugt N-Ar⁵.

In Verbindungen der Formel (eTMM1e) ist L³ bevorzugt ein heteroaromatisches Ringsystem mit 9 bis 30 Ringatomen, das mit einem oder mehreren Resten R⁷ substituiert sein kann.

In einer bevorzugten Ausführungsform der Verbindungen der Formeln (eTMM1), (eTMM1a), (eTMM1b), (eTMM1c), (eTMM1d), (eTMM1e), (eTMM2), (eTMM3), (eTMM3a), (eTMM4) oder (eTMM5) ist R⁷ gleich oder verschieden bei jedem Auftreten ausgewählt aus der Gruppe bestehend aus H, D, F, CN, Si(R⁸)₃, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R⁸ substituiert sein kann, oder ein aromatisches oder heteroaromatisches Ringsystem mit 5 bis 60 Ringatomen, bevorzugt mit 5 bis 40 Ringatomen, das jeweils durch einen oder mehrere Reste R⁸ substituiert sein kann.

In einer besonders bevorzugten Ausführungsform der Verbindungen der Formeln (eTMM1), (eTMM1a), (eTMM1b), (eTMM1c), (eTMM1d), (eTMM1e), (eTMM2), (eTMM3), (eTMM3a), (eTMM4) oder (eTMM5) ist R⁷ gleich oder verschieden bei jedem Auftreten ausgewählt aus der Gruppe bestehend aus H, D oder einem aromatischen oder heteroaromatischen Ringsystem mit 6 bis 30 Ringatomen, welches mit einem oder mehreren Resten R⁸ substituiert sein kann.

Die Herstellung der Verbindungen der Formeln (eTMM1), (eTMM1a), (eTMM1b), (eTMM1c), (eTMM1d), (eTMM1e), (eTMM2), (eTMM3), (eTMM3a), (eTMM4) oder (eTMM5) sind generell bekannt und einige der Verbindungen sind kommerziell erhältlich.

Geeignete Verbindungen der Formel (eTMM1) sind beispielsweise aus folgenden Publikationen bekannt: WO2007/077810A1, WO2008/056746A1, WO2010/136109A1, WO2011/057706A2, WO2011/160757A1, WO2012/023947A1, WO2012/048781A1, WO2013/077352A1, WO2013147205A1, WO2013/083216A1, WO2014/094963A1, WO2014/007564A1, WO2014/015931A1, WO2015/090504A2, WO2015/105251A1, WO2015/169412A1, WO2016/015810A1, WO2016/013875A1, WO2016/010402A1, WO2016/033167A1, WO2017/178311A1, WO2017/076485A1, WO2017/186760A1, WO2018/004096A1, WO2018/016742A1, WO2018/123783A1, WO2018/159964A1, WO2018/174678A1, WO2018/174679A1, WO2018/174681A1, WO2018/174682A1, WO2019/177407A1, WO2019/245164A1, WO2019/240473A1, WO2019/017730A1, WO2019/017731A1, WO2019/017734A1, WO2019/145316A1, WO2019/121458A1, WO2020/130381A1, WO2020/130509A1, WO2020/169241A1, WO2020/141949A1, WO2021/066623A1, WO2021/101220A1, WO2021/037401A1, WO2021/180614A1, WO2021/239772A1, WO2022/015084A1, WO2022/025714A1, WO2022/055169A1, EP3575296A1, EP3591728A1, US2014/0361254A1, US2014/0361268A1, KR20210036304A, KR20210036857A, KR2021147993A, JP2011/160367A2 und JP2017/107992A2.

Geeignete Verbindungen der Formel (eTMM2) sind beispielsweise aus folgenden Publikationen bekannt: WO2015/182872A1, WO2015/105316A1, WO2017/109637A1, WO2018/060307A1, WO2018/151479A2, WO2018/088665A2, WO2018/060218A1, WO2018/234932A1, WO2019/058200A1, WO2019/017730A1, WO2019/017731A1, WO2019/066282A1, WO2019/059577A1, WO2020/141949A1, WO2020/067657A1, WO2022063744A1, WO2022/090108A1, WO2022/207678A1, KR2019035308A, KR2021147993A, CN110437241A, US2016/072078A1.

Geeignete Verbindungen der Formel (eTMM3) sind beispielsweise aus folgenden Publikationen bekannt: WO2017/160089A1, WO2019/017730A1, WO2019/017731A1, WO2020/032424A1.

Geeignete Verbindungen der Formel (eTMM5) sind beispielsweise aus folgenden Publikationen bekannt: WO2015/093878A1, WO2016/033167A1, WO2017/183859A1, WO2017/188655A1, WO2018/159964A1.

Für eine Kombination mit den erfindungsgemäßen Verbindungen, wie zuvor beschrieben oder bevorzugt beschrieben, sind insbesondere Verbindungen der Formeln (eTMM1), (eTMM1a), (eTMM1b), (eTMM1c), (eTMM1d), (eTMM1e) und/oder (eTMM2) geeignet, wie zuvor beschrieben oder bevorzugt beschrieben oder entsprechende Verbindungen der nachfolgenden Tabellen, die unter diese Formeln fallen. Dabei sind die Verbindungen der Formeln (eTMM1), (eTMM1a), (eTMM1b), (eTMM1c), (eTMM1d) und/oder (eTMM1e) besonders bevorzugt.

Weitere Beispiele für geeignete Hostmaterialien der Formeln (eTMM1), (eTMM1a), (eTMM1b), (eTMM1c), (eTMM1d), (eTMM1e), (eTMM2), (eTMM3), (eTMM3a), (eTMM4) oder (eTMM5), die erfindungsgemäß mit vorstehend aufgeführten erfindungsgemäßen Verbindungen kombiniert werden können, wie zuvor beschrieben, sind die nachstehend genannten Strukturen in den nachfolgenden Tabellen A und B.

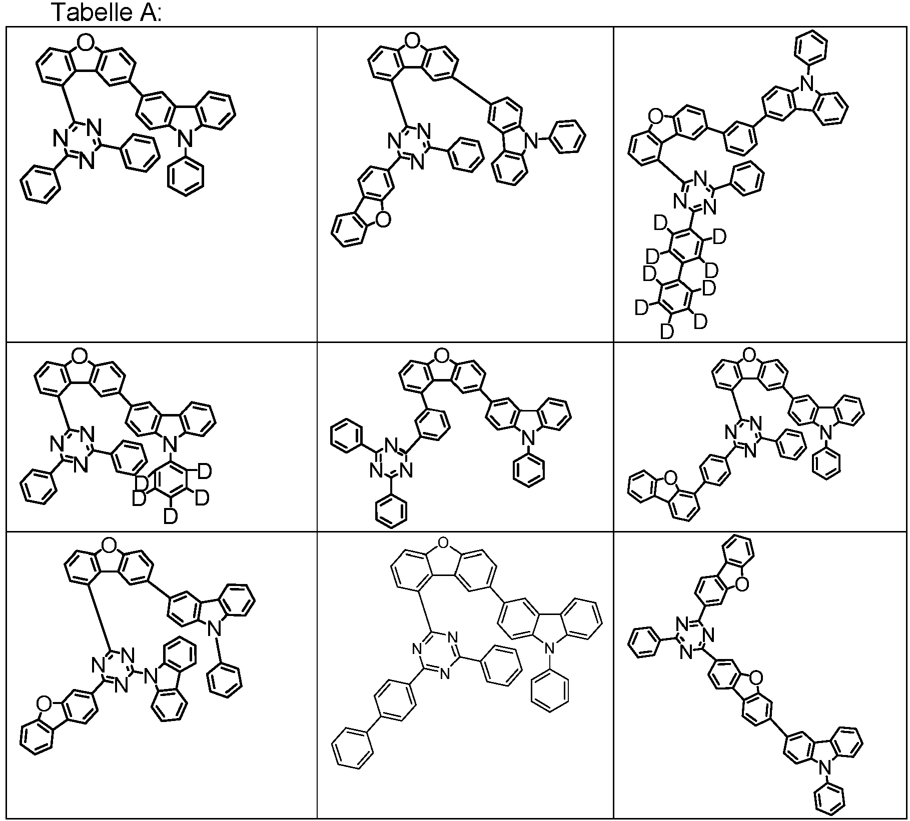

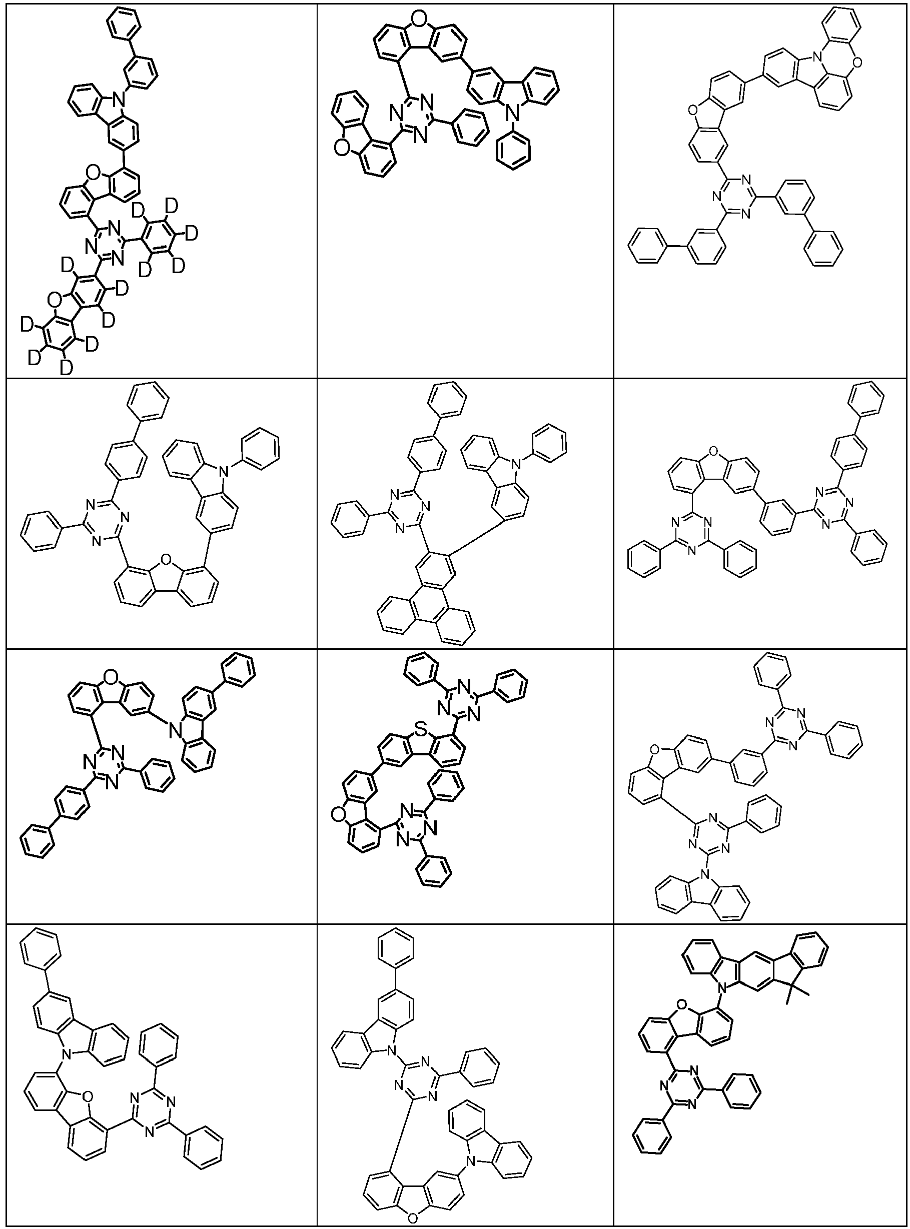

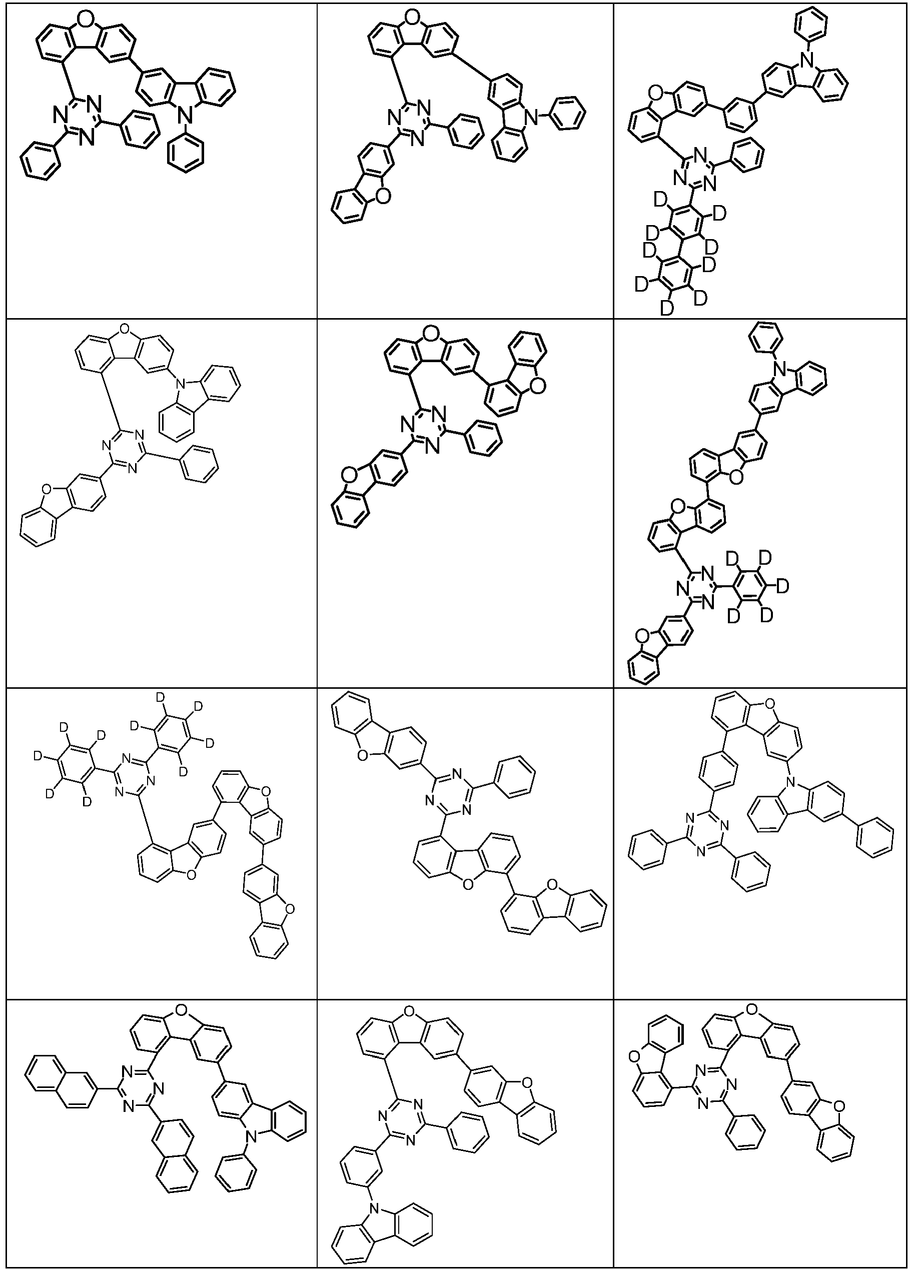

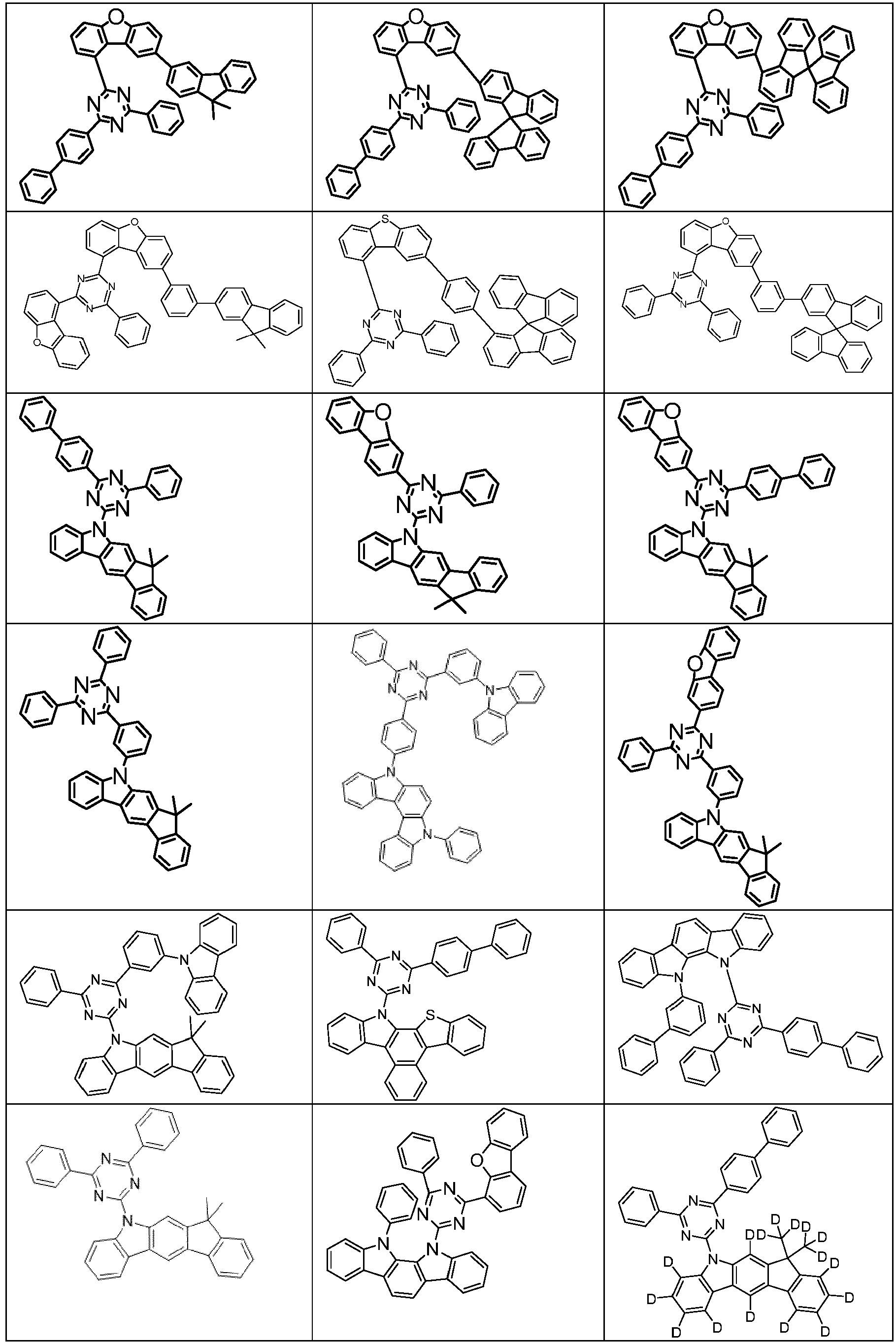

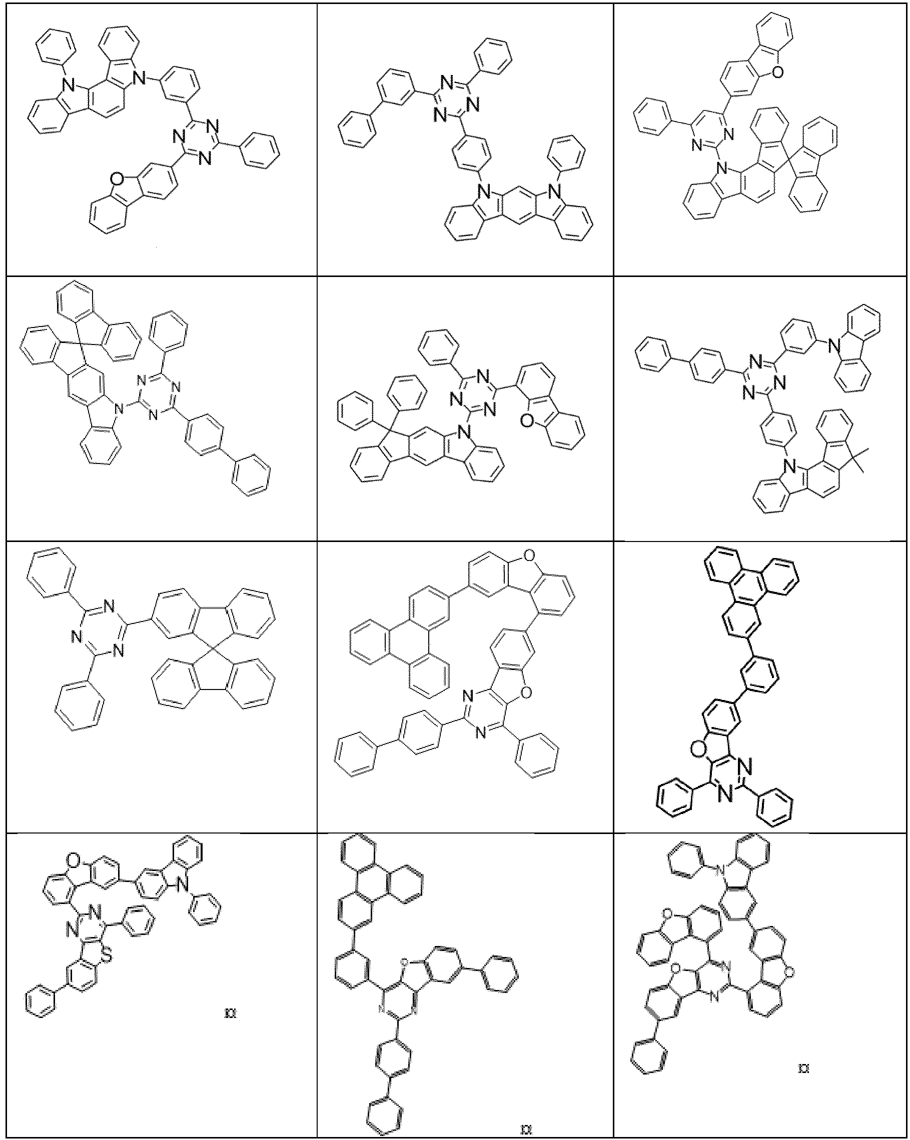

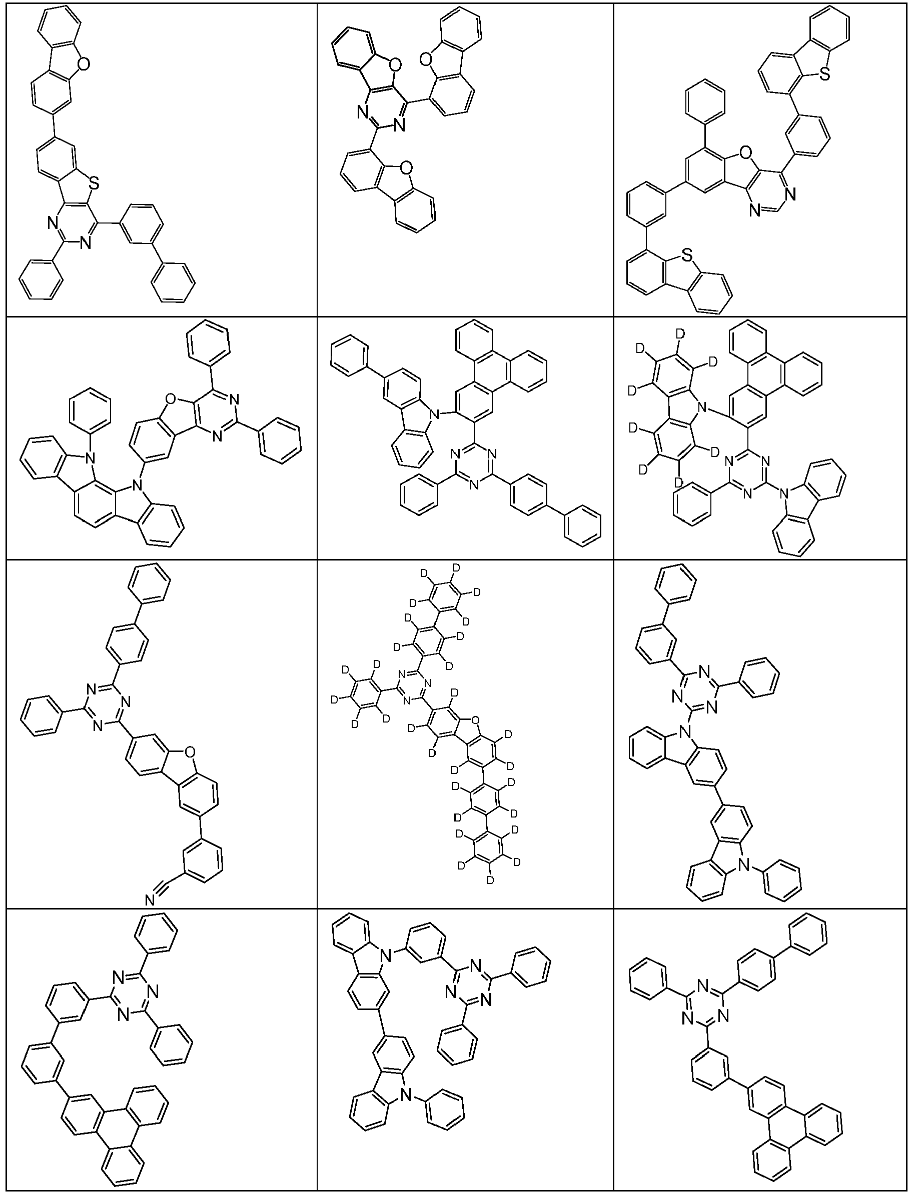

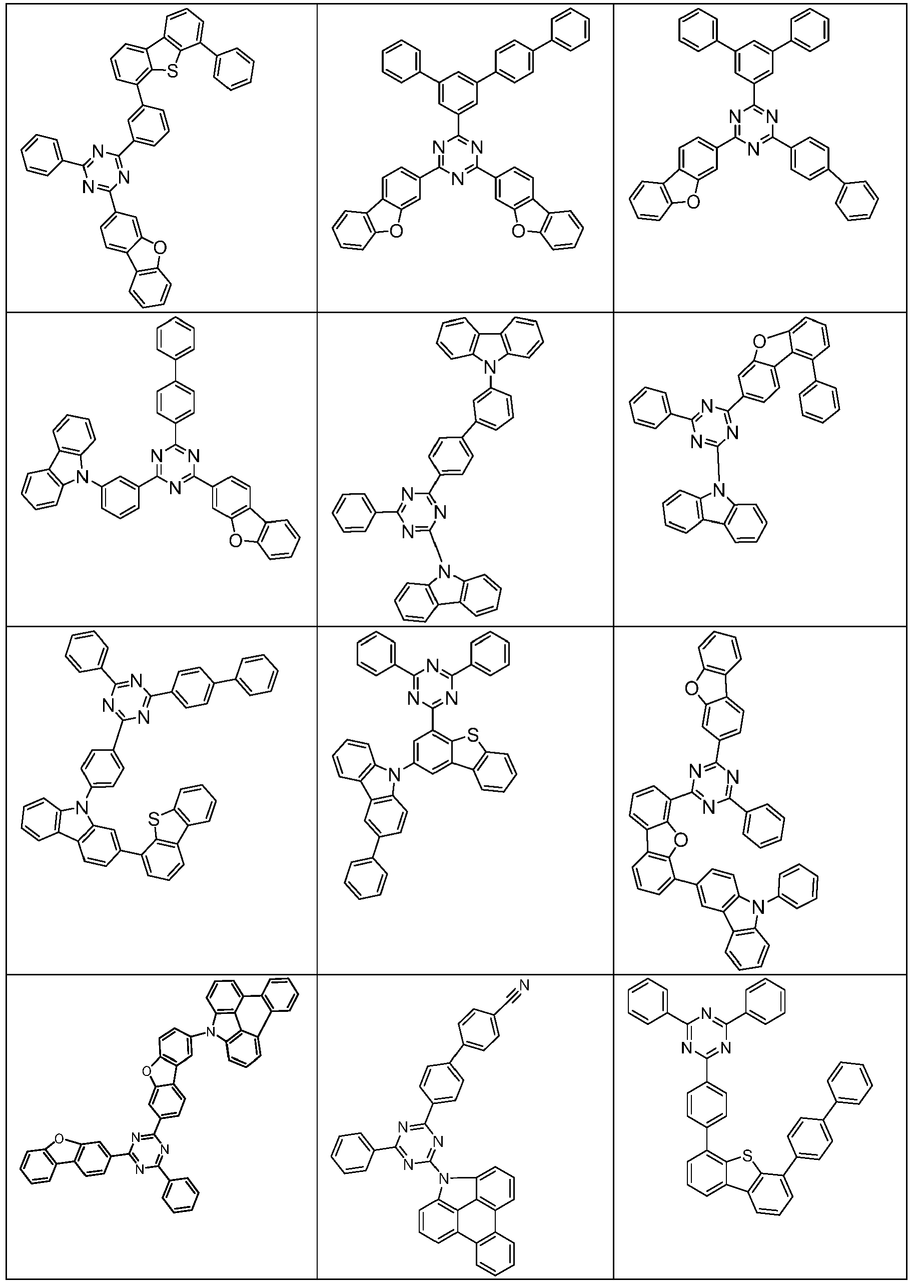

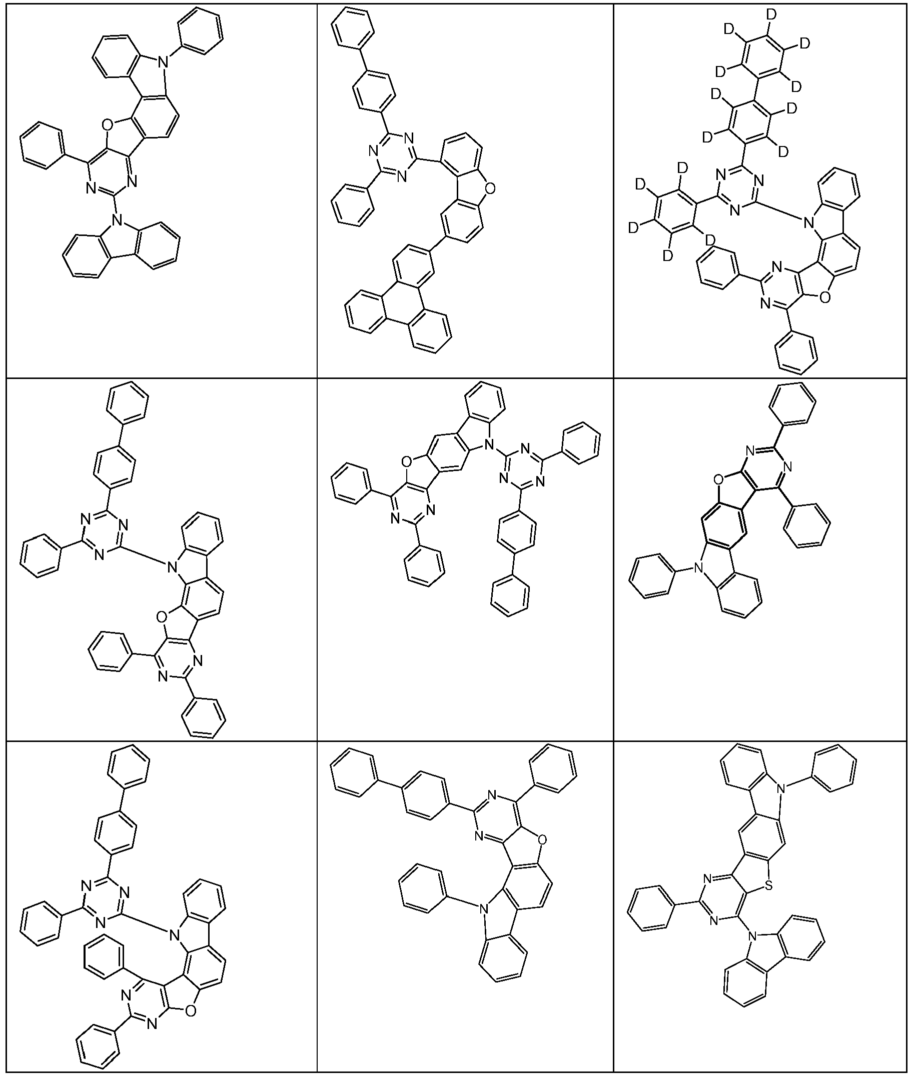

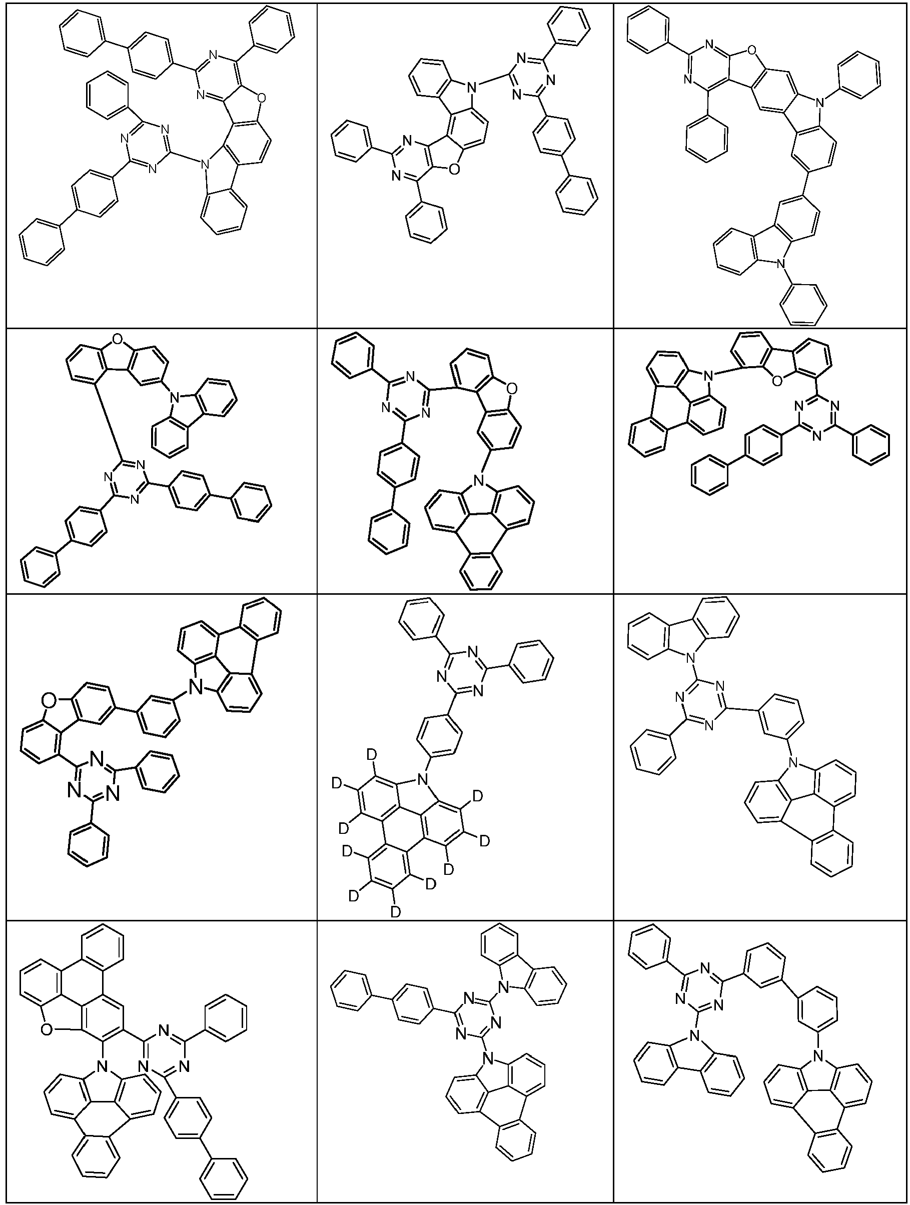

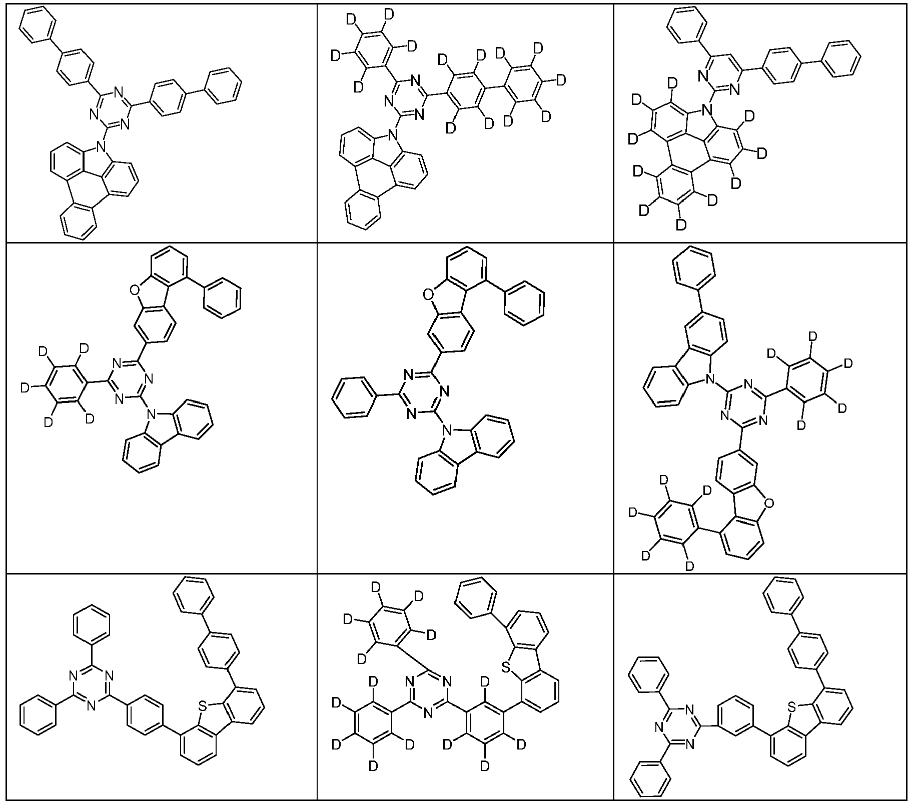

Besonders geeignete Verbindungen der Formeln (eTMM1), (eTMM1a), (eTMM1b), (eTMM1c), (eTMM1d), (eTMM1e), (eTMM1f) und/oder (eTMM2), die erfindungsgemäß mit vorstehend aufgeführten erfindungsgemäßen Verbindungen kombiniert werden können, wie zuvor beschrieben, und in der erfindungsgemäßen elektrolumineszierenden Vorrichtung oder der Mischung verwendet werden, sind die Verbindungen **E1** bis **E40** der Tabelle B.

**Tabelle B:**

| | | |
|---|---|---|
| 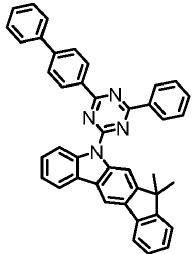 | 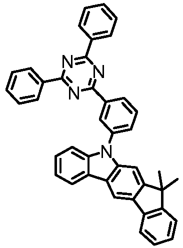 | 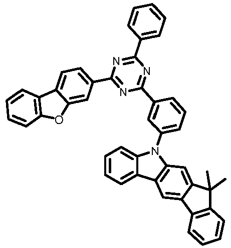 |
| **E1** | **E2** | **E3** |
| 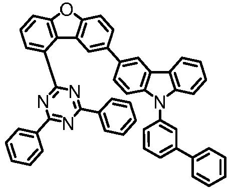 | 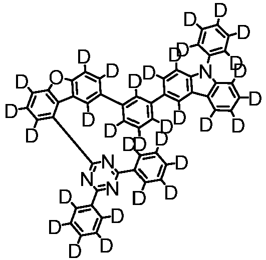 | 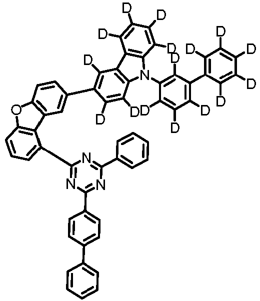 |
| **E4** | **E5** | **E6** |
| 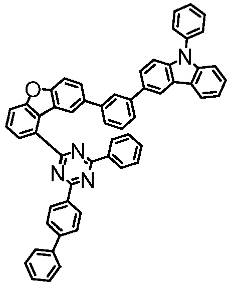 | 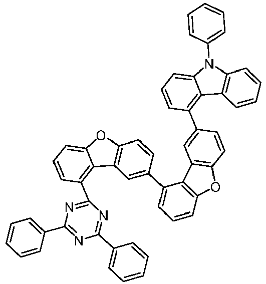 | 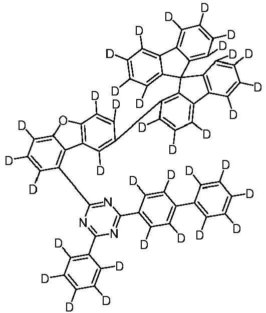 |
| **E7** | **E8** | **E9** |
| 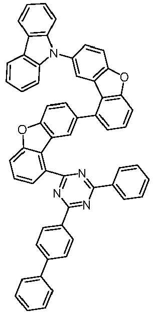 | 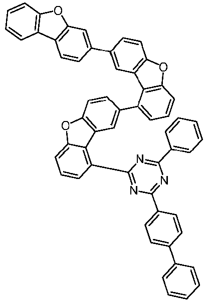 | 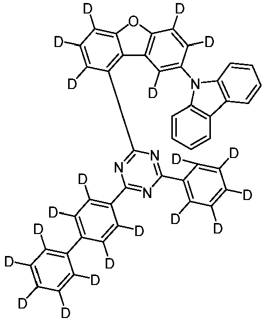 |
| **E10** | **E11** | **E12** |
| 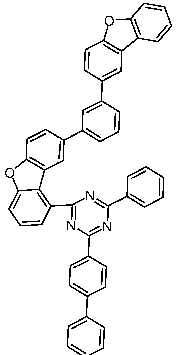 | 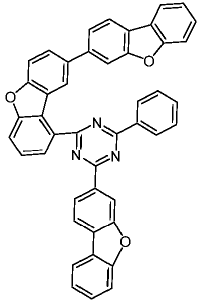 | 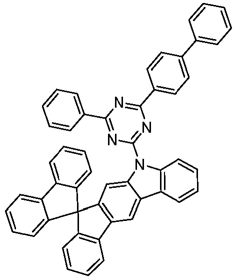 |
| **E13** | **E14** | **E15** |
| 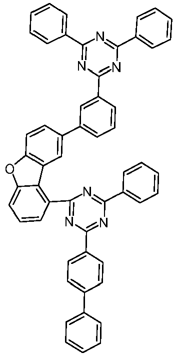 | 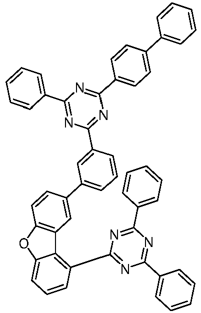 | 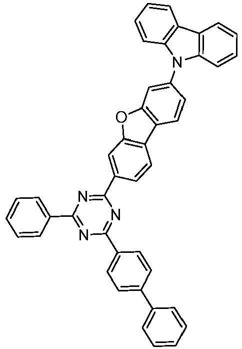 |
| **E16** | **E17** | **E18** |
| 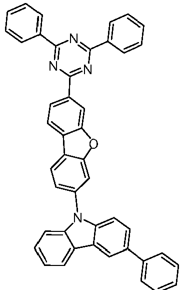 | 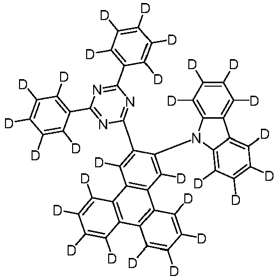 | 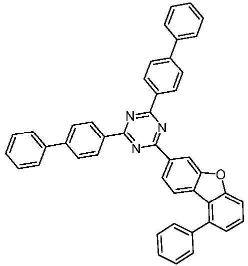 |
| **E19** | **E20** | **E21** |
| 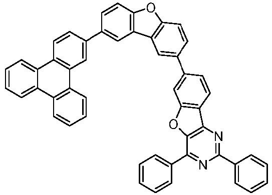 | 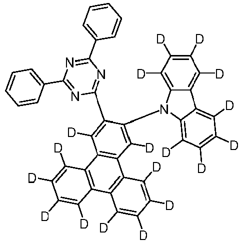 | 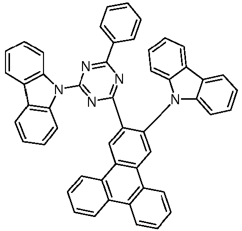 |
| **E22** | **E23** | **E24** |
| 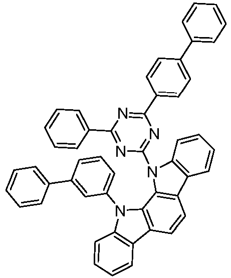 | 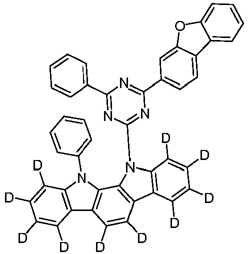 | 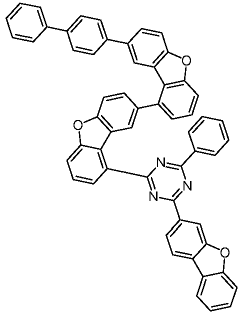 |
| **E25** | **E26** | **E27** |
| 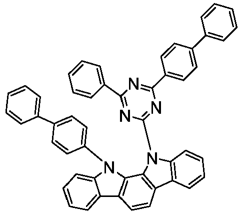 | 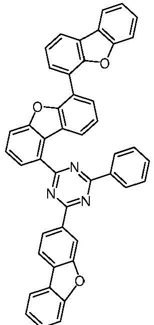 | 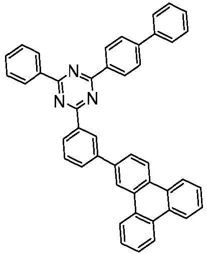 |
| **E28** | **E29** | **E30** |
| 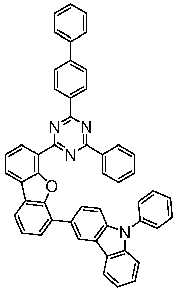 | 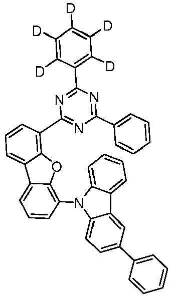 | 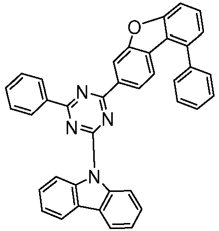 |
| **E31** | **E32** | **E33** |
| 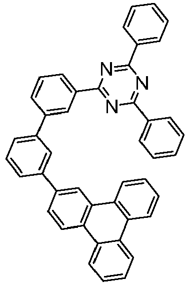 | 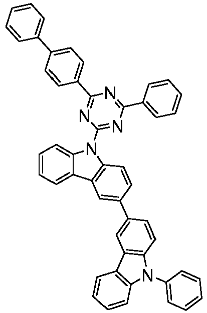 | 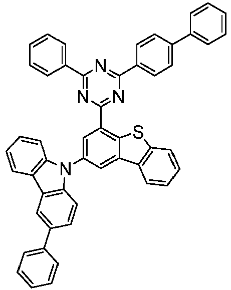 |
| **E34** | **E35** | **E36** |
| 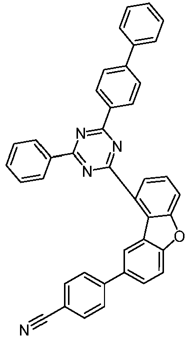 | 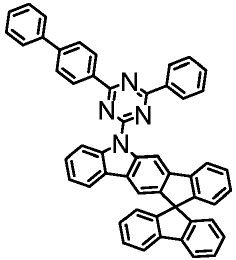 | 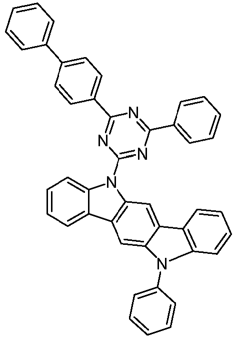 |
| **E37** | **E38** | **E39** |
| 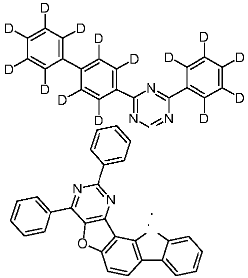 | | |
| **E40** | | |

Die vorstehend genannten erfindungsgemäßen Hostmaterialien sowie deren bevorzugt beschriebene Ausführungsformen können in der erfindungsgemäßen Vorrichtung beliebig mit den zuvor genannten Matrixmaterialien/Hostmaterialien, den Matrixmaterialien/Hostmaterialien der Formeln (eTMM1), (eTMM1a), (eTMM1b), (eTMM1c), (eTMM1d), (eTMM1e), (eTMM2), (eTMM3), (eTMM3a), (eTMM4) oder (eTMM5), sowie deren bevorzugt beschriebenen Ausführungsformen der Tabelle 1 oder den Verbindungen **E1** bis **E40** der Tabelle 2 kombiniert werden.

Handelt es sich bei dem Matrixmaterial um eine deuterierte Verbindung, so ist es möglich, dass das Matrixmaterial eine Mischung an deuterierten Verbindungen gleicher chemischer Grundstruktur ist, die sich lediglich durch den Deuterierungsgrad unterscheiden.

In einer bevorzugten Ausführungsform des Matrixmaterials ist dieses ein Gemisch aus deuterierten erfindungsgemäßen Verbindungen bzw. der Formel (eTMM1), (eTMM1a), (eTMM1b), (eTMM1c), (eTMM1d), (eTMM1e), (eTMM2), (eTMM3), (eTMM3a), (eTMM4) oder (eTMM5), wie zuvor beschrieben, wobei der Deuterierungsgrad dieser Verbindungen mindestens 50% bis 90% beträgt, bevorzugt 70% bis 100 % beträgt.

Die Konzentration der Summe aller erfindungsgemäßen Hostmaterialien, wie zuvor beschrieben oder bevorzugt beschrieben, in der erfindungsgemäßen Mischung oder in der lichtemittierenden Schicht der erfindungsgemäßen Vorrichtung liegt üblicherweise im Bereich von 5 Vol.-% bis 90 Vol.-%, bevorzugt im Bereich von 10 Vol.-% bis 85 Vol.-%, mehr bevorzugt im Bereich von 20 Vol.-% bis 85 Vol.-%, noch mehr bevorzugt im Bereich von 30 Vol.-% bis 80 Vol.-%, ganz besonders bevorzugt im Bereich von 20 Vol.-% bis 60 Vol.-% und am meisten bevorzugt im Bereich von 30 Vol.-% bis 50 Vol.-%, bezogen auf die gesamte Mischung oder bezogen auf die gesamte Zusammensetzung der lichtemittierenden Schicht.

Die Konzentration der Summe aller Hostmaterialien der Formeln (eTMM1), (eTMM1a), (eTMM1b), (eTMM1c), (eTMM1d), (eTMM1e), (eTMM2), (eTMM3), (eTMM3a), (eTMM4) oder (eTMM5), wie zuvor beschrieben oder bevorzugt beschrieben, in der erfindungsgemäßen Mischung oder in der lichtemittierenden Schicht der erfindungsgemäßen Vorrichtung liegt üblicherweise im Bereich von 5 Vol.-% bis 90 Vol.-%, bevorzugt im Bereich von 10 Vol.-% bis 85 Vol.-%, mehr bevorzugt im Bereich von 20 Vol.-% bis 85 Vol.-%, noch mehr bevorzugt im Bereich von 30 Vol.-% bis 80 Vol.-%, ganz besonders bevorzugt im Bereich von 20 Vol.-% bis 60 Vol.-% und am meisten bevorzugt im Bereich von 30 Vol.-% bis 50 Vol.-%, bezogen auf die gesamte Mischung oder bezogen auf die gesamte Zusammensetzung der lichtemittierenden Schicht.

Die vorliegende Erfindung betrifft auch eine Mischung, die neben den vorstehend genannten erfindungsgemäßen Hostmaterialien und des Hostmaterials mindestens einer der Formeln (eTMM1), (eTMM1a), (eTMM1b), (eTMM1c), (eTMM1d), (eTMM1e), (eTMM2), (eTMM3), (eTMM3a), (eTMM4) oder (eTMM5), wie zuvor beschrieben oder bevorzugt beschrieben, mindestens noch einen phosphoreszierenden Emitter enthält.

Beispiele für besonders geeignete Matrixmaterialien für blau phosphoreszierende Metallkomplexe sind nachstehend abgebildet:

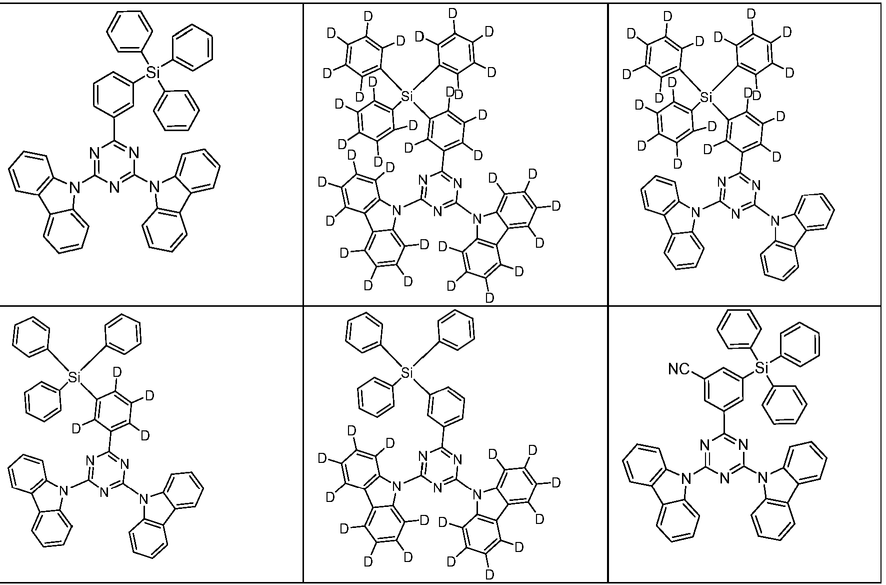

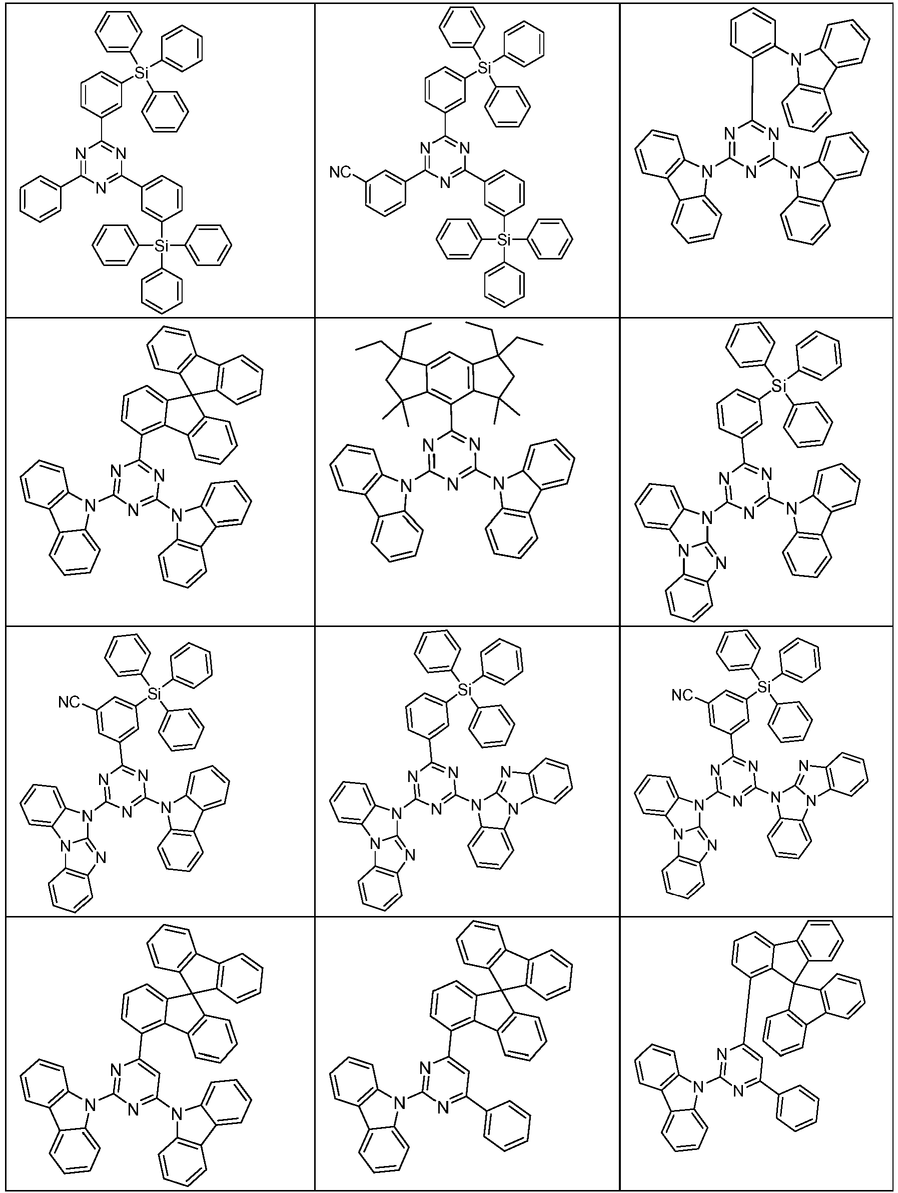

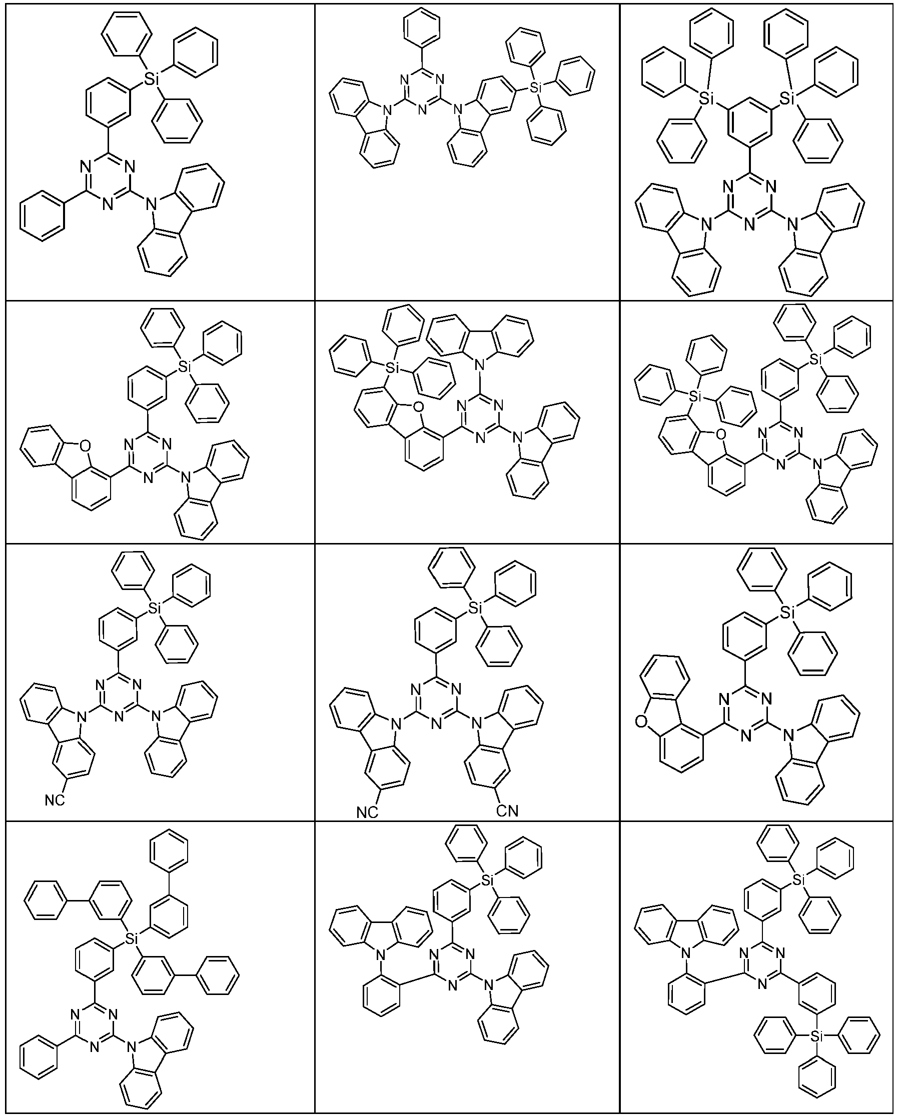

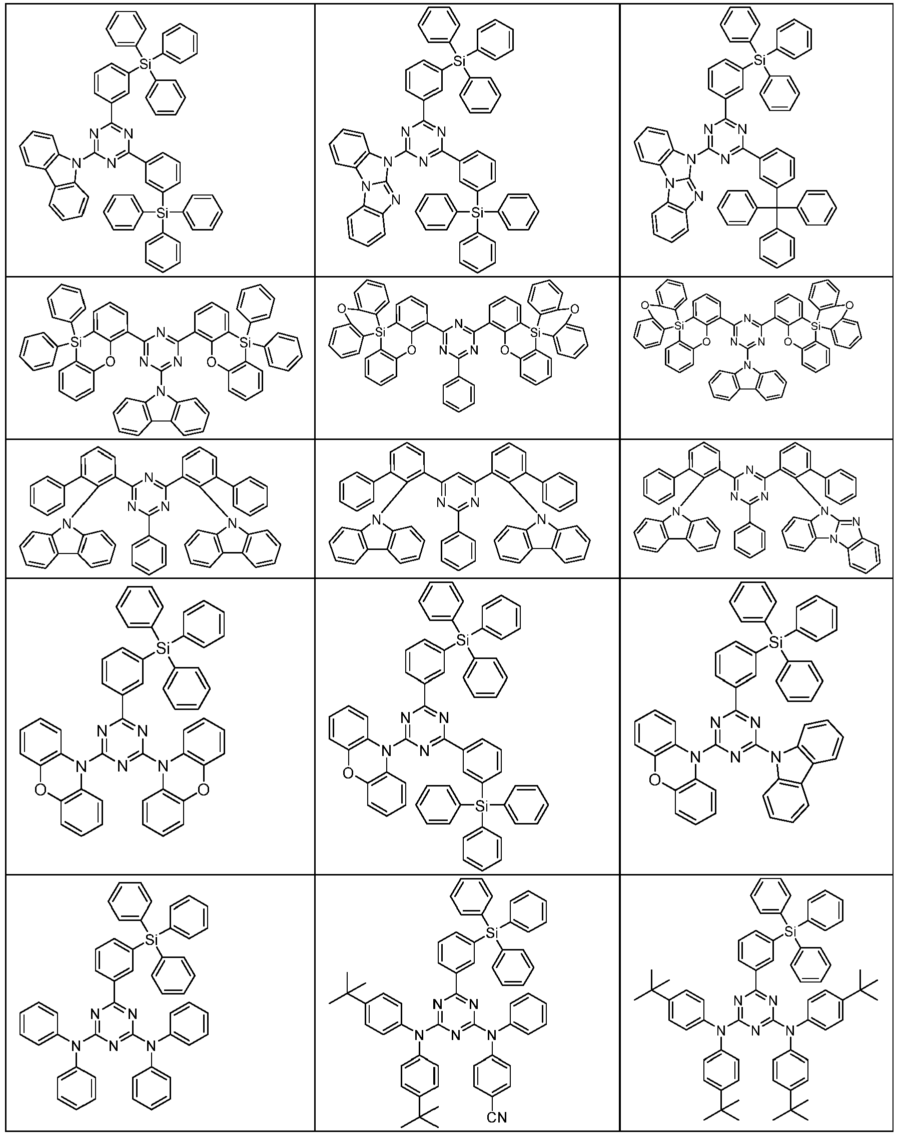

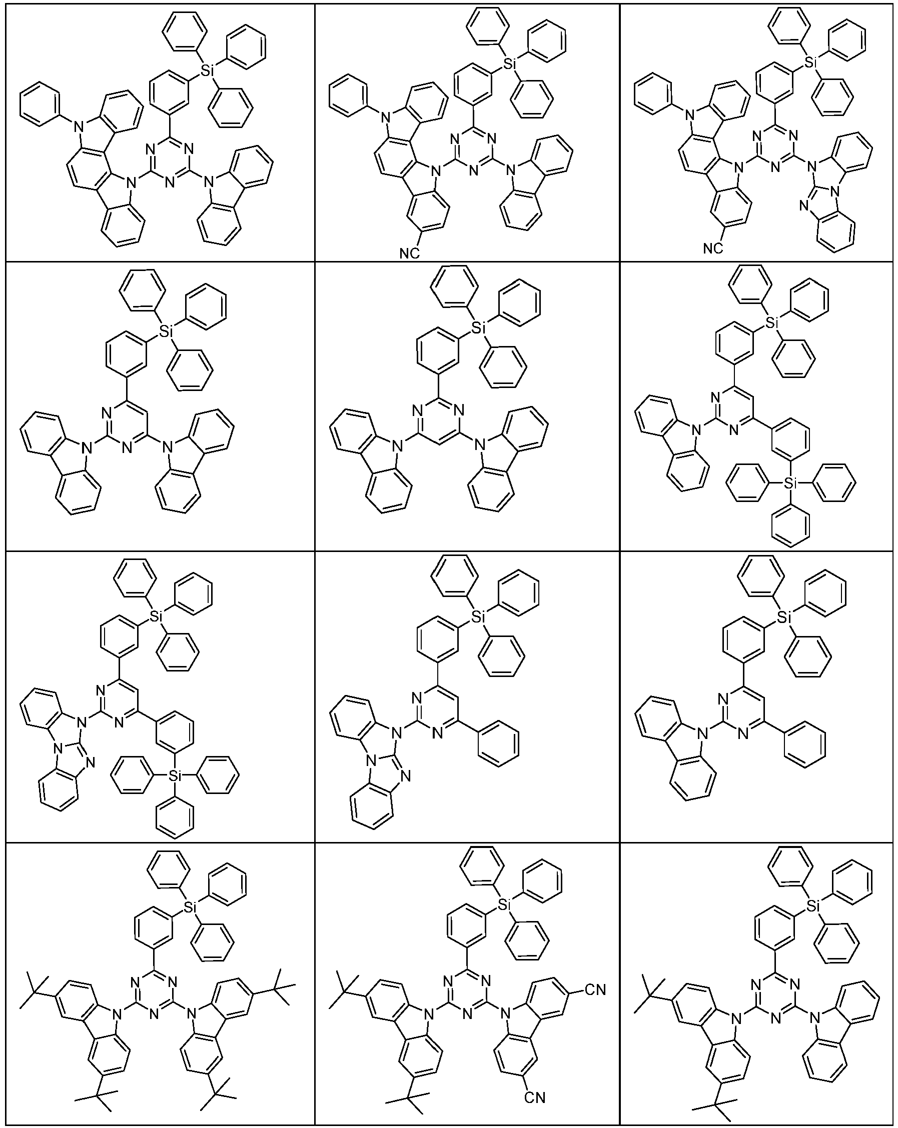

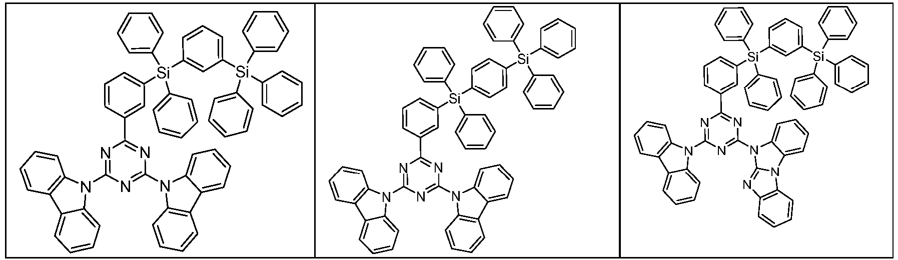

Vorzugsweise hat der mindestens eine fluoreszierende Emitter in der Zusammensetzung eine Peakemissionswellenlänge zwischen 420-550 nm, vorzugsweise zwischen 420-470 nm.

Bevorzugte fluoreszierende emittierende Verbindungen für hyperphosphoreszente OLEDs sind ausgewählt aus der Klasse der Arylamine. Unter einem Arylamin oder einem aromatischen Amin wird im Rahmen der vorliegenden Erfindung eine Verbindung verstanden, die drei substituierte oder unsubstituierte aromatische oder heteroaromatische Ringsysteme enthält, die direkt an den Stickstoff gebunden sind. Vorzugsweise ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin versteht man eine Verbindung, bei der eine Diarylaminogruppe direkt an eine Anthracengruppe, vorzugsweise in 9-Position, gebunden ist. Unter einem aromatischen Anthracendiamin ist eine Verbindung zu verstehen, in der zwei Diarylaminogruppen direkt an eine Anthracengruppe gebunden sind, vorzugsweise in der 9- und 10-Position. Analog sind aromatische Pyrenamine, Pyrendiamine, Chrysenamine und Chrysendiamine definiert, bei denen die Diarylaminogruppen vorzugsweise in 1-Position oder 1,6-Position an das Pyren gebunden sind. Weitere bevorzugte emittierende Verbindungen sind Indenofluorenamine oder Fluorendiamine, beispielsweise nach WO 2006/108497 oder WO 2006/122630, Benzoindenofluorenamine oder -fluorendiamine, beispielsweise nach WO 2008/006449, und Dibenzoindenofluorenamine oder -diamine, beispielsweise nach WO 2007/140847, sowie die in WO 2010/012328 offenbarten Indenofluorenderivate mit kondensierten Arylgruppen. Ebenso bevorzugt sind die in WO 2012/048780 und in WO 2013/185871 offenbarten Pyrenarylamine. Ebenfalls bevorzugt sind die in WO 2014/037077 offenbarten Benzoindenofluorenamine, die in WO 2014/106522 offenbarten Benzofluorenamine, die in WO 2014/111269 und in WO 2017/036574 offenbarten verlängerten Benzoindenofluorene, die in WO 2017/028940 und in WO 2017/028941 offenbarten Phenoxazine und die in WO 2016/150544 offenbarten an Furaneinheiten oder an Thiopheneinheiten gebundenen Fluorderivate. Weiterhin können Bor-Verbindungen gemäß WO 2020/208051, WO 2015/102118, WO 2016/152418, WO 2018/095397, WO 2019/004248, WO 2019/132040, US 2020/0161552 und WO 2021/089450, WO 2015/102118, KR 2018046851, WO 2019/009052, WO 2020/101001, US 2020/0207787, WO 2020/138874, KR 2020081978, JP 2020-147563, US 2020/0335705 oder KR 2022041028 Verwendung finden.

Vorzugsweise hat der mindestens eine fluoreszierende Emitter eine Halbwertsbreite auf halber Peakhöhe (Full Width at Half Maximum, FWHM) ≤ 50 nm, bevorzugt FWHM ≤ 40 nm, weiter bevorzugt FWHM ≤ 30 nm.

Vorzugsweise hat der mindestens eine fluoreszierende Emitter ein LUMO von -2.1 eV bis -2.5 eV, bevorzugt von -2.2 eV bis -2.4 eV, wie durch quantenchemische Berechnungen definiert. Vorzugsweise hat der mindestens eine fluoreszierende Emitter ein HOMO von -4.8 eV bis -5.2 eV, bevorzugt von -4.9 eV bis -5.1 eV, wie durch quantenchemische Berechnungen definiert.

Vorzugsweise liegt die Energie des niedrigsten Singulettzustands S₁ des fluoreszierenden Emitters bei 2.65 eV bis 2.9 eV, bevorzugt 2.7 bis 2.8 eV, weiter bevorzugt 2.7 bis 2.75 eV, wie durch quantenmechanische Berechnungen definiert.

In einer bevorzugten Ausführungsform der Erfindung ist der fluoreszente Emitter gewählt aus Strukturen der folgenden Formel (F-1), 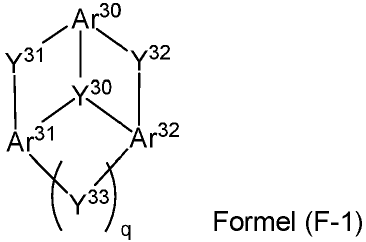 wobei R die oben genannten Bedeutungen aufweist und für die weiteren verwendeten Symbole und Indizes gilt:
- Ar³⁰, Ar³¹, Ar³²: ist gleich oder verschieden bei jedem Auftreten ein substituiertes oder unsubstituiertes aromatisches oder heteroaromatisches Ringsystem mit 5 bis 30 aromatischen Ringatomen;
- Y³⁰: ist B oder N;
- Y³¹, Y³², Y³³: ist gleich oder verschieden bei jedem Auftreten und steht für O, S, C(R⁰)₂, C=O, C=S, C=NR⁰, C=C(R⁰)₂, Si(R⁰)₂, BR⁰, NR⁰, PR⁰, SO₂, SeO₂ oder eine chemische Bindung, mit der Maßgabe dass, wenn Y³⁰ for B steht, mindestens eine der Gruppen Y³¹, Y³², Y³³ für NR⁰ steht, und wenn Y³⁰ für N steht, mindestens eine der Gruppe Y³¹, Y³², Y³³ für BR⁰ steht;
- R⁰: ist bei jedem Auftreten gleich oder verschieden, H, D, F, eine geradkettige Alkylgruppe mit 1 bis 20, bevorzugt mit 1 bis 10 C-Atomen oder eine verzweigte oder cyclische Alkylgruppe mit 3 bis 20, bevorzugt mit 3 bis 10 C-Atomen, welche jeweils mit einem oder mehreren Substituenten R substituiert sein kann, wobei jeweils ein oder mehrere nichtbenachbarte CH₂-Gruppen durch O oder S ersetzt sein können und wobei ein oder mehrere H-Atome durch D oder F ersetzt sein können, oder ein aromatisches oder heteroaromatisches Ringsystem mit 5 bis 40, bevorzugt mit 5 bis 30, besonders bevorzugt mit 6 bis 18 aromatischen Ringatomen, welches jeweils mit einem oder mehreren Substituenten R substituiert sein kann; dabei können zwei benachbarte Substituenten R⁰ miteinander ein aliphatisches oder aromatisches Ring- system bilden, welches mit einem oder mehreren Substituenten R substituiert sein kann;
- q: ist 0 oder 1.

Besonders bevorzugt sind dabei Verbindungen, bei denen gilt:
- q = 0; Y³⁰ = B; und Y³¹, Y³² = NR⁰; oder
- q = 0; Y³⁰ = B; und Y³¹, Y³² = NR⁰; oder
- q = 1; Y³⁰ = N; und Y³¹, Y³² = BR⁰; Y³³ = chemische Bindung.

Beispiele für geeignete fluoreszierende Emitter sind in der nachstehenden Tabelle abgebildet:

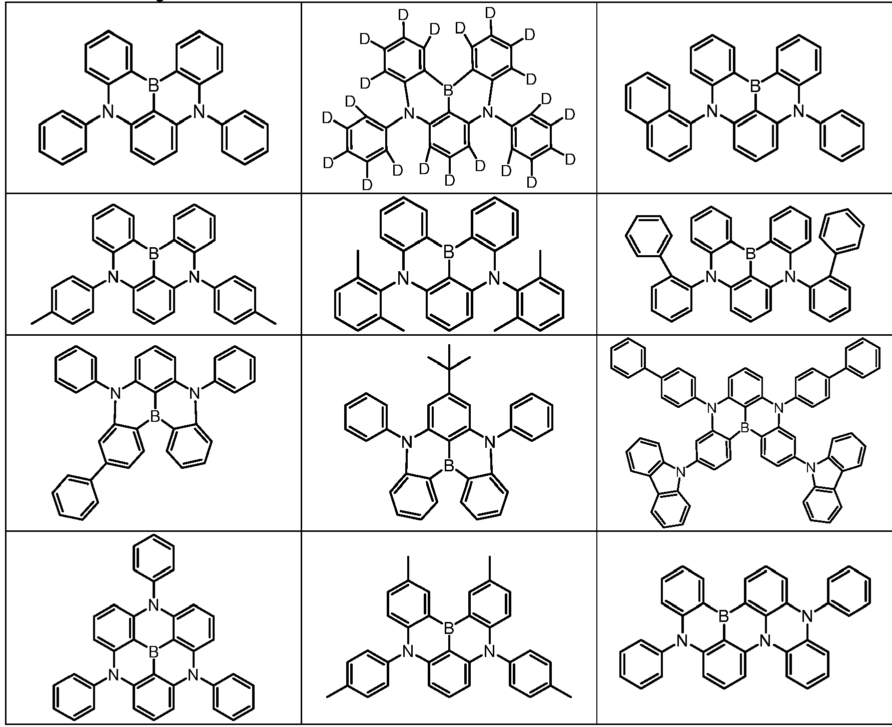

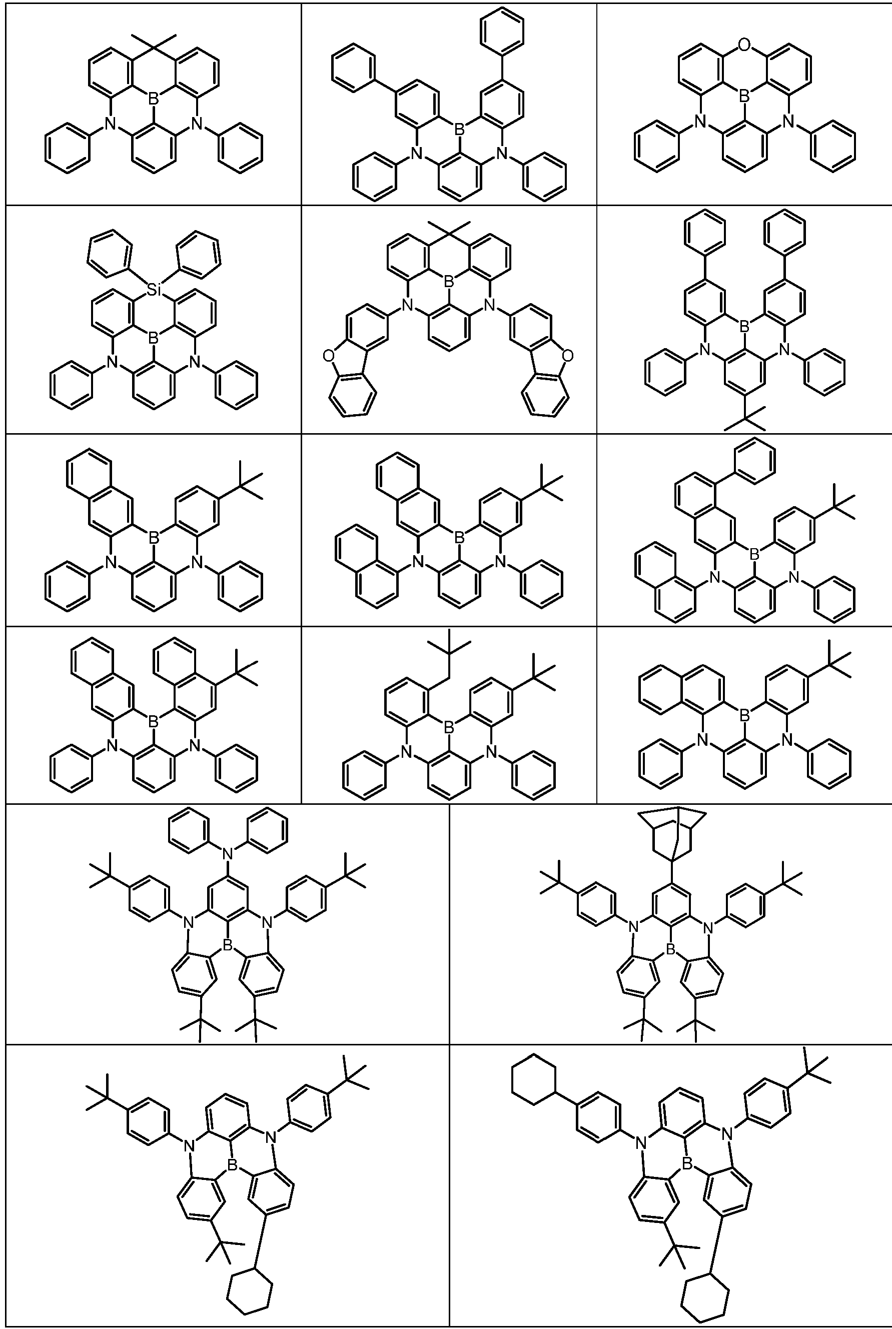

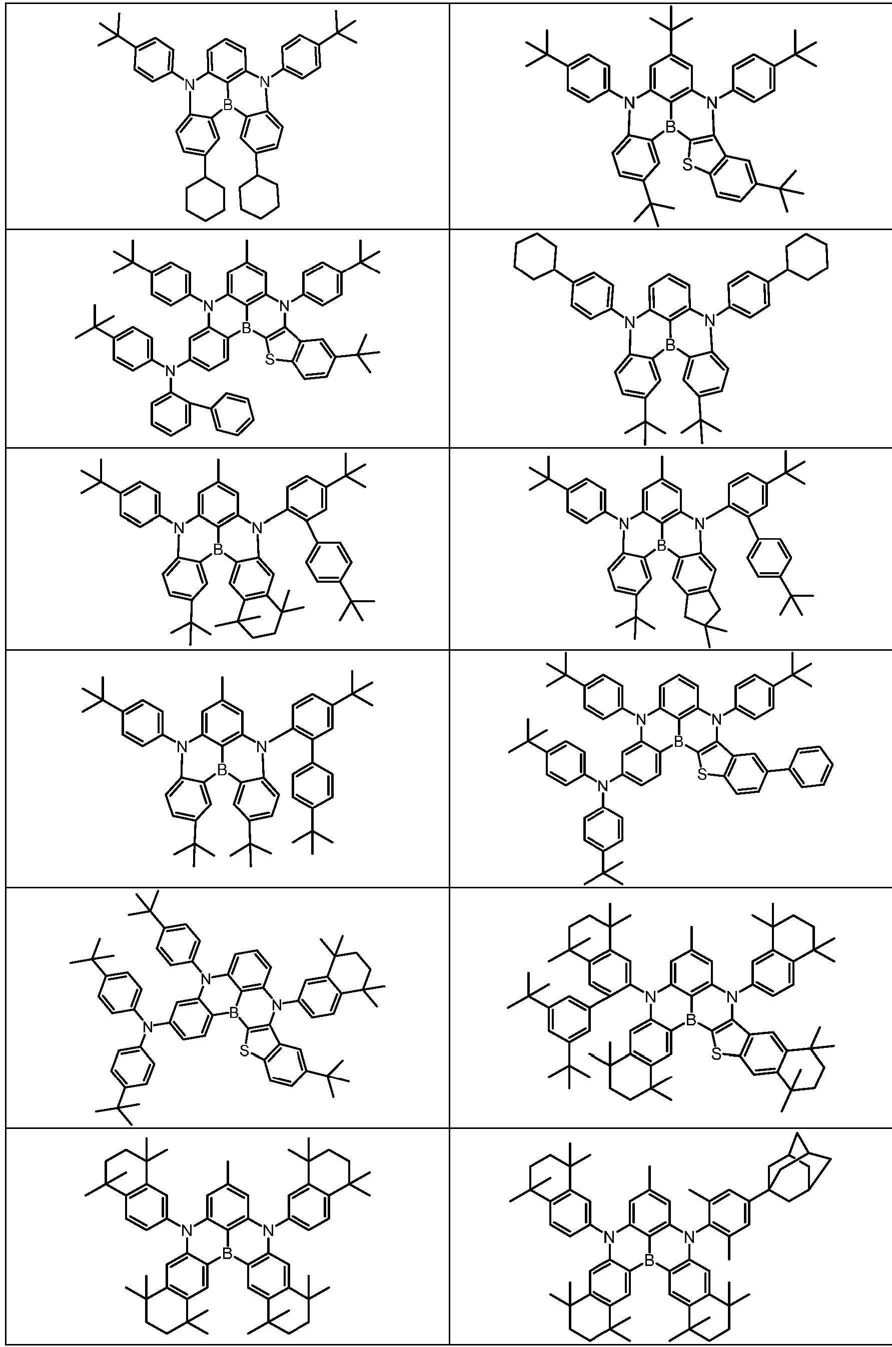

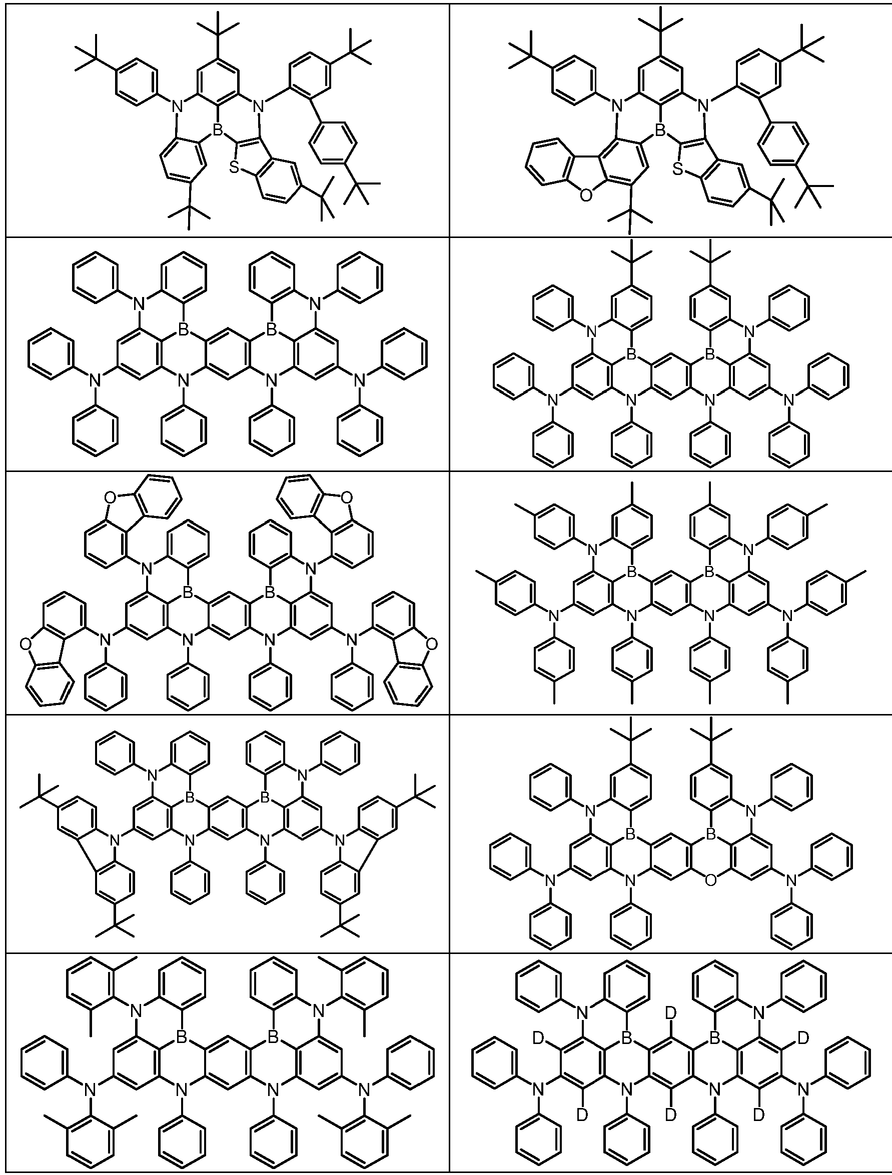

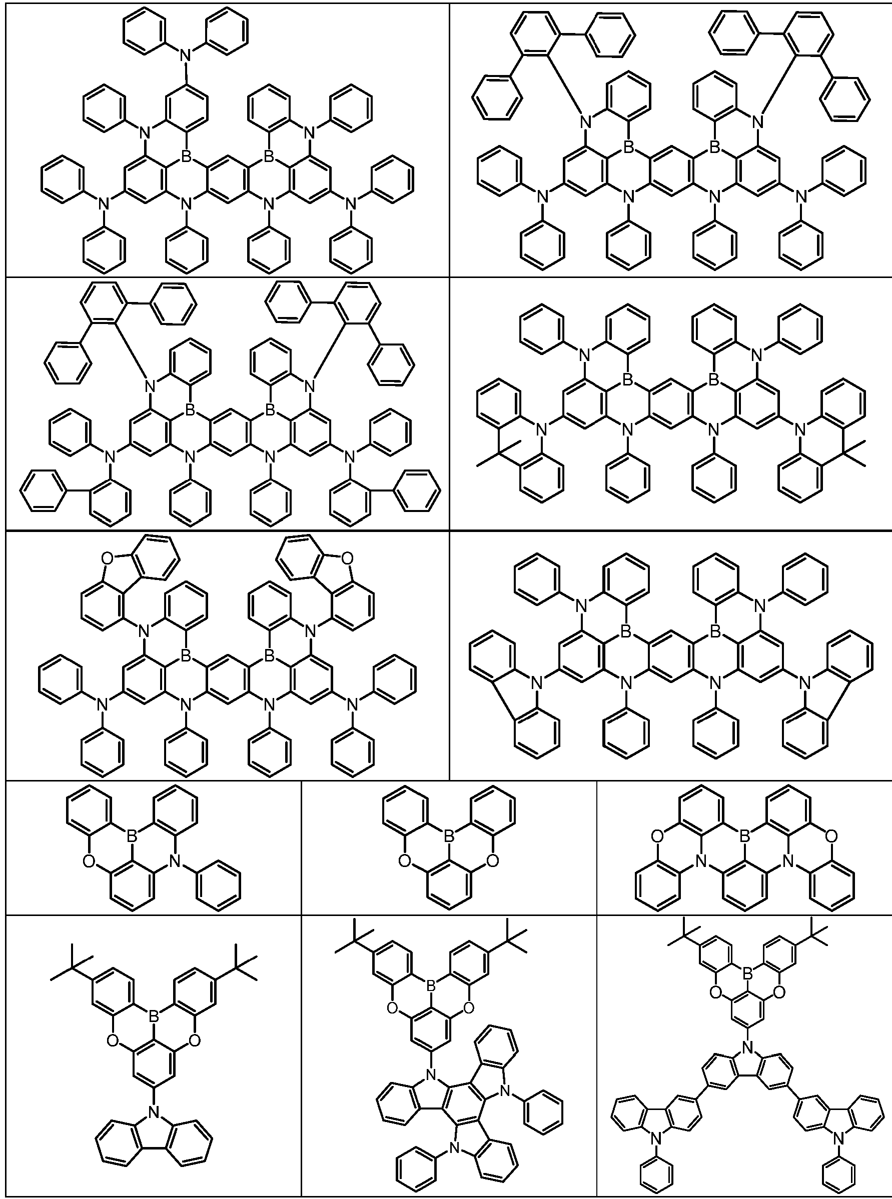

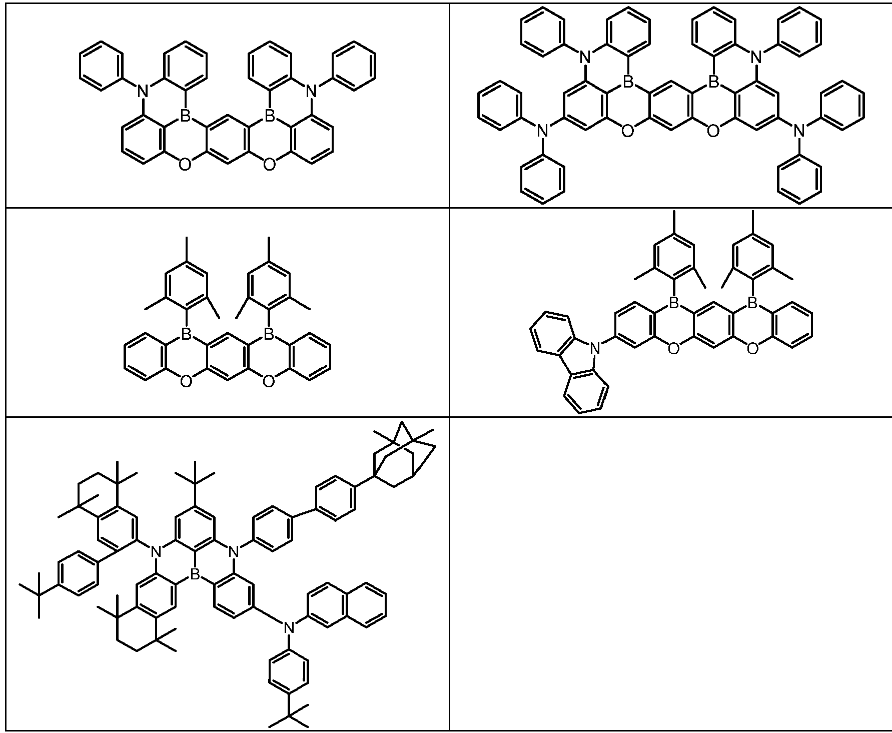

Geeignete Ladungstransportmaterialien, wie sie in der Lochinjektions- oder Lochtransportschicht oder in der Elektronen-/Exzitonenblockierschicht oder in der Elektronentransportschicht des erfindungsgemäßen elektronischen Bauelements verwendet werden können, sind neben den Verbindungen der Formel (1) zum Beispiel die in Y. Shirota et al., Chem. Rev. 2007, 107(4), 953-1010, oder andere Materialien, wie sie in diesen Schichten gemäß dem Stand der Technik verwendet werden.

Als Materialien für die Löchertransportschicht können alle Materialien verwendet werden, die nach dem Stand der Technik als Lochtransportmaterialien in der Lochtransportschicht eingesetzt werden. Es können aromatische Aminverbindungen eingesetzt werden. Weitere Verbindungen, die vorzugsweise in löchertransportierenden Schichten der erfindungsgemäßen OLEDs eingesetzt werden, sind insbesondere Indenofluorenam in-Derivate (z.B. nach WO 2006/122630 oder WO 2006/100896), die in EP 1661888 offenbarten Aminderivate, Hexaazatriphenylen-Derivate (z.B. nach WO 01/049806), Aminderivate mit anellierten Aromaten (zum Beispiel nach US 5,061,569), die in WO 95/09147 offenbarten Aminderivate, Monobenzoindenofluorenamine (zum Beispiel nach WO 08/006449), Dibenzoindenofluorenamine (zum Beispiel nach WO 07/140847), Spirobifluorenamine (zum Beispiel nach WO 2012/034627 oder WO 2013/120577), Fluorenamine (zum Beispiel nach WO 2014/015937, WO 2014/015938, WO 2014/015935 und WO 2015/082056), Spirodibenzopyranamine (zum Beispiel gemäß WO 2013/083216), Dihydroacridin-Derivate (zum Beispiel gemäß WO 2012/150001), Spirodibenzofurane und Spirodibenzothiophene (zum Beispiel nach WO 2015/022051, WO 2016/102048 und WO 2016/131521), Phenanthrendiarylamine (zum Beispiel nach WO 2015/131976), Spirotribenzotropolone (zum Beispiel gemäß WO 2016/087017), Spirobifluorene mit meta-Phenyldiamingruppen (zum Beispiel gemäß WO 2016/078738), Spirobisacridine (zum Beispiel gemäß WO 2015/158411), Xanthendiarylamine (zum Beispiel gemäß WO 2014/072017), und 9,10-Dihydroanthracen-Spiroverbindungen mit Diarylaminogruppen gemäß WO 2015/086108.

Ganz besonders bevorzugt ist die Verwendung von durch Diarylaminogruppen in 4-Position substituierten Spirobifluorenen als löchertransportierende Verbindungen, insbesondere die Verwendung derjenigen Verbindungen, die in WO 2013/120577 offenbart sind, und die Verwendung von durch Diarylaminogruppen in 2-Position substituierten Spirobifluorenen als löchertransportierende Verbindungen, insbesondere die Verwendung derjenigen Verbindungen, die in WO 2012/034627 offenbart sind.

Vorzugsweise umfasst die erfindungsgemäße OLED zwei oder mehr verschiedene elektronentransportierende Schichten. Verbindungen, die in diesen Schichten verwendet werden können, sind alle Materialien, die nach dem Stand der Technik als Elektronentransportmaterialien in der Elektronentransportschicht eingesetzt werden. Besonders geeignet sind Aluminiumkomplexe, z.B. Alq₃, Zirkoniumkomplexe, z.B. Zrq₄, Lithiumkomplexe, z.B. Liq, Benzimidazol-Derivate, Triazin-Derivate, Pyrimidin-Derivate, Pyridin-Derivate, Pyrazin-Derivate, Chinoxalin-Derivate, Chinolin-Derivate, Oxadiazol-Derivate, aromatische Ketone, Lactame, Borane, Diazaphosphol-Derivate und Phosphinoxid-Derivate. Weitere geeignete Materialien sind Derivate der vorgenannten Verbindungen, wie sie in JP 2000/053957, WO 2003/060956, WO 2004/028217, WO 2004/080975 und WO 2010/072300 offenbart sind.

Die Vorrichtung wird entsprechend (je nach Anwendung) strukturiert, kontaktiert und abschließend versiegelt, um schädliche Einflüsse durch Wasser und Luft auszuschließen.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen gemäß Formel (1) bzw. den oben ausgeführten bevorzugten Ausführungsformen einsetzen.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Die erfindungsgemäßen Verbindungen und die erfindungsgemäßen organischen Elektrolumineszenzvorrichtungen zeichnen sich durch eine siginifikant verbesserte Lebensdauer aus im Vergleich zu OLEDs, welche die entsprechenden undeuterierten Verbindungen enthalten, während die anderen Deviceparameter unverändert gut sind.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße Verbindungen herstellen und diese in elektronischen Vorrichtungen verwenden bzw. das erfindungsgemäße Verfahren anwenden.

### Beispiele:

Die nachfolgenden Synthesen werden, sofern nicht anders angegeben, unter einer Schutzgasatmosphäre in getrockneten Lösungsmitteln durchgeführt. Die Lösungsmittel und Reagenzien können von ALDRICH bzw. ABCR bezogen werden.

### 1) Synthese der Synthone:

### Synthon S1:

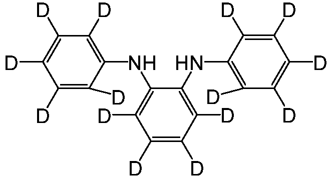

Ein gut gerührtes Gemisch aus 19.3 g (100 mmol) N¹-(Phenyl-2,3,4,5,6-d₅)-1,2-phenylen-3,4,5,6-d₄-diamin [1643792-54-4], 16.2 g (100 mmol) Brombenzol-d₅ [4165-57-5], 65.2 g (200 mmol) Caesiumcarbonat, 411 mg (1 mmol) S-Phos [657408-07-6], 224 mg (1 mmol) Palladium(II)acetat, 300 g Glaskugeln (3 mm Durchmesser) und 500 ml Toluol wird 12 h bei 70 °C gerührt. Nach Erkalten versetzt man mit 200 ml ges. Ammoniumchlorid-Lösung und dann vorsichtig mit 40 ml Essigsäure (Schäumen!). Man rührt kurz nach, trennt die wässrige Phase ab, wäscht die org. Phase zweimal mit je 200 ml ges. Kochsalz-Lösung, trocknet über Magnesiumsulfat, filtriert von diesem ab und engt das Filtrat zur Trockene ein. Man nimmt das Rohprodukt in 200 ml Dichlormethan (DCM) auf und chromatographiert mit DCM an 300 g Kieselgel. Das so erhaltene Produkt wird abschließend noch mit 100 ml Ethanol ausgerührt. Ausbeute: 25.2 g (92 mmol), 92 %, Reinheit: > 99 % n. HPLC.

Analog können die folgenden Verbindungen unter Anpassung der Stöchiometrie dargestellt werden.

| Bsp. | Edukte | Produkt |
|---|---|---|
| S2 | 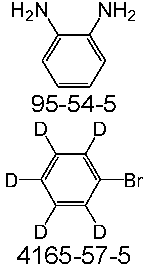 | 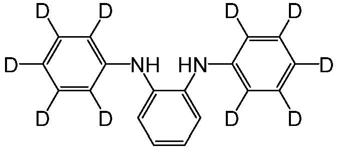 |
| S3 | 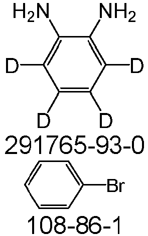 | 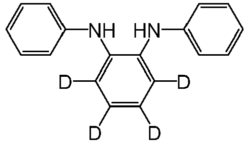 |
| S4 | 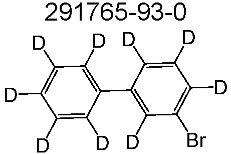 | 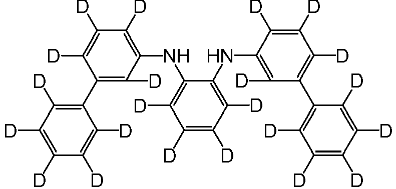 |
| S5 | 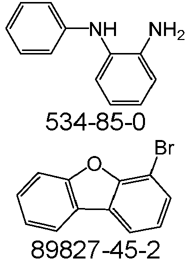 | 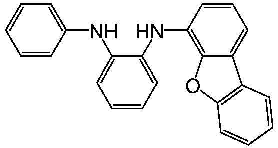 |

### Beispiel S100-D30%:

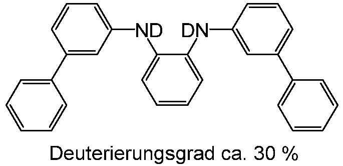

Ein Rührautoklav wird mit 41.3 g (100 mmol) *N*¹,*N*²-Bis([1,1'-biphenyl]-3-yl)-1,2-benzoldiamin [1225231-02-6], 182 ml (10 mol) D₂O, Deuterierungsgrad > 99 %, 800 ml Cyclohexan und 40 g Pt/C (Platin auf Kohle, trocken) beschickt, durch zweimaliges Aufpressen und Entspannen von 5 bar Stickstoff und einmaliges Aufpressen und Entspannen von 30 bar Stickstoff entgast und für 4 h bei 110 °C mit einem Schrägblattrüher mit 1000 U/min gerührt. Man lässt den Rührautoklaven erkalten, entnimmt die Reaktionsmischung, filtriert den Katalysator ab und trennt die Cyclohexanphase ab. Der Katalysator wird mit THF nachgewaschen und anschließend mit heißem THF extrahiert, bis er kein Produkt mehr enthält. Die vereinigten organischen Phasen werden unter reduziertem Druck am Rotationsverdampfer (p ca. 20 mbar, T ca. 60 °C) zur Trockene eingeengt. Das so erhaltene Produkt wird abschließend noch mit 100 ml Methanol-d1 ausgerührt. Ausbeute: 37.7 g (90 mmol), 90 %, Reinheit: > 99 % n. HPLC, Deuterierungsgrad ca. 30 % n. MS.

Analog können die folgenden Verbindungen dargestellt werden.

| Bsp. | Edukt Reaktionszeit | Produkt |
|---|---|---|
| S100-D50 % | 1225231-02-6 | 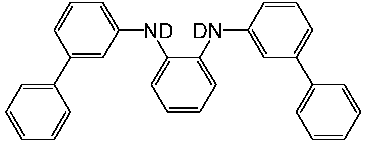 Deuterierungsgrad ca. 50 % |
| | 8 h | |
| S100-D80 % | 1225231-02-6 | 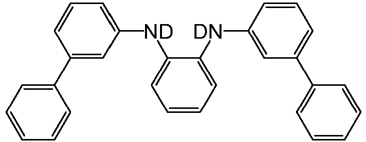 Deuterierungsgrad ca. 80 % |
| | 18 h | |
| S101-D50 % | 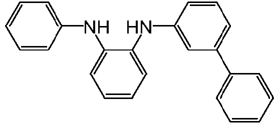 2773945-46-1 | 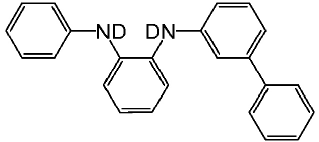 Deuterierungsgrad ca. 50 % |
| | 8h | |
| S102-D50 % | 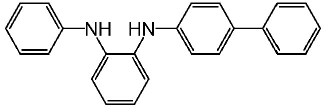 1227269-56-8 | 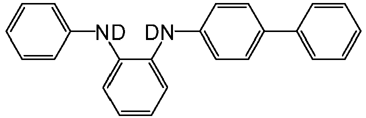 Deuterierungsgrad ca. 50 % |
| | 8h | |
| S103-D70 % | 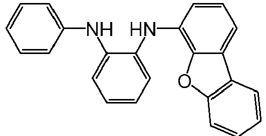 S5 | 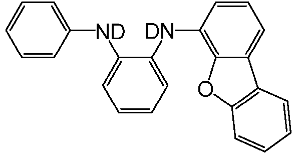 Deuterierungsgrad ca. 70 % |
| | 14h | |
| S104-D65 % | 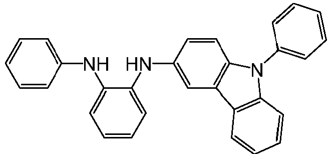 2226920-05-2 | 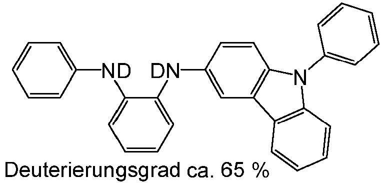 |
| | 12h | |
| S105-D65 % | 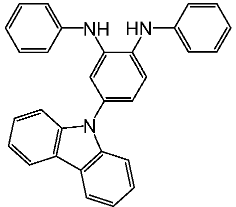 1531602-15-9 | 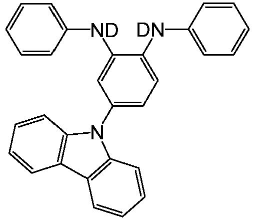 Deuterierungsgrad ca. 65 % |
| | 12h | |

### 2) Synthese der erfindungsgemäßen Verbindungen B und der Referenzverbindungen H:

### Beispiel B1:

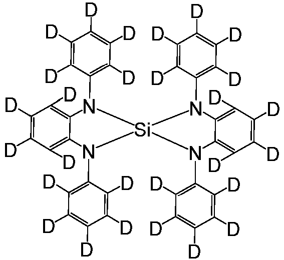

Ein gut gerührtes, auf 0 °C gekühltes Gemisch aus 54.9 g (200 mmol) **S1** in 1200 ml Diethylether wird tropfenweise über 20 min. mit 37.3 ml (400 mmol) n-Butyllithium, 10.6 M in n-Hexan, versetzt und dann 10 min. nachgerührt. Anschließend versetzt man tropfenweise während 30 min. mit 11.5 ml (100 mmol) Siliciumtetrachlorid [10026-04-7] und lässt dann unter Rühren auf Raumtemperatur erwärmen. Nach 16 h entfernt man alle flüchtigen Anteile im Vakuum, nimmt den Rückstand in 1200 ml Dichlormethan (DCM) auf, filtriert über eine mit DCM vorgeschlämmte Kieselgelsäule (300 g Kieselgel, 15 cm Durchmesser), wäscht mit 300 ml DCM nach und engt das Eluat im Vakuum zur Trockene ein. Man nimmt das Rohprodukt in 150 ml DCM auf und tropft die Lösung unter gutem Rühren langsam bei Raumtemperatur in 600 ml Ethanol ein. Man rührt 5 h nach, saugt vom auskristallisierten Feststoff ab und trocknet diesen im Vakuum. Die Kristallisation wird noch zweimal mit Ethanol und dann dreimal mit 600 ml Acetonitril wiederholt. Abschließend wird das Produkt zweimal fraktioniert im Hochvakuum (p ~ 10⁻⁵ mbar, T - 220 - 230 °C) sublimiert. Ausbeute: 30.4 g (53 mmol), 53 %, Reinheit: > 99.9 % n. HPLC.

Analog können die folgenden Verbindungen dargestellt werden:

| Bsp. | Edukt | Produkt |
|---|---|---|
| B2 | S2 | 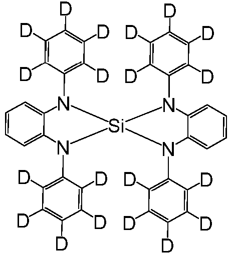 |
| B3 | S3 | 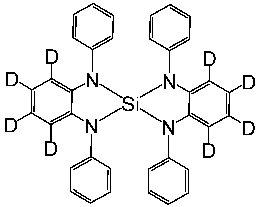 |
| B4 | S4 | 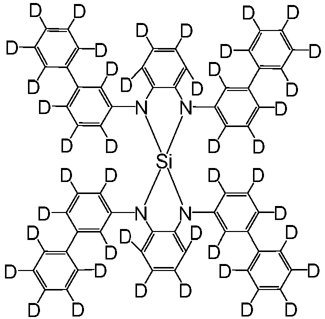 |
| B100 | S100-D30% | 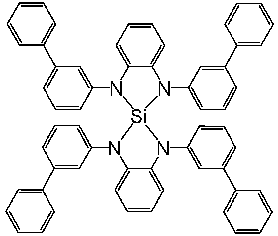 Deuterierungsgrad ca. 30 % |
| B101 | S100-D50% | 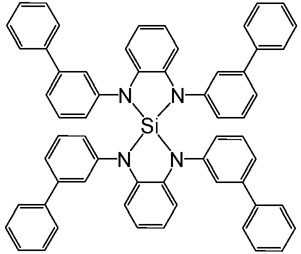 Deuterierungsgrad ca. 50 % |
| B102 | S100-D80% | 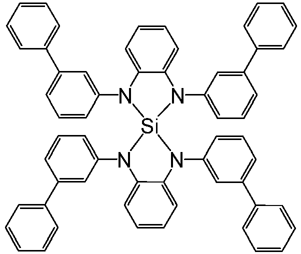 Deuterierungsgrad ca. 80 % |
| B103 | S101-D50% | 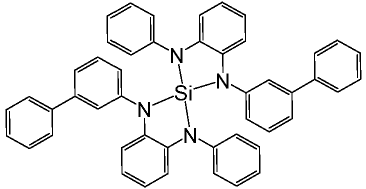 Deuterierungsgrad ca. 50 % |
| B104 | S102-D50% | 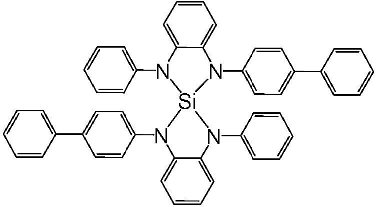 Deuterierungsgrad ca. 50 % |
| B105 | S103-D70% | 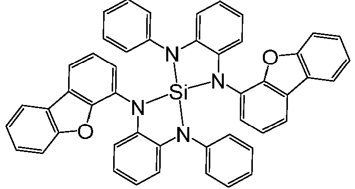 Deuterierungsgrad ca. 70 % |
| B106 | S104-D65% | 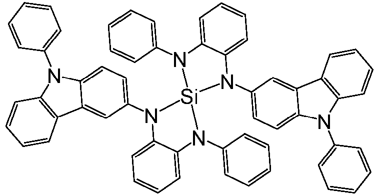 Deuterierungsgrad ca. 65 % |
| B107 | S105-D65% | 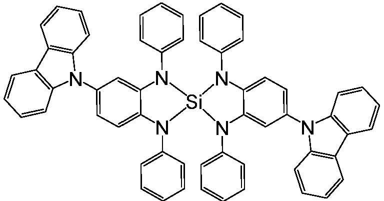 Deuterierungsgrad ca. 65 % |
| H3 | 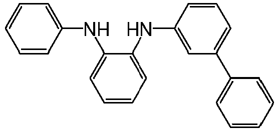 2773945-46-1 | 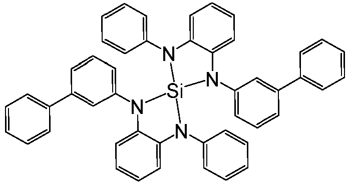 |
| H4 | 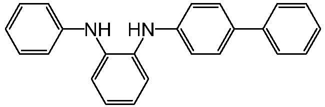 1227269-56-8 | 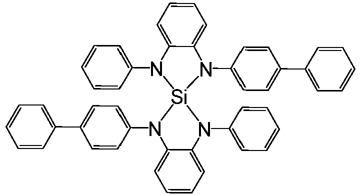 |
| H5 | 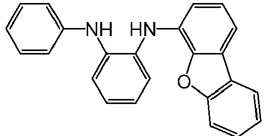 S5 | 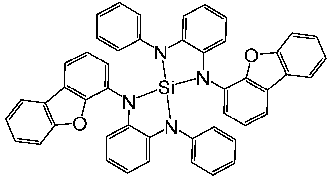 |
| H6 | 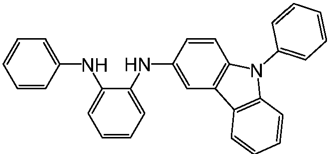 2226920-05-2 | 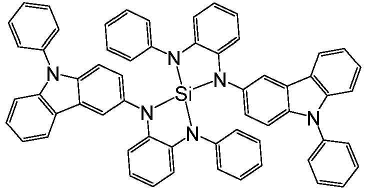 |
| H7 | 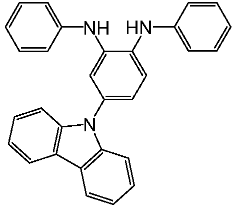 1531602-15-9 | 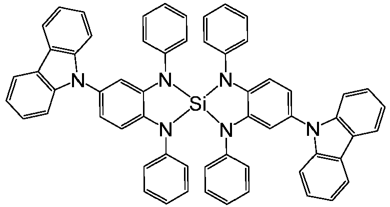 |

### OLED-Beispiele

Die Herstellung von OLEDs wurde bereits mehrfach in der Literatur beschrieben, z. B. in WO 2004/058911. Das Verfahren ist an die nachfolgend beschriebenen Gegebenheiten, d.h. Schichtdickenvariation, Schichtfolgen und Materialien, angepasst. Im Folgenden werden Beispiele für OLED-Bauelemente gemäß bevorzugten Ausführungsformen der Erfindung beschrieben.

Alle beispielhaften OLED-Bauelemente sind durch den folgenden Schichtaufbau gekennzeichnet:
- Glasplatte (im Folgenden auch Glassubstrat oder Substrat),
- Indium-Zinn-Oxid (nachfolgend ITO) als Anode,
- Lochinjektionsschicht (nachfolgend HIL)
- Lochtransportschicht (nachfolgend HTL),
- Elektronenblockierschicht (nachfolgend EBL),
- Emissionsschicht (nachfolgend EML),
- Lochblockierschicht (nachfolgend HBL),
- Elektronentransportschicht (nachfolgend ETL),
- Elektroneninjektionsschicht (nachfolgend EIL),
- Aluminium (nachfolgend Kathode).

Die Glassubstrate mit dem strukturierten 50 nm dicken ITO werden mit einem Sauerstoffplasma, gefolgt von einem Argonplasma, vorbehandelt. Danach werden die Materialien für die HIL, HTL, EBL, EML, HBL, ETL und EIL durch thermisches Verdampfen in einer Vakuumkammer auf das vorbehandelte Glassubstrat aufgebracht. Ausführliche Informationen über die HIL, HTL, EBL, EML, HBL, ETL und EIL der OLED-Bauelemente sind in Tabelle 1 enthalten. Die in diesen Beispielen verwendeten Materialien sind in Tabelle 2 bzw. oben bei den Synthesebeispielen ("2. Synthese der erfindungsgemäßen Verbindungen B und der Referenzverbindungen H") aufgeführt. Die Kathode besteht aus einer Aluminiumschicht mit einer Dicke von 100 nm.

Gemäß einer Ausführungsform der Erfindung umfasst die EML ein lochtransportierendes Hostmaterial, ein elektronentransportierendes Hostmaterial und einen phosphoreszierendes Metallkomplex. Alle Materialien der EML werden mit einer bestimmten Abscheiderate parallel abgeschieden, d. h. durch Co-Verdampfung, um eine homogene, amorphe Mischung zu bilden. Die Abscheidungsrate der einzelnen Materialien kann so gewählt werden, dass jedes Material zu einem bestimmten Volumenanteil (Vol.-%) in der Mischung vorhanden ist. So wird beispielsweise die Zusammensetzung einer EML, die ein lochtransportierendes Hostmaterial (HH) mit 45 Vol.-%, ein elektronentransportierendes Hostmaterial (EH) mit 45 Vol.-% und ein phosphoreszierendes Metallkomplexmaterial (D) mit 10 Vol. % aufweist in Tabelle A als HH:EH:D (45%:45%:10%) bezeichnet. Diese Schreibweise eignet sich analog zur Beschreibung der Zusammensetzung einer EML, die zwei oder vier verschiedene Materialien umfasst und auch für HIL, HTL, EBL, HBL, ETL und EIL des OLED-Bauelements, falls diese Schichten jeweils mehr als ein Material umfassen.

Die Performance der OLED-Bauelemente kann mit Standardmethoden gemessen werden. Zu diesem Zweck können die Elektrolumineszenzspektren (EL) und die externe Quanteneffizienz (EQE) aus Strom/Spannung/Leuchtdichte-Kennlinien (I-U-L-Kennlinien) unter Annahme eines Lambertschen Emissionsprofils bestimmt werden. Die EL-Spektren können bei einer Leuchtdichte von 1000 cd/m² aufgenommen und die CIE 1931 x- und y-Koordinaten aus dem EL-Spektrum berechnet werden. Die Lebensdauer LT90 ist definiert als die Zeit, nach der die Leuchtdichte im Laufe des Betriebs bei einer konstanten Stromdichte von 5 mA/cm² auf 90 % der Ausgangsleuchtdichte abfällt. In Tabelle 1 ist die Lebensdauer LT90 als relative Lebensdauer (rel. LT) gezeigt, wobei die Lebensdauer LT90 des jeweiligen Referenz-Bauteils Ref. auf 100% rel. LT gesetzt wird.

Die folgenden Ausführungsbeispiele entsprechen einer bevorzugten Ausführungsform der Erfindung.

**Beispiele 1 bis 12:** Die EML umfasst ein lochtransportierendes Hostmaterial H1, ein elektronentransportierendes Hostmaterial E1 und einen phosphoreszierenden Metallkomplex D1. Diese OLEDs können mit den jeweiligen Referenz-OLEDs gemäß den Beispielen Ref.1 bis Ref.6 aus Tabelle 1 verglichen werden. Die Vorrichtungen unterscheiden sich hinsichtlich des lochtransportierenden Hostmaterials, das in der jeweiligen EML verwendet wird, d.h. H1 bis H7 im Fall von Ref.1 bis 7 bzw. die erfindungsgemäßen Materialien B gemäß der aufgeführten Bsp. 1 bis 12. Die OLED-Bauelemente enthaltend die erfindungsgemäßen Materialien B weisen eine signifikant bessere relative Lebensdauer rel. LT auf als die jeweils korrespondierende Referenz-OLED, welche das entsprechende undeuterierte Material enthält.

**Tabelle 1: Aufbau und Ergebnisse der OLEDs**

| Bsp. | HIL [nm] | HTL [nm] | EBL [nm] | EML [nm] | HBL [nm] | ETL [nm] | EIL [nm] | Rel. LT [%] |
|---|---|---|---|---|---|---|---|---|
| Ref.1 | HTM:PD (95%:5%) 20nm | HTM 150nm | EBM 20nm | H1:E1:D1 (45%:45%: 10%) 30nm | E1 10nm | ETM:LiQ (50%:50%) 30nm | LiQ 1nm | 100 |
| 1 | HTM:PD (95%:5%) 20nm | HTM 150nm | EBM 20nm | B100:E1:D1 (45%:45%: 10%) 30nm | E1 10nm | ETM:LiQ (50%:50%) 30nm | LiQ 1nm | 116 |
| 2 | HTM:PD (95%:5%) 20nm | HTM 150nm | EBM 20nm | B101:E1:D1 (45%:45%: 10%) 30nm | E1 10nm | ETM:LiQ (50%:50%) 30nm | LiQ 1nm | 127 |
| 3 | HTM:PD (95%:5%) 20nm | HTM 150nm | EBM 20nm | B102:E1:D1 (45%:45%: 10%) 30nm | E1 10nm | ETM:LiQ (50%:50%) 30nm | LiQ 1nm | 135 |
| 4 | HTM:PD (95%:5%) 20nm | HTM 150nm | EBM 20nm | B4:E1:D1 (45%:45%: 10%) 30nm | E1 10nm | ETM:LiQ (50%:50%) 30nm | LiQ 1nm | 148 |
| Ref.2 | HTM:PD (95%:5%) 20nm | HTM 150nm | EBM 20nm | H2:E1:D1 (45%:45%: 10%) 30nm | E1 10nm | ETM:LiQ (50%:50%) 30nm | LiQ 1nm | 100 |
| 5 | HTM:PD (95%:5%) 20nm | HTM 150nm | EBM 20nm | B1:E1:D1 (45%:45%: 10%) 30nm | E1 10nm | ETM:LiQ (50%:50%) 30nm | LiQ 1nm | 141 |
| 6 | HTM:PD (95%:5%) 20nm | HTM 150nm | EBM 20nm | B2:E1:D1 (45%:45%: 10%) 30nm | E1 10nm | ETM:LiQ (50%:50%) 30nm | LiQ 1nm | 112 |
| 7 | HTM:PD (95%:5%) 20nm | HTM 150nm | EBM 20nm | B3:E1:D1 (45%:45%: 10%) 30nm | E1 10nm | ETM:LiQ (50%:50%) 30nm | LiQ 1nm | 124 |
| Ref.3 | HTM:PD (95%:5%) 20nm | HTM 150nm | EBM 20nm | H3:E1:D1 (45%:45%: 10%) 30nm | E1 10nm | ETM:LiQ (50%:50%) 30nm | LiQ 1nm | 100 |
| 8 | HTM:PD (95%:5%) 20nm | HTM 150nm | EBM 20nm | B103:E1:D1 (45%:45%: 10%) 30nm | E1 10nm | ETM:LiQ (50%:50%) 30nm | LiQ 1nm | 126 |
| Ref.4 | HTM:PD (95%:5%) 20nm | HTM 150nm | EBM 20nm | H4:E1:D1 (45%:45%: 10%) 30nm | E1 10nm | ETM:LiQ (50%:50%) 30nm | LiQ 1nm | 100 |
| 9 | HTM:PD (95%:5%) 20nm | HTM 150nm | EBM 20nm | B104:E1:D1 (45%:45%: 10%) 30nm | E1 10nm | ETM:LiQ (50%:50%) 30nm | LiQ 1nm | 134 |
| Ref.5 | HTM:PD (95%:5%) 20nm | HTM 150nm | EBM 20nm | H5:E1:D1 (45%:45%: 10%) 30nm | E1 10nm | ETM:LiQ (50%:50%) 30nm | LiQ 1nm | 100 |
| 10 | HTM:PD (95%:5%) 20nm | HTM 150nm | EBM 20nm | B105:E1:D1 (45%:45%: 10%) 30nm | E1 10nm | ETM:LiQ (50%:50%) 30nm | LiQ 1nm | 132 |
| Ref.6 | HTM:PD (95%:5%) 20nm | HTM 150nm | EBM 20nm | H6:E1:D1 (45%:45%: 10%) 30nm | E1 10nm | ETM:LiQ (50%:50%) 30nm | LiQ 1nm | 100 |
| 11 | HTM:PD (95%:5%) 20nm | HTM 150nm | EBM 20nm | B106:E1:D1 (45%:45%: 10%) 30nm | E1 10nm | ETM:LiQ (50%:50%) 30nm | LiQ 1nm | 129 |
| Ref.7 | HTM:PD (95%:5%) 20nm | HTM 150nm | EBM 20nm | H7:E1:D1 (45%:45%: 10%) 30nm | E1 10nm | ETM:LiQ (50%:50%) 30nm | LiQ 1nm | 100 |
| 12 | HTM:PD (95%:5%) 20nm | HTM 150nm | EBM 20nm | B107:E1:D1 (45%:45%: 10%) 30nm | E1 10nm | ETM:LiQ (50%:50%) 30nm | LiQ 1nm | 130 |

**Tabelle 2: Strukturformeln der OLED-Materialien**

| | |
|---|---|
| 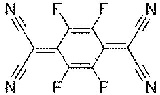 | 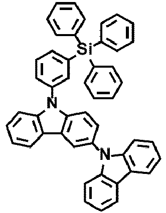 |
| PD | EBM |
| 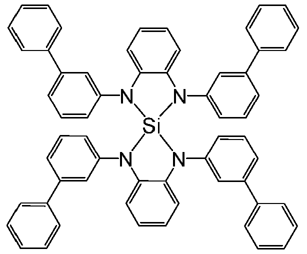 1225231-09-3 | 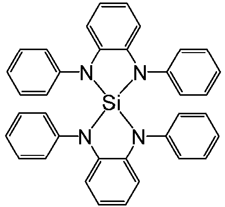 1206465-62-4 |
| H1 | H2 |
| 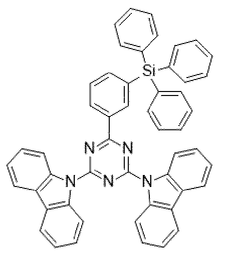 | 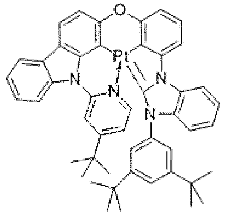 |
| E-1 | D-1 |
| 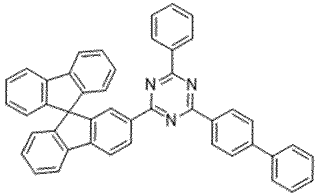 | 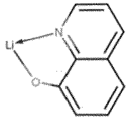 |
| ETM | LiQ |

## Patentansprüche

1. Verbindung gemäß Formel (1), 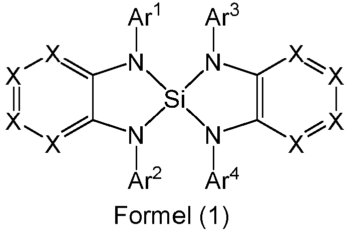 wobei für die verwendeten Symbole gilt:
X ist bei jedem Auftreten gleich oder verschieden CR oder N, mit der Maßgabe, dass nicht mehr als zwei X pro Cyclus für N stehen;
Ar¹, Ar², Ar³, Ar⁴ ist bei jedem Auftreten gleich oder verschieden ein aromatisches oder heteroaromatisches Ringsystem mit 5 bis 40 aromatischen Ringatomen, das durch einen oder mehrere Reste R substituiert sein kann;
R ist bei jedem Auftreten gleich oder verschieden H, D, F, Cl, Br, I, OR¹, SR¹, B(OR¹)₂, CHO, C(=O)R¹, CR¹=C(R¹)₂, CN, C(=O)OR¹, C(=O)NR¹, Si(R¹)₃, Ge(R¹)₃, NO₂, P(=O)(R¹)₂, OSO₂R¹, OR¹, N(R¹)₂, S(=O)R¹, S(=O)₂R¹, SR¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch - R¹C=CR¹- , -C≡C-, Si(R¹)₂, CONR¹, C=O, C=S, -C(=O)O-, P(=O)(R¹), -O-, -S-, SO oder SO₂ ersetzt sein können, oder ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann; dabei können zwei oder mehrere Reste R miteinander ein Ringsystem bilden;
R¹ ist bei jedem Auftreten gleich oder verschieden H, D, F, Cl, Br, I, B(OR²)₂, CHO, C(=O)R², CR²=C(R²)₂, CN, C(=O)OR², Si(R²)₃, Ge(R²)₃, NO₂, P(=O)(R²)₂, OSO₂R², SR², S(=O)R², S(=O)₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere CH₂-Gruppen in den oben genannten Gruppen durch -R²C=CR²-, -C=C-, Si(R²)₂, C=O, C=S, -C(=O)O-, CONR², P(=O)(R²), -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R² substituiert sein kann, wobei zwei oder mehr Reste R¹ miteinander ein Ringsystem bilden können;
R² ist bei jedem Auftreten gleich oder verschieden H, D, F, CN oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden;
**dadurch gekennzeichnet, dass** die Verbindung zu mindestens 20 % deuteriert ist.

2. Verbindung nach Anspruch 1, **dadurch gekennzeichnet, dass** der Deuterierungsgrad der Verbindung bei 30 bis 95 % liegt.

3. Verbindung nach Anspruch 1 oder 2, ausgewählt aus den Verbindungen der Formeln (2), (3) oder (4), 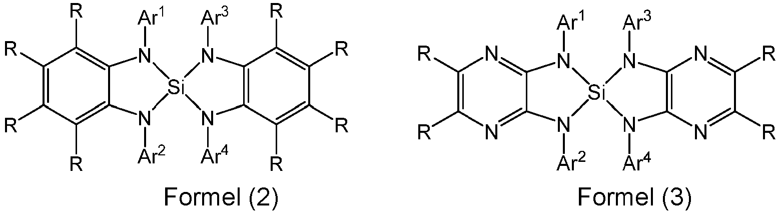 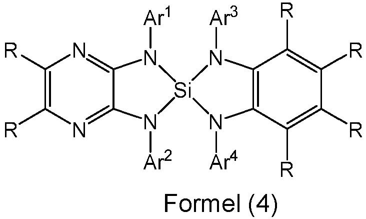 wobei die Symbole die in Anspruch 1 genannten Bedeutungen aufweisen.

4. Verbindung nach einem oder mehreren der Ansprüche 1 bis 3, ausgewählt aus den Verbindungen der Formeln (2a) bis (2f), 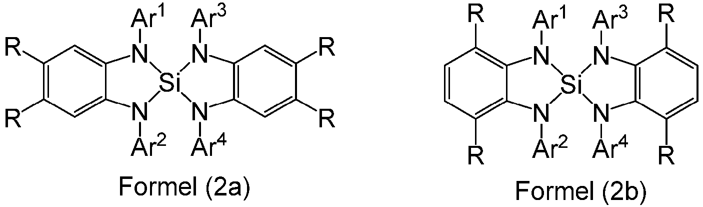 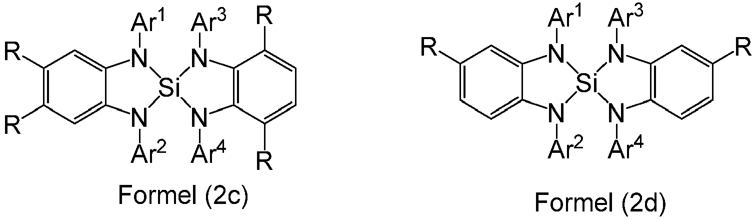 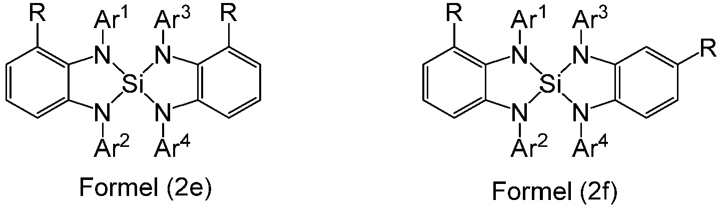 wobei die als unsubstituiert dargestellten Kohlenstoffatome auch teilweise oder vollständig deuteriert sein können, und Ar¹ bis Ar⁴ und R die in Anspruch 1 genannten Bedeutungen aufweisen.

5. Verbindung nach einem oder mehreren der Ansprüche 1 bis 4, **dadurch gekennzeichnet, dass** für Ar¹ bis Ar⁴ gilt:
Ar¹ = Ar² = Ar³ = Ar⁴;
Ar¹ = Ar² und Ar³ = Ar⁴, aber Ar¹ ≠ Ar³;
Ar¹ = Ar³ und Ar² = Ar⁴, aber Ar¹ ≠ Ar²;
Ar¹ = Ar² = Ar³ und Ar⁴ ≠ Ar¹;
Ar¹ = Ar² und Ar³ ≠ Ar⁴ ≠ Ar¹;
Ar¹ = Ar³ und Ar² ≠ Ar⁴ ≠ Ar¹; oder
Ar¹ ≠ Ar² ≠ Ar³ ≠ Ar⁴.

6. Verbindung nach einem oder mehreren der Ansprüche 1 bis 5, **dadurch gekennzeichnet, dass** mindestens eine der Gruppen Ar¹ bis Ar⁴ mindestens 12 aromatische Ringatome enthält.

7. Verbindung nach einem oder mehreren der Ansprüche 1 bis 6, **dadurch gekennzeichnet, dass** Ar¹ bis Ar⁴ gleich oder verschieden bei jedem Auftreten ausgewählt sind aus Phenyl, Biphenyl, Terphenyl, Quaterphenyl, Fluoren, Spirobifluoren, Naphthalin, Indol, Benzofuran, Benzothiophen, Dibenzofuran, Carbazol, Dibenzothiophen, Indenocarbazol, Indolocarbazol, Pyridin, Pyrimidin, Pyrazin, Pyridazin, Triazin, Chinolin, Chinazolin, Benzimidazol, Benzimidazobenzimidazol, Phenanthren oder Triphenylen, welche jeweils mit einem oder mehreren Resten R substituiert sein können und wobei diese Strukturen auch teilweise oder vollständig deuteriert sein können.

8. Verbindung nach einem oder mehreren der Ansprüche 1 bis 7, **dadurch gekennzeichnet, dass** die Substituenten R, die an Ar¹ bis Ar⁴ gebunden sind, bei jedem Auftreten gleich oder verschieden ausgewählt sind aus der Gruppe bestehend aus H, D, F, CN, Si(R¹)₃, Ge(R¹)₃, einer geradkettigen Alkylgruppe mit 1 bis 10 C-Atomen oder cyclischen Alkylgruppe mit 3 bis 10 C-Atomen, wobei die Alkylgruppe jeweils optional deuteriert und/oder mit einem oder mehreren Resten R¹ substituiert sein kann und wobei eine oder mehrere nicht benachbarte CH₂-Gruppen durch O ersetzt sein können; dabei können zwei benachbarte Reste R miteinander ein Ringsystem bilden;
und **dadurch gekennzeichnet, dass** die Substituenten R, die für X = CR an das Kohlenstoffatom binden, bei jedem Auftreten gleich oder verschieden ausgewählt sind aus der Gruppe bestehend aus H, D, F, CN, OR¹, N(R¹)₂, Si(R¹)₃, Ge(R¹)₃, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils optional deuteriert und/oder mit einem oder mehreren Resten R¹ substituiert sein kann, oder einem aromatischen oder heteroaromatischen Ringsystem mit 6 bis 30 aromatischen Ringatomen, das jeweils optional deuteriert und/oder durch einen oder mehrere Reste R¹ substituiert sein kann; dabei können zwei oder mehrere benachbarte Reste R miteinander ein Ringsystem bilden.

9. Verfahren zur Herstellung einer Verbindung nach einem oder mehreren der Ansprüche 1 bis 8, **gekennzeichnet durch** die folgenden Schritte:
(1) Bereitstellung eines teilweise oder vollständig deuterierten Benzolderivats oder entsprechenden heteroaromatischen Derivats, welches in ortho-Position zueinander mit einer Gruppe -NHAr¹ und -NHAr² substituiert ist und gegebenenfalls Bereitstellung eines teilweise oder vollständig deuterierten Benzolderivats oder entsprechenden heteroaromatischen Derivats, welches in ortho-Position zueinander mit einer Gruppe -NHAr³ und -NHAr⁴ substituiert ist; und
(2) Umsetzung von SiHal₄, wobei Hal für ein Halogen steht, mit dem teilweise oder vollständig deuterierten Benzolderivat oder entsprechenden heteroaromatischen Derivat, welches in ortho-Position zueinander mit einer Gruppe -NHAr¹ und und einer Gruppe -NHAr² substituiert ist, gegebenenfalls gefolgt von Umsetzung mit dem teilweise oder vollständig deuterierten Benzolderivat oder entsprechenden heteroaromatischen Derivat, welches in ortho-Position zueinander mit einer Gruppe -NHAr³ und einer Gruppe -NHAr⁴ substituiert ist.

10. Mischung, enthalten mindestens eine Verbindung nach einem oder mehreren der Ansprüche 1 bis 8 und mindestens eine weitere Verbindung.

11. Verwendung einer Verbindung nach einem oder mehreren der Ansprüche 1 bis 8 in einer elektronischen Vorrichtung.

12. Elektronische Vorrichtung enthaltend mindestens eine Verbindung nach einem oder mehreren der Ansprüche 1 bis 8.

13. Elektronische Vorrichtung nach Anspruch 12, wobei es sich um eine organische Elektrolumineszenzvorrichtung handelt, **dadurch gekennzeichnet, dass** die Verbindung nach einem oder mehreren der Ansprüche 1 bis 8 in einer Lochtransportschicht und/oder einer Excitonenblockierschicht und/oder als Matrixmaterial in einer emittierenden Schicht eingesetzt wird.

14. Elektronische Vorrichtung nach Anspruch 13, **dadurch gekennzeichnet, dass** die emittierende Schicht eine phosphoreszente oder hyperphosphoreszente Schicht ist.

15. Elektronische Vorrichtung nach Anspruch 14, **dadurch gekennzeichnet, dass** die emittierende Schicht einen blau phosphoreszenten Iridium- oder Platinkomplex als emittierenden Verbindung oder als Sensitizer enthält.

16. Elektronische Vorrichtung nach einem oder mehreren der Ansprüche 13 bis 15, **dadurch gekennzeichnet, dass** die Verbindung nach einem oder mehreren der Ansprüche 1 bis 8 als Matrixmaterial in Kombination mit einem elektronentransportierenden Matrixmaterial eingesetzt wird.

## Claims

1. Compound of formula (1) 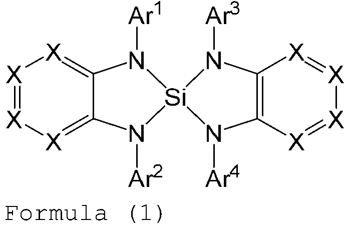 where the symbols used are as follows:
X is the same or different at each instance and is CR or N, with the proviso that not more than two X per cycle are N;
Ar¹, Ar², Ar³, Ar⁴ are the same or different at each instance and are an aromatic or heteroaromatic ring system which has 5 to 40 aromatic ring atoms and may be substituted by one or more R radicals;
R is the same or different at each instance and is H, D, F, Cl, Br, I, OR¹, SR¹, B(OR¹)₂, CHO, C(=O)R¹, CR¹=C(R¹)₂, CN, C(=O)OR¹, C(=O)NR¹, Si(R¹)₃, Ge(R¹)₃, NO₂, P(=O)(R¹)₂, OSO₂R¹, OR¹, N(R¹)₂, S(=O)R¹, S(=O)₂R¹, SR¹, a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals, where one or more nonadjacent CH₂ groups may be replaced by - R¹C=CR¹-, -C=C-, Si(R¹)₂, CONR¹, C=O, C=S, -C(=O)O-, P(=O)(R¹), -O-, -S-, SO or SO₂, or an aromatic or heteroaromatic ring system which has 5 to 60 aromatic ring atoms, preferably 5 to 40 aromatic ring atoms, and may be substituted in each case by one or more R¹ radicals; at the same time, two or more R radicals may form a ring system with one another;
R¹ is the same or different at each instance and is H, D, F, Cl, Br, I, B (OR²)₂, CHO, C(=O)R², CR²=C(R²)₂, CN, C(=O)OR², Si(R²)₃, Ge(R²)₃, NO₂, P(=O)(R²)₂, OSO₂R², SR², S(=O)R², S(=O)₂R², a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals and where one or more CH₂ groups in the abovementioned groups may be replaced by -R²C=CR²-, -C=C-, Si(R²)₂, C=O, C=S, -C(=O)O-, CONR², P(=O)(R²), -S-, SO or SO₂ and where one or more hydrogen atoms in the abovementioned groups may be replaced by D, F, Cl, Br, I, CN or NO₂, or an aromatic or heteroaromatic ring system which has 5 to 30 aromatic ring atoms and may be substituted in each case by one or more R² radicals, where two or more R¹ radicals may form a ring system with one another;
R² is the same or different at each instance and is H, D, F, CN or an aliphatic, aromatic or heteroaromatic organic radical having 1 to 20 carbon atoms, in which one or more hydrogen atoms may also be replaced by D or F;
at the same time, two or more R² substituents may be joined to one another and form a ring;
**characterized in that** the compound is at least 20% deuterated.

2. Compound according to Claim 1, **characterized in that** the degree of deuteration of the compound is 30% to 95%.

3. Compound according to Claim 1 or 2, selected from the compounds of the formulae (2), (3) and (4): 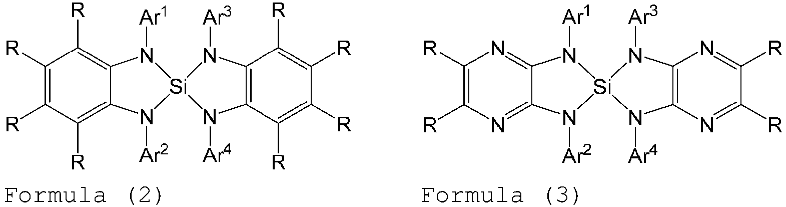 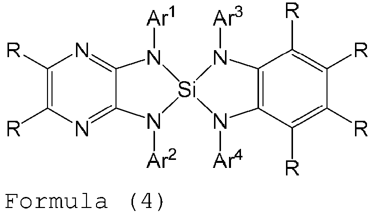 where the symbols have the definitions given in Claim 1.

4. Compound according to one or more of Claims 1 to 3, selected from the compounds of the formulae (2a) to (2f): 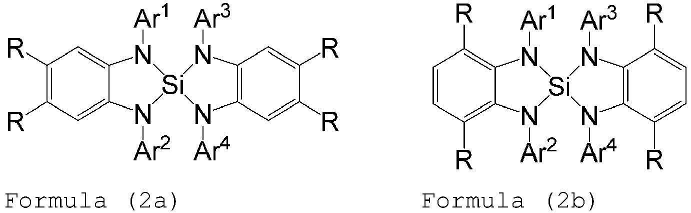 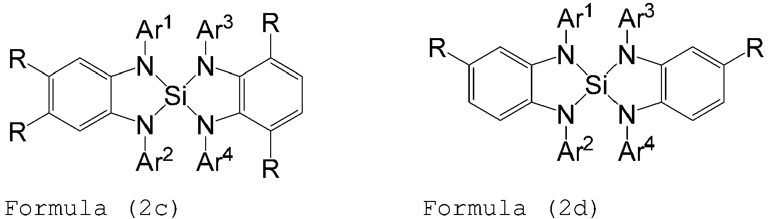 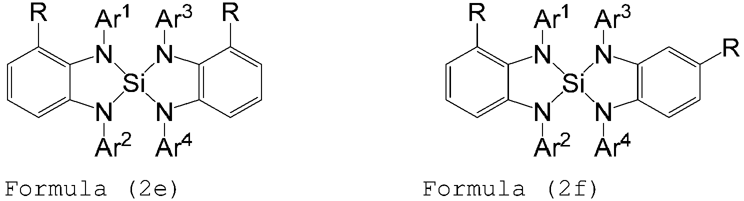 where the carbon atoms shown as unsubstituted may also be partly or fully deuterated, and Ar¹ to Ar⁴ and R have the meanings given in Claim 1.

5. Compound according to one or more of Claims 1 to 4, **characterized in that** Ar¹ to Ar⁴ are as follows:
Ar¹ = Ar² = Ar³ = Ar⁴;
Ar¹ = Ar² and Ar³ = Ar⁴, but Ar¹ ≠ Ar³;
Ar¹ = Ar³ and Ar² = Ar⁴, but Ar¹ ≠ Ar²;
Ar¹ = Ar² = Ar³ and Ar⁴ ≠ Ar¹;
Ar¹ = Ar² and Ar³ ≠ Ar⁴ ≠ Ar¹;
Ar¹ = Ar³ and Ar² ≠ Ar⁴ ≠ Ar¹; or
Ar¹ ≠ Ar² ≠ Ar³ ≠ Ar⁴.

6. Compound according to one or more of Claims 1 to 5, **characterized in that** at least one of the Ar¹ to Ar⁴ groups contains at least 12 aromatic ring atoms.

7. Compound according to one or more of Claims 1 to 6, **characterized in that** Ar¹ to Ar⁴ are the same or different at each instance and are selected from phenyl, biphenyl, terphenyl, quaterphenyl, fluorene, spirobifluorene, naphthalene, indole, benzofuran, benzothiophene, dibenzofuran, carbazole, dibenzothiophene, indenocarbazole, indolocarbazole, pyridine, pyrimidine, pyrazine, pyridazine, triazine, quinoline, quinazoline, benzimidazole, benzimidazobenzimidazole, phenanthrene or triphenylene, which may each be substituted by one or more R radicals, and where these structures may also be partly or fully deuterated.

8. Compound according to one or more of Claims 1 to 7, **characterized in that** the substituents R bonded to Ar¹ to Ar⁴ are the same or different at each instance and are selected from the group consisting of H, D, F, CN, Si(R¹)₃, Ge(R¹)₃, a straight-chain alkyl group having 1 to 10 carbon atoms or a cyclic alkyl group having 3 to 10 carbon atoms, where the alkyl group may in each case optionally be deuterated and/or substituted by one or more R¹ radicals, and where one or more nonadjacent CH₂ groups may be replaced by O; at the same time, two adjacent R radicals may form a ring system with one another;
and **characterized in that** the substituents R bonded to the carbon atom when X = CR are the same or different at each instance and are selected from the group consisting of H, D, F, CN, OR¹, N(R¹)₂, Si(R¹)₃, Ge(R¹)₃, a straight-chain alkyl group having 1 to 10 carbon atoms or a branched or cyclic alkyl group having 3 to 10 carbon atoms, where the alkyl group may in each case optionally be deuterated and/or substituted by one or more R¹ radicals, or an aromatic or heteroaromatic ring system which has 6 to 30 aromatic ring atoms and may in each case optionally be deuterated and/or substituted by one or more R¹ radicals; at the same time, two or more adjacent R radicals may form a ring system with one another.

9. Process for preparing a compound according to one or more of Claims 1 to 8, **characterized by** the following steps:
(1) providing a partly or fully deuterated benzene derivative or corresponding heteroaromatic derivative which is substituted by an -NHAr¹ and -NHAr² group in ortho positions to one another, and optionally providing a partly or fully deuterated benzene derivative or corresponding heteroaromatic derivative which is substituted by an -NHAr³ and -NHAr⁴ group in ortho positions to one another; and
(2) reacting SiHal₄ where Hal represents a halogen with the partly or fully deuterated benzene derivative or corresponding heteroaromatic derivative which is substituted by an -NHAr¹ group and an -NHAr² group in ortho positions to one another, optionally followed by reaction with the partly or fully deuterated benzene derivative or corresponding heteroaromatic derivative which is substituted by an -NHAr³ group and an -NHAr⁴ group in ortho positions to one another.

10. Mixture comprising at least one compound according to one or more of Claims 1 to 8 and at least one further compound.

11. Use of a compound according to one or more of Claims 1 to 8 in an electronic device.

12. Electronic device comprising at least one compound according to one or more of Claims 1 to 8.

13. Electronic device according to Claim 12 which is an organic electroluminescent device, **characterized in that** the compound according to one or more of Claims 1 to 8 is used in a hole transport layer and/or an exciton blocker layer and/or as matrix material in an emitting layer.

14. Electronic device according to Claim 13, **characterized in that** the emitting layer is a phosphorescent or hyperphosphorescent layer.

15. Electronic device according to Claim 14, **characterized in that** the emitting layer contains a blue phosphorescent iridium or platinum complex as emitting compound or as sensitizer.

16. Electronic device according to one or more of Claims 13 to 15, **characterized in that** the compound according to one or more of Claims 1 to 8 is used as matrix material in combination with an electron-transporting matrix material.

## Revendications

1. Composé de formule (1), 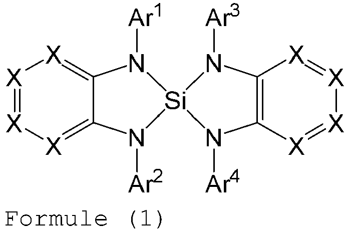 dans laquelle, pour les symboles utilisés, ce qui suit est d'application :
X représente, à chaque occurrence, de manière identique ou différente, CR ou N, à la condition que pas plus de deux X par cycle ne représentent N ;
Ar¹, Ar², Ar³, Ar⁴ représentent, à chaque occurrence, de manière identique ou différente, un système cyclique aromatique ou hétéroaromatique comportant de 5 à 40 atomes de cycle aromatique, pouvant être substitué par un ou plusieurs radicaux R ;
R représente, à chaque occurrence, de manière identique ou différente, H, D, F, Cl, Br, I, OR¹, SR¹, B(OR¹)₂, CHO, C(=O)R¹, CR¹=C(R¹)₂, CN, C(=O)OR¹, C(=O)NR¹, Si(R¹)₃, Ge(R¹)₃, NO₂, P(=O)(R¹)₂, OSO₂R¹, OR¹, N(R¹)₂, S(=O)R¹, S(=O)₂R¹, SR¹, un groupe alkyle linéaire comportant de 1 à 20 atomes C, un groupe alcényle ou alcynyle comportant de 2 à 20 atomes C, ou un groupe alkyle ramifié ou cyclique comportant de 3 à 20 atomes C, le groupe alkyle, alcényle ou alcynyle pouvant, dans chaque cas, être substitué par un ou plusieurs radicaux R¹, un ou plusieurs groupes CH₂ non voisins pouvant être remplacés par -R¹C=CR¹-, -C≡C-, Si(R¹)₂, CONR¹, C=O, C=S, -C(=O)O-, P(=O)(R¹), -O-, -S-, SO ou SO₂, ou un système cyclique aromatique ou hétéroaromatique comportant de 5 à 60 atomes de cycle aromatique, de préférence de 5 à 40 atomes de cycle aromatique, pouvant, dans chaque cas, être substitué par un ou plusieurs radicaux R¹ ; deux ou plus de deux radicaux R pouvant former ensemble un système cyclique ;
R¹ représente, à chaque occurrence, de manière identique ou différente, H, D, F, Cl, Br, I, B(OR²)₂, CHO, C(=O)R², CR²=C(R²)₂, CN, C(=O)OR², Si(R²)₃, Ge(R²)₃, NO₂, P(=O)(R²)₂, OSO₂R², SR², S(=O)R², S(=O)₂R², un groupe alkyle linéaire comportant de 1 à 20 atomes C, un groupe alcényle ou alcynyle comportant de 2 à 20 atomes C, ou un groupe alkyle ramifié ou cyclique comportant de 3 à 20 atomes C, le groupe alkyle, alcényle ou alcynyle pouvant, dans chaque cas, être substitué par un ou plusieurs radicaux R², un ou plusieurs groupes CH₂ dans les groupes précités pouvant être remplacés par -R²C=CR²-, -C≡C-, Si(R²)₂, C=O, C=S, -C(=O)O-, CONR², P(=O)(R²), -S-, SO ou SO₂, et un ou plusieurs atomes H dans les groupes précités pouvant être remplacés par D, F, Cl, Br, I, CN ou NO₂, ou un système cyclique aromatique ou hétéroaromatique comportant de 5 à 30 atomes de cycle aromatique, pouvant, dans chaque cas, être substitué par un ou plusieurs radicaux R², deux ou plus de deux radicaux R¹ pouvant former ensemble un système cyclique ;
R² représente, à chaque occurrence, de manière identique ou différente, H, D, F, CN ou un radical organique aliphatique, aromatique ou hétéroaromatique comportant de 1 à 20 atomes C, dans lequel un ou plusieurs atomes H peuvent également être remplacés par D ou F ;
deux ou plus de deux substituants R² pouvant être liés entre eux et former un cycle ;
**caractérisé en ce que** le composé est deutéré à au moins 20 %.

2. Composé selon la revendication 1, **caractérisé en ce que** le degré de deutération du composé est de 30 à 95 %.

3. Composé selon la revendication 1 ou 2, choisi parmi les composés de formules (2), (3) ou (4), 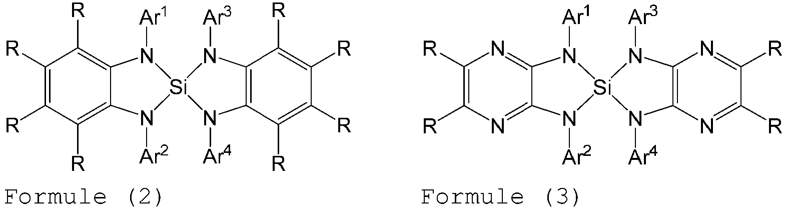 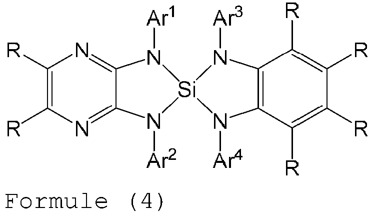 les symboles présentant les significations données dans la revendication 1.

4. Composé selon une ou plusieurs des revendications 1 à 3, choisi parmi les composés de formules (2a) à (2f), 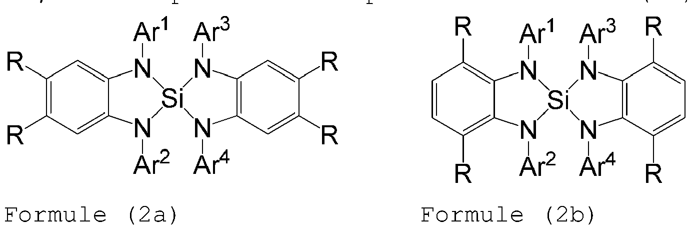 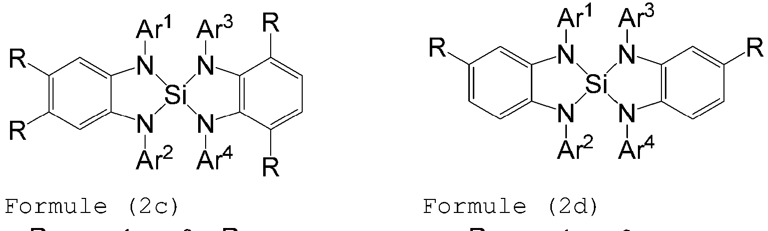 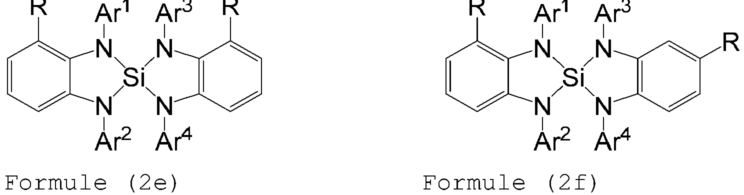 les atomes de carbone représentés comme non substitués pouvant également être partiellement ou entièrement deutérés, et Ar¹ à Ar⁴ et R ayant les significations indiquées dans la revendication 1.

5. Composé selon une ou plusieurs des revendications 1 à 4, **caractérisé en ce que** Ar¹ à Ar⁴ satisfont à :
Ar¹ = Ar² = Ar³ = Ar⁴ ;
Ar¹ = Ar² et Ar³ = Ar⁴, mais Ar¹ ≠ Ar³;
Ar¹ = Ar³ et Ar² = Ar⁴, mais Ar¹ ≠ Ar²;
Ar¹ = Ar² = Ar³ et Ar⁴ ≠ Ar¹;
Ar¹ = Ar² et Ar³ ≠ Ar⁴ ≠ Ar¹;
Ar¹ = Ar³ et Ar² ≠ Ar⁴ ≠ Ar¹; ou
Ar¹ ≠ Ar² ≠ Ar³ ≠ Ar⁴.

6. Composé selon une ou plusieurs des revendications 1 à 5, **caractérisé en ce qu'**au moins un des groupes Ar¹ à Ar⁴comporte au moins 12 atomes de cycle aromatique.

7. Composé selon une ou plusieurs des revendications 1 à 6, **caractérisé en ce que** Ar¹ à Ar⁴ sont, à chaque occurrence, de manière identique ou différente, choisis parmi phényle, biphényle, terphényle, quaterphényle, fluorène, spirobifluorène, naphtalène, indole, benzofurane, benzothiophène, dibenzofurane, carbazole, dibenzothiophène, indénocarbazole, indolocarbazole, pyridine, pyrimidine, pyrazine, pyridazine, triazine, quinoléine, quinazoline, benzimidazole, benzimidazobenzimidazole, phénanthrène ou triphénylène, pouvant chacun être substitué par un ou plusieurs radicaux R, et ces structures pouvant également être partiellement ou entièrement deutérées.

8. Composé selon une ou plusieurs des revendications 1 à 7, **caractérisé en ce que** les substituants R liés à Ar¹ à Ar⁴ sont, à chaque occurrence, de manière identique ou différente, choisis dans le groupe constitué de H, D, F, CN, Si(R¹)₃, Ge(R¹)₃, un groupe alkyle linéaire comportant de 1 à 10 atomes C ou un groupe alkyle cyclique comportant de 3 à 10 atomes C, le groupe alkyle pouvant, dans chaque cas, être éventuellement deutéré et/ou substitué par un ou plusieurs radicaux R¹, un ou plusieurs groupes CH₂ non voisins pouvant être remplacés par O ; deux radicaux R voisins pouvant former ensemble un système cyclique ;
et **caractérisé en ce que** les substituants R qui, pour X = CR, sont liés à l'atome de carbone sont, à chaque occurrence, de manière identique ou différente, choisis dans le groupe constitué de H, D, F, CN, OR¹, N(R¹)₂, Si(R¹)₃, Ge(R¹)₃, un groupe alkyle linéaire comportant de 1 à 10 atomes C ou un groupe alkyle ramifié ou cyclique comportant de 3 à 10 atomes C, le groupe alkyle pouvant, dans chaque cas, être éventuellement deutéré et/ou substitué par un ou plusieurs radicaux R¹, ou un système cyclique aromatique ou hétéroaromatique comportant de 6 à 30 atomes de cycle aromatique, pouvant, dans chaque cas, être éventuellement deutéré et/ou substitué par un ou plusieurs radicaux R¹ ; deux ou plus de deux radicaux R voisins pouvant former ensemble un système cyclique.

9. Procédé de préparation d'un composé selon une ou plusieurs des revendications 1 à 8, **caractérisé par** les étapes suivantes :
(1) la fourniture d'un dérivé de benzène ou d'un dérivé hétéroaromatique correspondant, partiellement ou entièrement deutéré, substitué en positions ortho l'une par rapport à l'autre par un groupe -NHAr¹ et -NHAr² et, le cas échéant, la fourniture d'un dérivé de benzène ou d'un dérivé hétéroaromatique correspondant, partiellement ou entièrement deutéré, substitué en positions ortho l'une par rapport à l'autre par un groupe -NHAr³ et -NHAr⁴ ; et
(2) la mise en réaction de SiHal₄, Hal représentant un halogène, avec le dérivé de benzène ou le dérivé hétéroaromatique correspondant, partiellement ou entièrement deutéré, substitué en positions ortho l'une par rapport à l'autre par un groupe -NHAr¹ et un groupe -NHAr², éventuellement suivie d'une mise en réaction avec le dérivé de benzène ou le dérivé hétéroaromatique correspondant, partiellement ou entièrement deutéré, substitué en positions ortho l'une par rapport à l'autre par un groupe -NHAr³ et un groupe -NHAr⁴.

10. Mélange contenant au moins un composé selon une ou plusieurs des revendications 1 à 8 et au moins un autre composé.

11. Utilisation d'un composé selon une ou plusieurs des revendications 1 à 8 dans un dispositif électronique.

12. Dispositif électronique contenant au moins un composé selon une ou plusieurs des revendications 1 à 8.

13. Dispositif électronique selon la revendication 12, qui est un dispositif électroluminescent organique, **caractérisé en ce que** le composé selon une ou plusieurs des revendications 1 à 8 est utilisé dans une couche de transport de trous et/ou une couche de blocage des excitons et/ou comme matériau de matrice dans une couche émissive.

14. Dispositif électronique selon la revendication 13, **caractérisé en ce que** la couche émissive est une couche phosphorescente ou hyperphosphorescente.

15. Dispositif électronique selon la revendication 14, **caractérisé en ce que** la couche émissive contient un complexe d'iridium ou de platine phosphorescent bleu en tant que composé émetteur ou sensibilisateur.

16. Dispositif électronique selon une ou plusieurs des revendications 13 à 15, **caractérisé en ce que** le composé selon une ou plusieurs des revendications 1 à 8 est utilisé comme matériau de matrice en combinaison avec un matériau de matrice transporteur d'électrons.
